# EUROPEAN PATENT SPECIFICATION

(11) **EP 3 620 459 B1**
(45) Date of publication and mention of the grant of the patent: **24.05.2023**
(21) Application number: 18777799.0
(22) Date of filing: 06.03.2018
(51) Int. Cl.: C07F 9/53, C07F 9/6574, C08K 5/51, C08L 63/00, C08L 101/00, C09K 21/12, H01L 23/29, H01L 23/31, C07F 9/6571, C08G 59/30, C08G 59/32, H05K 1/03

(54) **PHOSPHORUS-CONTAINING PHENOLIC COMPOUND, PHOSPHORUS-CONTAINING EPOXY RESIN, CURABLE RESIN COMPOSITION THEREOF, OR EPOXY RESIN COMPOSITION AND CURED PRODUCT THEREOF**
PHOSPHORHALTIGE PHENOLISCHE VERBINDUNG, PHOSPHORHALTIGES EPOXIDHARZ, HÄRTBARE HARZZUSAMMENSETZUNG DAVON ODER EPOXIDHARZZUSAMMENSETZUNG UND GEHÄRTETES PRODUKT DAVON
COMPOSÉ PHÉNOLIQUE CONTENANT DU PHOSPHORE, RÉSINE ÉPOXY CONTENANT DU PHOSPHORE, COMPOSITION DE RÉSINE DURCISSABLE ASSOCIÉE, OU COMPOSITION DE RÉSINE ÉPOXY ET PRODUIT DURCI CORRESPONDANT

(30) Priority: 29.03.2017 JP 2017064401; 01.09.2017 JP 2017168650
(43) Date of publication of application: 11.03.2020
(73) Proprietor: NIPPON STEEL Chemical & Material Co., Ltd., Tokyo 103-0027 (JP)
(72) Inventor: SATO, Hiroshi, Tokyo 1030027 (JP); GUNJI, Masao, Tokyo 1030027 (JP); MIYAKE, Chikara, Tokyo 1030027 (JP)
(74) Representative: Beckmann, Claus
(86) International application number: PCT/JP2018/008481
(87) International publication number: WO 2018/180267

(56) References cited:
- JP-A- S6 460 628
- JP-A- H06 340 680
- JP-A- S63 130 598
- JP-A- S63 185 992
- JP-A- S63 277 233
- JP-A- 2012 501 335
- JP-A- 2013 181 082
- TW-B- 393 496
- US-A1- 2003 125 433
- US-A1- 2015 221 982
- PATRICK MÜLLER ET AL: "New Phosphorus-Containing Quinone Derivatives II: Tri- and Tetraphosphorylated Quinone Derivatives", HETEROATOM CHEMISTRY, vol. 24, no. 4, 21 July 2013 (2013-07-21), pages 252-262, XP055135570, ISSN: 1042-7163, DOI: 10.1002/hc.21089
- PATRICK MÜLLER ET AL: "New phosphorus-containing quinone derivatives", HETEROATOM CHEMISTRY, vol. 23, no. 4, 1 January 2012 (2012-01-01), pages 383-394, XP055138382, ISSN: 1042-7163, DOI: 10.1002/hc.21028
- VLADIMIR BENIN et al.: "Heat release of polyurethanes containing potential flame retardants based on boron and phosphorus chemistries", Polymer Degradation and Stability, vol. 106, 2014, pages 108-121, XP028854215,
- PATRICK MULLER et al.: "New phosphorus-containing quinone derivatives", Heteroatom Chemistry, vol. 23, no. 4, 2012, pages 383-394, XP055138382,
- PATRICK MULLER et al.: "New Phosphorus-Containing Quinone Derivatives II: Tri- and Tetraphosphorylated Quinone Derivatives", Heteroatom Chemistry, vol. 24, no. 4, 2013, pages 252-262, XP055135570,
- MICHAEL F. RECTENWALD et al.: "Phosphoryl-Rich Flame-Retardant Ions (FRIONs): Towards Safer Lithium-Ion Batteries", Angew. Chem. Int. Ed., vol. 53, no. 16, 14 April 2014 (2014-04-14), pages 4173-4176, XP055613111,
- FENG LI LAUGHLIN et al.: "Fluorescent Heteroacenes with Multiply-Bonded Phosphorus", Organometallics, vol. 32, no. 23, 15 November 2013 (2013-11-15), pages 7116-7121, XP055613112,
- BIQUAN XIONG et al.: "Highly Selective 1,4- and 1,6-Addition of P(O)-H Compounds to p Quinones: A Divergent Method for the Synthesis of C - and O -Phosphoryl Hydroquinone Derivatives", Chem. Eur. J., vol. 18, no. 52, 2012, pages 16902-16910, XP055637520, ISSN: 0947-6539, DOI: 10.1002/chem.201202074
- BALRAM DHAWAN et al.: "o-Hydroxyaryl diphosphonic acids", J. Org. Chem., vol. 49, 1 October 1984 (1984-10-01), pages 4018-4021, XP002557148,
- SALVATORE FAILLA et al.: "Synthesis, Characterization, and Properties of New Phosphorus-Containing Epoxy Resins", Phosphorus, Sulfur and Silicon and the Related Elements, vol. 186, no. 11, 2011, pages 2189-2201, XP055263962,

## Description

### [Technical Field]

The present invention relates to a phosphorus-containing phenolic compound useful as a flame retardant for an epoxy resin composition for producing a copper-clad laminate, a film material, a copper foil with a resin attached thereto and the like to be used for an electronic circuit board, and also for a sealing material, a molding material, a casting material, an adhesive and an electrical insulation coating material to be used for electronic components. The present invention also relates to a phosphorus-containing epoxy resin, a curable resin composition thereof, or an epoxy resin composition and a cured product thereof.

### [Background Art]

In recent years, in the field of improving flame retardancy of electronic devices, for the purpose of suppression of toxic gases generated at the time of combustion thereof in consideration of environmental impact reduction, halogen-free flame retarding aimed at achieving flame retardancy by organophosphorus compounds has already been established and is generally widely used and recognized in the form of phosphorus flame retardant epoxy resins as an alternative to flame retarding by halogen-containing compounds represented by the conventional brominated epoxy resins.

As specific representative examples of such epoxy resins imparted with flame retardancy, it was proposed to use organophosphorus compounds such as disclosed in PTL 1 to 4. PTL 1 discloses a thermosetting resin obtained by reacting10-(2,5-dihydroxyphenyl)-9,10-dihydro-9-oxa-10-phosphaphenanthrene-10-oxide (hereinafter abbreviated as DOPO-HQ) and an epoxy resin at a predetermined molar ratio. Further, PTL 2 briefly describes a method for producing diphenylphosphylhydroquinone, and discloses a phosphorus-containing epoxy resin obtained by reacting an epoxy compound having two or more epoxy groups with this diphenylphosphylhydroquinone. PTL 3 discloses a method for producing a flame retardant epoxy resin obtained by reacting an epoxy resin, a phosphine compound having an aromatic group on a phosphorus element and a quinone compound in the presence of an organic solvent. PTL 4 discloses a phosphorus-containing epoxy resin obtained by reacting a phosphorus-containing polyvalent phenolic compound and an epoxy resin, and a phosphorus-containing flame retardant epoxy resin composition.

PTL 5 discloses a method for producing a phosphorus-containing flame retardant bisphenol epoxy resin by performing a step 1 of obtaining a resin composition by reacting 9,10-dihydro-9-oxa-10-phosphaphenanthrene-10-oxide (hereinafter abbreviated as DOPO) and 1,4-benzoquinone (hereinafter abbreviated as BQ) and/or 1,4-naphthoquinone (hereinafter abbreviated as NQ) by controlling the total water amount in the reaction system to be 0.3% by mass or less based on the total amount of DOPO used in the reaction, and a step 2 of reacting the reaction compound obtained in in the step 1, without purification thereof, with a bisphenol A epoxy resin and/or a bisphenol F epoxy resin. Here, in this case, a phosphorus-containing epoxy resin is described which is obtained by reacting a quinone compound with an organophosphorus compound such as DOPO or diphenyl phosphine oxide, then generating a bifunctional phenolic compound, and reacting the bifunctional phenolic compound with an epoxy resin. All of these resins are naturally imparted with flame retardancy by the organophosphorus compound, that is, in a halogen-free manner in consideration of effect on environment, but the above methods are characterized by using the above bifunctional phenolic compound in order to increase the crosslink density of the cured product so as not to impair the heat resistance after curing of the phosphorus-containing epoxy resin.

Meanwhile, PTL 6 and 7 describes the effects produced by by-products generated in the process of synthesizing such DOPO-added bifunctional phenolic compounds. PTL 6 discloses a method of reacting DOPO and NQ so as to reduce the amount of by-products in an inert solvent having a dielectric constant of 10 or less, and then dissolving the obtained reaction composition in a solvent selected from ethylene glycol, propylene glycol, diethylene glycol, cyclohexanone, benzyl alcohol, an acetic acid ester, and a benzoic acid ester, and performing recrystallization purification. In this document, impurities and moisture are removed by enhancing the crystallinity of the bifunctional phenolic compound to which DOPO has been added, and solder resistance and heat resistance, which are problematic, are improved, but the recrystallization step in the purification is expensive and has poor utility when applied to a printed circuit board or the like. Furthermore, these phosphorus-containing resins are poorly soluble in solvents, such as ethyl methyl ketone, that are generally used in the preparation of varnishes for producing prepregs, and poor infiltration to glass cloth due to the influence of crystal precipitation and deterioration of properties in terms of mechanical characteristics, heat resistance and uniform flame retardancy after substrate molding are matters of concern. Another problem is that since the melting start temperature of these crystals is as high as 280°C or higher, curing defects occur under the pressing temperature conditions on general printed circuit boards at around 200°C, and the target properties such as heat resistance, flame retardancy and the like cannot be obtained. For these reasons, an economically advantageous method is to obtain a phosphorus-containing epoxy resin by reacting the polyfunctional phenolic compound in which a phosphorus compound such as DOPO is added to a quinone compound, without the purification of the compound after the reaction, with an epoxy resin.

PTL 7 refers to a by-product generated in production of a phosphorus-containing phenolic compound. It is indicated that when an epoxy resin is produced by reacting an epoxy resin with the phosphorus-containing phenolic compound, the remarkable curing delay during the curing reaction can be suppressed by specifying the amount of the by-product. It is further indicated that even when the amount of this by-product is small, the influence on inhibiting the curability is very large, and the control of the amount is important.

However, none of the documents mentions the phosphorus-containing phenolic compound or the phosphorus-containing epoxy resin of the present invention, and the conditions for producing the phosphorus-containing phenolic compound and the effects thereof cannot be found in the documents.

US 2003/125433 A1 describes a phosphorus-containing hydroquinone derivative represented by the following general formula 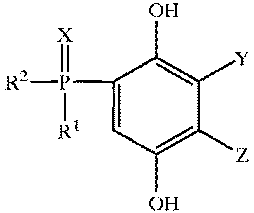 where R¹ and R² represent linear or branched alkyl groups that are identical or may be different, and/or R¹ and R² may form a circular group; X represents an oxygen atom or sulfur atom; Y and Z represent hydrogen atom, hydroxy group, linear or branched alkyl group, aralkyl group, alkoxy group, allyl group, aryl group or cyano group, and/or Y and Z may form a circular group. The document indicates the phosphorus-containing hydroquinone derivatives to be useful for intermediate materials for reactive type flame-retardant agents or phosphorus-containing epoxy resins.

Müller et al. (Heteroatom Chemistry, vol. 24, 2013, pages 252-262) describe new phosphorus-containing quinone derivatives, namely tri- and tetraphosphorylated quinone derivatives.

Müller et al. (Heteroatom Chemistry, vol. 23, 2013, pages 383-394) describe new phosphorus-containing quinone derivatives.

### [Citation List]

### [Patent Literature]

[PTL 1] Japanese Patent Application Publication No. H04-11662
[PTL 2] Japanese Patent Application Publication No. H05-214070
[PTL 3] Japanese Patent Application Publication No. 2000-309624
[PTL 4] Japanese Patent Application Publication No. 2002-265562
[PTL 5] Japanese Patent Application Publication No. 2006-342217
[PTL 6] Japanese Patent Application Publication No. 2013-43910
[PTL 7] WO 2009/060987

### [Summary of Invention]

### [Technical Problem]

A phosphorus-containing phenolic compound, a phosphorus-containing epoxy resin, and a resin composition using the phosphorus-containing epoxy resin that exhibit excellent flame retardancy without reducing the heat resistance of the cured product are provided as flame retardant formulations of a halogen-free epoxy resin cured product.

### [Solution to Problem]

The inventors of the present invention have conducted a comprehensive research aimed at the resolution of the abovementioned problems. Based on the results obtained, it was found that a specific phosphorus-containing phenolic compound obtained by reacting an organophosphorus compound represented by DOPO and a quinone compound has excellent flame retardancy as compared with the conventionally known organophosphorus compounds, and an epoxy resin composition using a curable resin composition using the phosphorus-containing phenolic compound, or a phosphorus-containing epoxy resin obtained by reacting the phosphorus-containing phenolic compound with a polyfunctional epoxy resin demonstrate excellent flame retardancy in the cured product and also improved heat resistance and improved properties such as solder reflowability due to a decrease in water absorption. The present invention has been achieved based on this finding.

That is, the present invention provides a phosphorus-containing phenolic compound represented by formula (1) .

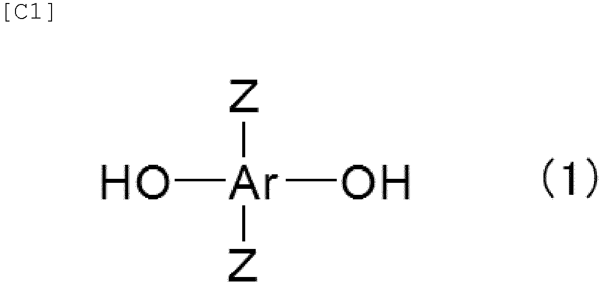

Here, Ar represents a naphthalene ring which may include an alkyl group having 1 to 8 carbon atoms, an alkoxy group having 1 to 8 carbon atoms, a cycloalkyl group having 5 to 8 carbon atoms, an aryl group having 6 to 10 carbon atoms, an aralkyl group having 7 to 11 carbon atoms, an aryloxy group having 6 to 10 carbon atoms, or an aralkyloxy group having 7 to 11 carbon atoms as a substituent.

Z in the formula (1) is a phosphorus-containing group represented by formula (a1) and/or formula (a2).

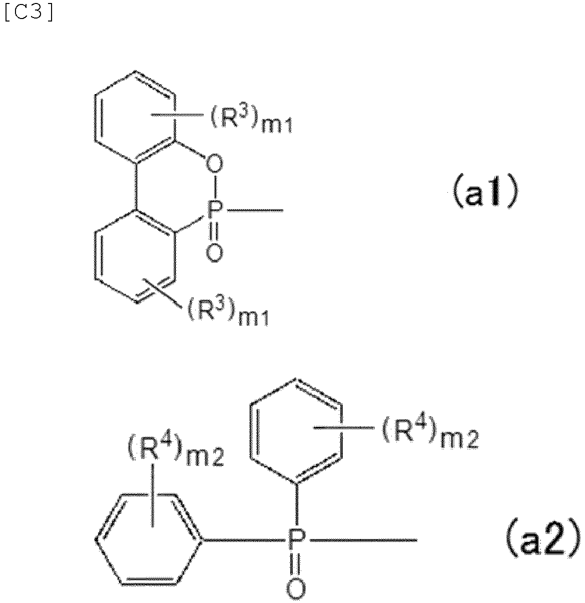

Here, R³ are each independently a hydrocarbon group having 1 to 11 carbon atoms, and m1 are each independently an integer of 0 to 4. Here, R⁴ are each independently a hydrocarbon group having 1 to 11 carbon atoms, and m2 are each independently an integer of 0 to 5.

Further, the present invention provides a curable resin composition including the phosphorus-containing phenolic compound and a thermosetting resin. It is preferable that the thermosetting resin include an epoxy resin and a curing agent. The present invention also provides a cured product obtained by curing the curable resin composition.

The present invention also provides a method for producing the phosphorus-containing phenolic compound, comprising:
a step 1 of reacting 0.5 mol or more and less than 1.0 mol of a quinone compound as defined below with 1 mol of a phosphorus compound represented by formula (2a) and/or formula (2b) as shown below at 100°C to 200°C in an organic solvent in the presence of 0.05 to 0.5 mol of water;
a step 2 of dissolving the reaction product obtained in the step 1 in a good solvent and removing insoluble impurities; and
a step 3 of mixing the solution obtained in the step 2 with a poor solvent to obtain a product by precipitation separation.

The good solvent is one or a mixture of two or more solvents selected from the group consisting of ethylene glycol, propylene glycol, diethylene glycol, cyclohexanone, benzyl alcohol, an acetic acid ester, and a benzoic acid ester, and the poor solvent is one or a mixture of two or more solvents selected from the group consisting of methanol, ethanol, butanol and acetone.

The reaction in step 1 is preferably performed under reflux conditions.

The phosphorus compound is a compound represented by formula (2a) and/or formula (2b).

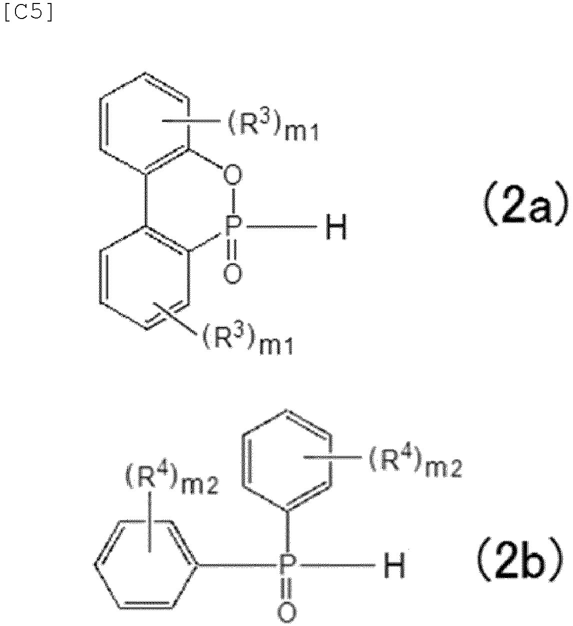

Here, R³ and m1 have the same meaning as R³ and m1 in the formula (a1), and R⁴ and m2 have the same meaning as R⁴ and m2 in the formula (a2).

The quinone compound is at least one selected from the group consisting of naphthoquinone, methyl-naphthoquinone, cyclohexyl-naphthoquinone, and methoxy-naphthoquinone.

Another aspect of the present invention pertains to a phosphorus-containing epoxy resin that is obtained by reacting the phosphorus-containing phenolic compound and an epoxy resin, and has a structure produced by a reaction of a hydroxy group of the phosphorus-containing phenolic compound and an epoxy group of the epoxy resin. The phosphorus-containing epoxy resin preferably has a structural segment (hereinafter referred to as a structural segment b) represented by formula (b).

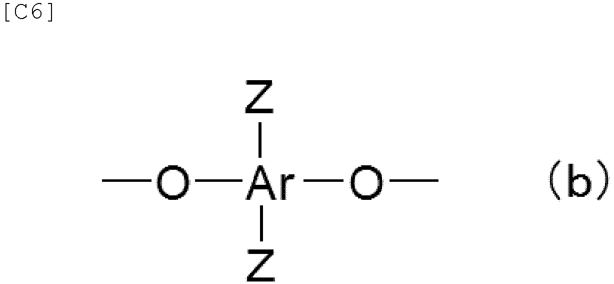

The phosphorus-containing epoxy resin can further have a structural segment (hereinafter referred to as a structural segment c) represented by formula (c).

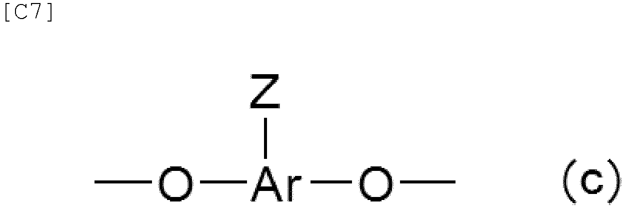

This invention also provides a phosphorus-containing epoxy resin which has a structure represented by formula (b1), and can have a structure represented by formula (c1).

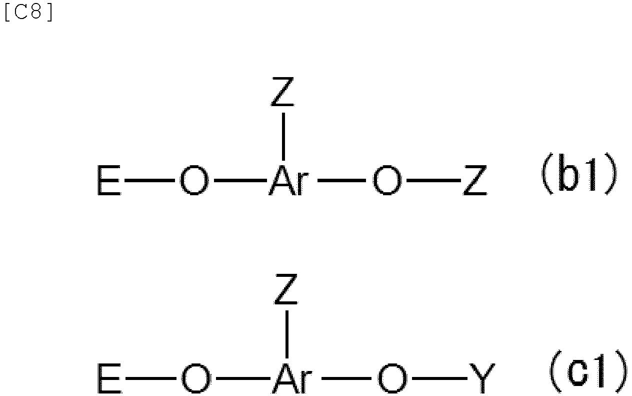

Here, E is an organic group represented by -R-A¹, - R- is a linking group generated by the reaction of an epoxy group of a polyfunctional epoxy resin and a hydroxy group, A¹ is a residue of the polyfunctional epoxy resin, and contains 1 mol or more of an epoxy group or an epoxy derivative group thereof per 1 mol of A¹, where at least a part of the epoxy group and the epoxy derivative group thereof is an epoxy group, and the epoxy derivative group is generated from an epoxy group and a phenolic compound having a structure in which a phosphorus-containing group Z and a hydroxy group are bonded to Ar.

E in the formula (b1) and formula (c1) may be shared with other formula (b1) or formula (c1).

Y is a hydrogen atom or E.

The phosphorus-containing epoxy resin is obtained by reacting the hydroxy groups of the phosphorus-containing phenolic compound (1) represented by the formula (1) with the epoxy groups of the polyfunctional epoxy resin.

Further, the present invention also provides a method for producing a phosphorus-containing epoxy resin in which a reactive agent (x) including a compound that includes the phosphorus-containing phenolic compound (1) represented by the formula (1) as an essential component and has a functional group reactive with an epoxy group is reacted with a polyfunctional epoxy resin (y).

The reactive agent (x) includes a phosphorus-containing reactive agent (p) having a functional group reactive with an epoxy group, the phosphorus-containing reactive agent (p) may include a phosphorus-containing phenolic compound (1) and a phosphorus-containing phenolic compound (3) represented by formula (3), and a content ratio of the phosphorus-containing phenolic compound (1) may be 0.1% by mass to 35% by mass of the phosphorus-containing reactive agent (p). The content ratio is more preferably 0.5% by mass to 30% by mass, and still more preferably 1.0% by mass to 25% by mass.

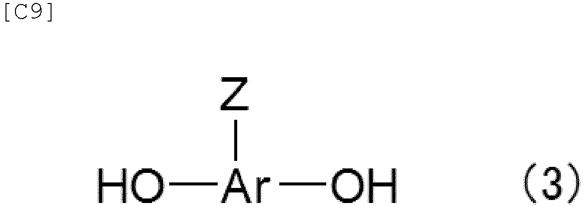

In the formula (b), formula (c), formula (b1), formula (c1) and formula (3), Ar and Z have the same meaning as in the formula (1).

In the method for producing a phosphorus-containing epoxy resin, the phosphorus-containing reactive agent (p) may be obtained by charging a quinone compound (q) in an amount of 0.10 mol or more and less than 1.0 mol thereof with respect to 1 mol of the phosphorus compound (2) represented by the formula (2a) and/ or formula (2b), and conducting a reaction at 100°C to 200°C in an organic solvent having a water amount of 0.05 to 0.5 mol with respect to 1 mol of the phosphorus compound (2).

The reactive agent (x) may also include a compound (x1) having a functional group reactive with an epoxy group, this compound (x1) being other than the phosphorus compound (p).

The present invention also provides an epoxy resin composition including the phosphorus-containing epoxy resin and a curing agent for epoxy resin. The present invention also provides a circuit board material obtained by using this epoxy resin composition. Further, the present invention provides a cured product obtained by curing the epoxy resin composition.

### [Advantageous Effects of Invention]

The cured product of the resin composition using the phosphorus-containing phenolic compound of the present invention is significantly improved in flame retardancy as compared with a cured product using a conventional organophosphorus compound. That is, since the content ratio of phosphorus which is used to impart flame retardancy can be suppressed to a low level, the reduction of the water absorption ratio of the cured product can be achieved.

The cured product using the phosphorus-containing epoxy resin of the present invention is also significantly improved in flame retardancy as compared with a cured product using a phosphorus-containing epoxy resin obtained from a conventional organophosphorus compound. That is, since the content ratio of phosphorus which is used to impart flame retardancy can be suppressed to a low level, the epoxy equivalent indicating the number of functional groups in the epoxy resin can be kept low, thereby greatly improving the heat resistance of the cured product. At the same time, lowered phosphorus content ratio can also achieve a decrease in water absorption.

Therefore, it is possible to provide an electronic circuit board material excellent in thermal stability such as solder reflowability of a cured product such as a laminate.

### [Brief Description of Drawings]

[Fig. 1]

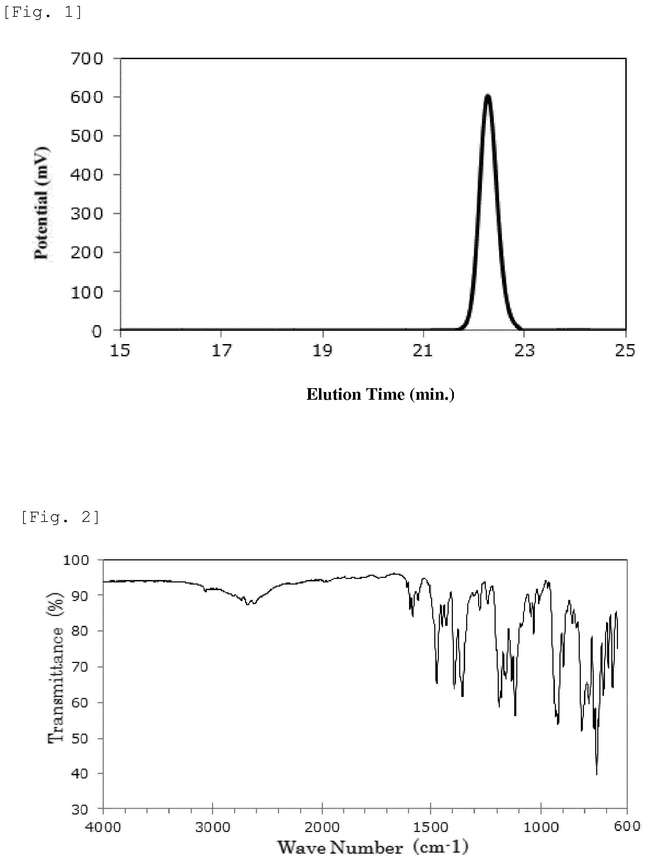

   Fig. 1 is a GPC chart of the phosphorus-containing phenolic compound of the present invention.
[Fig. 2]
   Fig. 2 is an FT-IR chart of the phosphorus-containing phenolic compound of the present invention.
[Fig. 3]

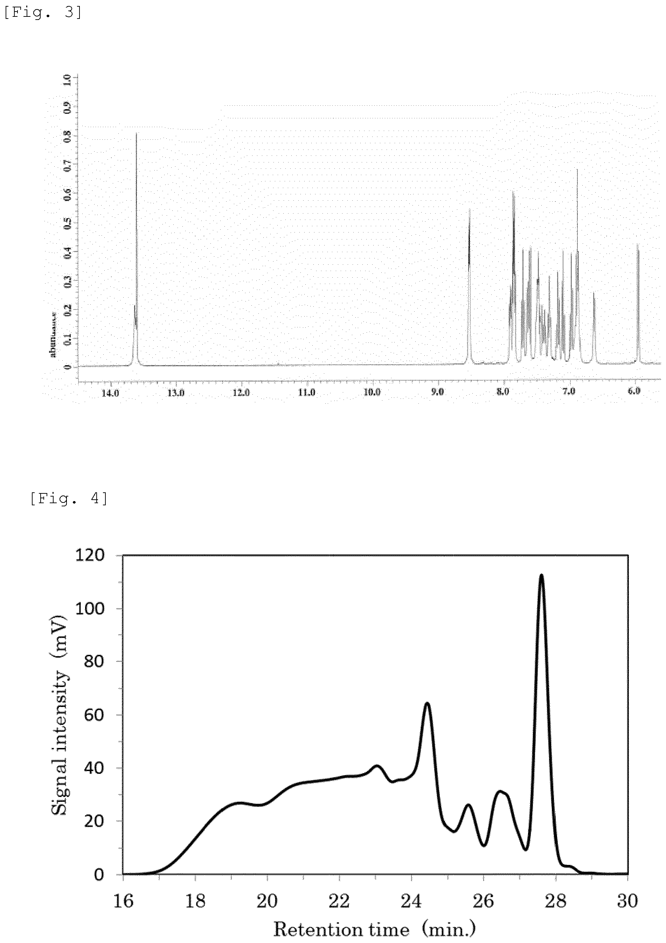

   Fig. 3 is an NMR chart of the phosphorus-containing phenolic compound of the present invention.
[Fig. 4]
   Fig. 4 is a GPC chart of the phosphorus-containing epoxy resin of the present invention.
[Fig. 5]

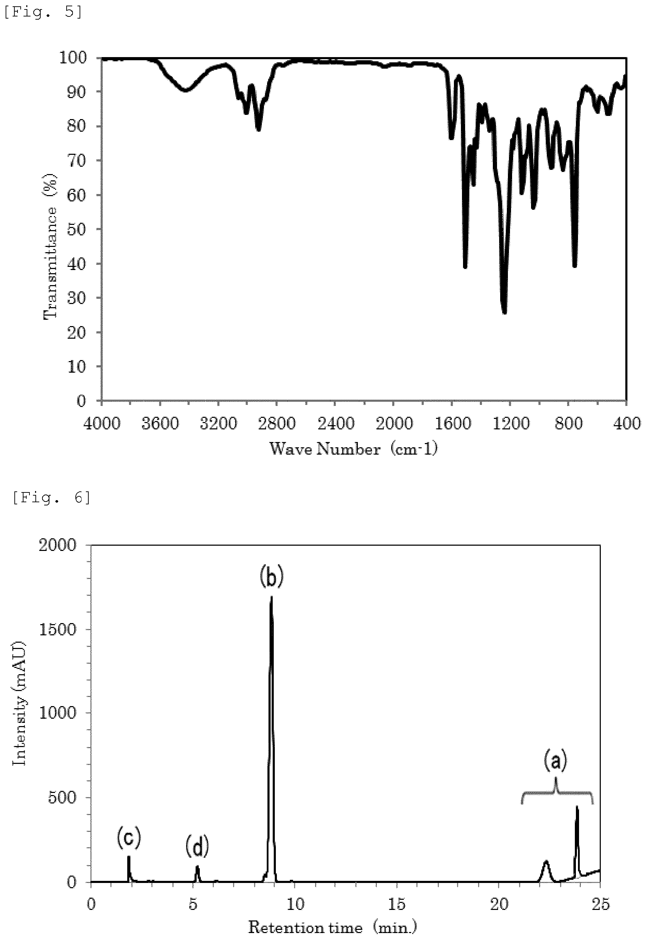

   Fig. 5 is a FT-IR chart of the phosphorus-containing epoxy resin of the present invention.
[Fig. 6]
   Fig. 6 is an HPLC chart of the phosphorus compound obtained in Synthesis Example 1.

### [Description of Embodiments]

The phosphorus-containing phenolic compound of the present invention is represented by the above formula (1). Since this phosphorus-containing phenolic compound is also an organophosphorus compound, it is also referred to as an organophosphorus compound or a phosphorus compound. Moreover, it is also referred to as phosphorus-containing phenolic compound (1).

In formula (1), Ar represents a tetravalent aromatic ring group, namely a naphthalene ring. The aromatic ring group may be composed only of a naphthalene ring, and may have a substituent.

The substituent in the case where a substituent is present is an alkyl group having 1 to 8 carbon atoms, an alkoxy group having 1 to 8 carbon atoms, a cycloalkyl group having 5 to 8 carbon atoms, an aryl group having 6 to 10 carbon atoms, an aralkyl group having 7 to 11 carbon atoms, an aryloxy group having 6 to 10 carbon atoms, or an aralkyloxy group having 7 to 11 carbon atoms, and when the substituent has an aromatic ring, this aromatic ring may be further substituted with an alkyl group or an alkoxy group and the like.

For example, the alkyl group having 1 to 8 carbon atoms can be exemplified by a methyl group, an ethyl group, a propyl group, an isopropyl group, an n-butyl group, a t-butyl group, a hexyl group and the like. The cycloalkyl group having 5 to 8 carbon atoms can be exemplified by a cyclohexyl group and the like. The aryl group having and the aryloxy group 6 to 10 carbon atoms can be exemplified by a phenyl group, a tolyl group, a naphthyl group, a methoxyphenyl group, an ethoxyphenyl group, a phenoxy group, a naphthyloxy group and the like, and the aralkyl group. The aralkyloxy group having 7 to 11 carbon atoms can be exemplified by a benzyl group, a phenethyl group, a 1-phenylethyl group, a benzyloxy group, a naphthylmethyloxy group and the like.

Preferred examples of Ar include a naphthalene ring group, a methyl group-substituted naphthalene ring group, and a 1-phenylethyl group-substituted naphthalene ring group. Here, the naphthalene ring group is a group generated by removing four Hs from the naphthalene ring. Note that the positions from which Hs are removed are not restricted.

Z is a phosphorus-containing group represented by the above formula (a1) or (a2).

In formulas (a1) and (a2), R³ and R⁴ each independently represent a hydrocarbon group having 1 to 11 carbon atoms, and specifically, a methyl group, an ethyl group, a t-butyl group, a cyclohexyl group, a phenyl group, a tolyl group and a benzyl group, and a methyl group, a phenyl group and a benzyl group are preferable. m1 are each independently an integer of 0 to 4, preferably 0 to 2, and more preferably 0 or 1. m2 are each independently an integer of 0 to 5, preferably 0 to 2, and more preferably 0 or 1.

A method for producing the phosphorus-containing phenolic compound of the present invention has a step 1 of reacting 0.1 mol or more and less than 1.0 mol of a quinone compound with 1 mol of the phosphorus compound 1 represented by the formula (2a) and/or formula (2b) at 100°C to 200°C in an organic solvent in the presence of 0.05 to 0.5 mol of water. The reaction is preferably carried out in a reflux state. In this reaction, a reaction represented by the following reaction formula (30) is performed.

After the step 1 is completed, next in step 2, the reaction mixture is mixed with a good solvent to dissolve the target phosphorus-containing phenolic compound, and the by-produced phosphorus-containing phenolic compound (3) and phosphorus compound (4) are removed as insoluble component. Most of the phosphorus-containing phenolic compound (1) which is the target product is present in the solution after solid fraction separation, but some by-produced phosphorus-containing phenolic compound (3) and phosphorus compound (4) remain. Therefore, further purification is performed in a step 3.

In the step 3, the solution is mixed with a poor solvent to precipitate crystals of the phosphorus-containing phenolic compound (1) which is a target product. Then, the by-produced phosphorus-containing phenolic compounds are dissolved in the poor solvent solution.

An example of the reaction formula of the step 1 is shown by the following reaction formula (30).

The reaction formula (30) is a reaction example of the phosphorus compound (2) and the quinone compound (q). In this reaction example, in addition to the phosphorus-containing phenolic compound (1) of the present invention, the phosphorus-containing phenolic compound (3) or the phosphorus compound (4) is by-produced, and the raw material phosphorus compound (2) remains as an impurity.

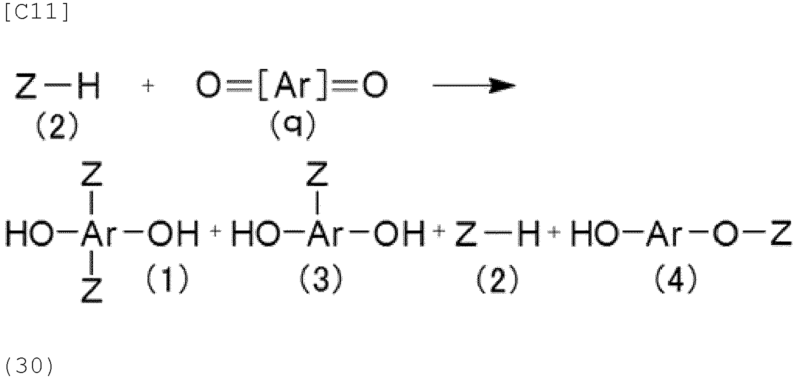

In the above reaction formula, [Ar] is an aromatic ring group satisfying the following reaction formula (31).

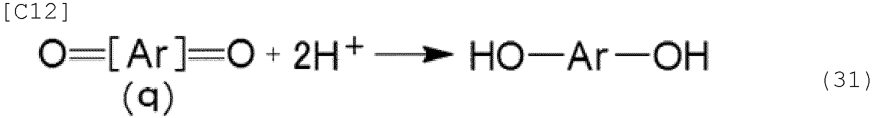

In the present description, in each formula, the same symbols have the same meaning unless otherwise noted. However, Ar may be a 2-, 3- or 4-valent group.

The following reaction formula (30a) can be obtained in an example in which DOPO (2-2) and NQ (q) are used as specific compounds for the reaction formula (30).

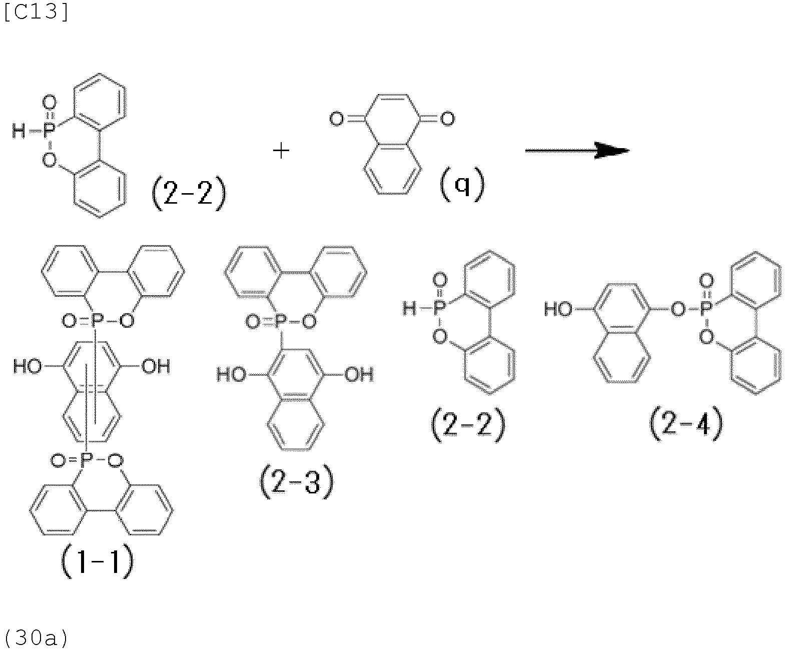

The phosphorus-containing phenolic compound (1) can be exemplified not only by the compound represented by the formula (1-1), but also, for example, by the compounds represented by the following formulas (1-2) to (1-5), formulas (1-2) and (1-4) not being according to the invention, depending on the selection of raw material phosphorus compound (2) or quinone compound (q), but these compounds are not limiting.

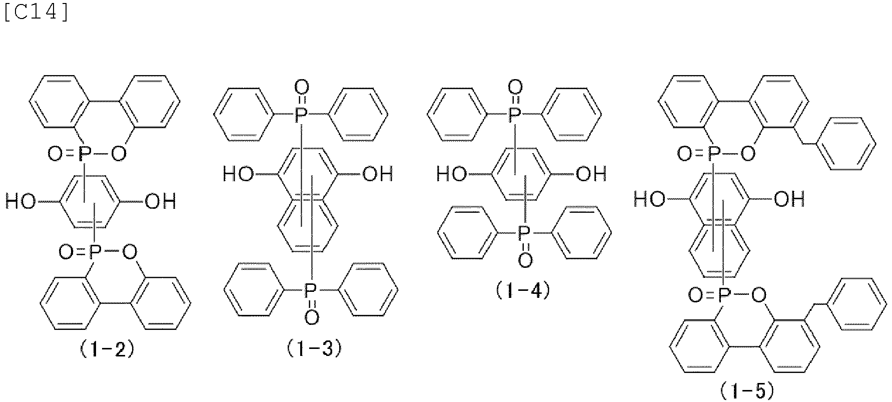

When the quinone compound is BQ (not according to the invention), for example, three types of phosphorus-containing phenolic compounds represented by the formula (1) are present. In the case of NQ, nine types are present, but the phosphorus-containing phenolic compounds represented by formula (1') are preferable.

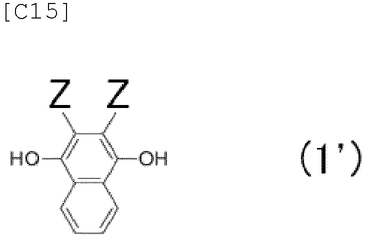

In the reaction shown in the reaction formula (30), a competition reaction occurs between the phosphorus-containing phenolic compound (1) of the present invention and the by-produced phosphorus-containing phenolic compound (3) and the phosphorus compound (4). In order to increase the yield of the phosphorus-containing phenolic compound (1), it is preferable to increase the molar ratio of the quinone compound (q) to the phosphorus compound (2). The quinone compound is in the range of 0.5 mol or more and less than 1.0 mol, preferably 0.75 mol or more and less than 1.0 mol, more preferably 0.8 mol or more and less than 1.0 mol, and even more preferably 0.9 mol or more and less than 1.0 mol with respect to 1 mol of the phosphorus compound. When the molar ratio is low, the remaining amount of the unreacted phosphorus compound is increased and the reaction efficiency is deteriorated. Meanwhile, when the molar ratio is 1.0 or more, although the phosphorus-containing phenolic compound of the present invention is effectively generated, an unreacted raw material quinone compound is likely to remain, and a complicated treatment process for removal after reaction is necessary which is industrially disadvantageous.

When the phosphorus-containing phenolic compound of the present invention is used, without being isolated, as a raw material of the phosphorus-containing epoxy resin described hereinbelow, the raw material may be a mixture with the by-produced phosphorus-containing phenolic compound (3). Therefore, the quinone compound (q) is in the range of 0.1 mol or more to less than 1.0 mol, preferably 0.2 mol or more to 0.99 mol or less, more preferably 0.25 mol or more and 0.85 mol or less, and even more preferably 0.3 mol or more and 0.9 mol or less with respect to 1 mol of the phosphorus compound (2). When the molar ratio is less than 0.10, the amount of the quinone compound (q) used is small, and the remaining amount of the phosphorus compound (2) is more than the formed amount of the phosphorus-containing phenolic compound (1) or the phosphorus-containing phenolic compound (3). Therefore, when the raw material is used as it is as a modifier of the phosphorus-containing epoxy resin, the sealing structure segment of the terminal epoxy group created by the phosphorus compound (2) increases and the crosslinking point is lowered, so that the heat resistance as a cured product is lowered.

The formation of the phosphorus-containing phenolic compound is affected not only by the abovementioned molar ratio, but also by the reaction temperature. The reaction temperature is preferably 100°C to 200°C, and it is more preferable that the mixture with water be azeotropic at that temperature. Therefore, it is preferable to use an organic solvent capable of maintaining the reflux temperature at 100°C to 200°C. Since the reflux temperature is lowered by water, a high boiling point is preferable, a range of 100°C to 220°C is more preferable, and a range of 110°C to 180°C is still more preferable. In addition, as long as the reflux temperature can be maintained, an organic solvent having a low boiling point may be used in combination. Further, although ketone-based organic solvents which are reactive with an organophosphorus compound are not suitable, there are other organic solvents, and the kind of organic solvent is not particularly limited, provided that the abovementioned conditions are met. However, a good solvent which dissolves the raw material and the target organophosphorus compound is preferred.

When the phosphorus-containing phenolic compound of the present invention is used without being isolated as a raw material of the phosphorus-containing epoxy resin described hereinbelow, it is undesirable to use an organic solvent having a very high boiling point because the used organic solvent is difficult to remove. In this case, an organic solvent capable of maintaining the reflux temperature at 100°C to 160°C is preferable, and an organic solvent having a boiling point of 100°C to 160°C is more preferable.

Examples of suitable solvents include, but are not limited to, alcohols such as 1-methoxy-2-propanol, 2-ethyl-1-hexanol, benzyl alcohol, ethylene glycol, propylene glycol, 1,3-butanediol, isopropyl alcohol, and the like; acetic acid esters such as butyl acetate, methoxybutyl acetate, cellosolve acetate, methyl cellosolve acetate, propylene glycol monomethyl ether acetate, diethylene glycol monoethyl ether acetate, benzyl alcohol acetate and the like; benzoic acid esters such as methyl benzoate, ethyl benzoate and the like; cellosolves such as methyl cellosolve, cellosolve, butyl cellosolve and the like; carbitols such as methyl carbitol, butyl carbitol and the like; ethers such as dimethoxydiethylene glycol, ethylene glycol diethyl ether, diethylene glycol diethyl ether, triethylene glycol dimethyl ether, tetrahydrofuran, dioxane and the like; aromatic hydrocarbons such as benzene, toluene, xylene and the like; amides such as N, N-dimethyl formamide, N, N-dimethyl acetamide and the like; dimethyl sulfoxide; acetonitrile; N-methyl pyrrolidone; and the like. These organic solvents may be used singly or in combination of two or more.

Further, the amount of water in the reaction system is also important for promoting the formation of the phosphorus-containing phenolic compound (1). It is effective to adjust the amount of water in the range of 0.05 to 0.5 mol with respect to 1 mol of the raw material phosphorus compound. Although the factor that promotes the formation of the phosphorus-containing phenolic compound is not yet known at present, a reaction mechanism can be presumed in which when the phosphorus compound is reactively bonded to carbon adjacent to the C=O group of the quinone compound, an addition reaction occurs almost simultaneously due to partial hydrogen bonding of a phosphorus compound having good affinity for water between two molecules. The amount of water is more preferably 0.1 to 0.5 mol, and still more preferably 0.2 to 0.4 mol with respect to 1 mol of the raw material phosphorus compound.

Further, the quinone compound used by the production method of the present invention can be used without a problem, provided that the purity is 90% or more as an industrial product. When the purity is lower than this, the amount of by-produced impurities increases, and it may be difficult to achieve high purification of the target phosphorus-containing phenolic compound. The preferred purity is 96% or more, and the more preferred purity is 98% or more. Because of harmful nature thereof, these quinone compounds are sometimes sold by the manufacturer after being hydrated in advance in order to prevent scattering. In this case, the reaction needs to be adjusted in advance in consideration of the amount of water in the quinone compound. These quinone compounds may be used singly or in combination of two or more.

Ar in the formula (1) is a naphthalene ring and examples of the quinone compound include, but are not limited to, naphthoquinone, methyl-naphthoquinone, cyclohexyl-naphthoquinone, methoxy-naphthoquinone, ethoxy-naphthoquinone, dimethyl-naphthoquinone, dimethyl-isopropyl-naphthoquinone, methyl-methoxy-naphthoquinone and the like.

Examples of the phosphorus compound of the raw material to be used in the abovementioned reaction include, but are not limited to, diphenyl phosphine oxide and the like, DOPO, 8-methyl-9,10-dihydro-9-oxa-10-phosphaphenanthrene-10-oxide, 8-benzyl-9,10-dihydro-9-oxa-10-phosphaphenanthrene-10-oxide, 8-phenyl-9,10-dihydro-9-oxa-1-phosphaphenanthrene-10-oxide, 2,6,8-tri-t-butyl-9,10-dihydro-9-oxa-10-phosphaphenanthrene-10-oxide, 6,8-dicyclohexyl-9,10-dihydro-9-oxa-10-phosphaphenanthrene-10-oxide and the like. These phosphorus compounds may be used singly or in a mixture of two or more thereof.

After completion of the reaction, the reaction solution is separated by filtration into an organic solvent and a product, and then subjected to the above step 2 in order to reduce the amount of by-products in the product. In step 2, after the reaction mixture is mixed with and dissolved in a good solvent, insoluble by-products are preferably removed by filtration or the like. The good solvent is ethylene glycol, propylene glycol, diethylene glycol, cyclohexanone, benzyl alcohol, acetic acid esters or benzoic acid esters. These solvents may be used singly or in a mixture of two or more thereof. Of these solvents, acetic acid esters are preferred, and benzyl acetate is more preferred.

Thereafter, in order to obtain the phosphorus-containing phenolic compound of the present invention in high purity from the solution, the step 3 is implemented. In step 3, it is preferable to mix with the poor solvent to obtain a product by precipitation separation. The poor solvent is methanol, ethanol, butanol or acetone. These solvents may be used singly or in a mixture of two or more thereof. Among these solvents, methanol, ethanol and acetone are preferable, and methanol and ethanol are more preferable. These solvents may be water-containing products. In this case, up to 100 parts by mass of water may be contained with respect to 100 parts by mass of the solvent.

Moreover, it is also possible to perform a purification operation, such as extraction, washing, distillation and the like as another method of high-level purification.

The preferable organophosphorus compound represented by the formula (1) which is obtained in such a manner can be exemplified by phosphorus-containing phenolic compounds represented by following formulae (1'-1), (1'-3) and (1'-5) (compounds represented by formulae (1'-2) and (1'-4)) not being according to the invention).

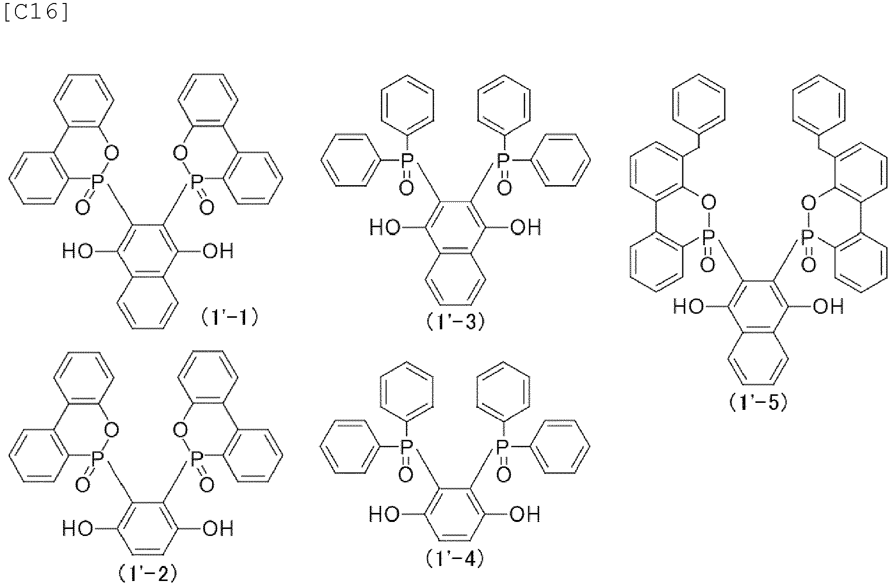

Next, the phosphorus-containing epoxy resin of the present invention will be described.

The phosphorus-containing epoxy resin of the present invention is obtained by reacting the phosphorus-containing phenolic compound (1) and an epoxy resin. The product has a structure obtained by reaction of the hydroxy group of the phosphorus-containing phenolic compound (1) and the epoxy group of the epoxy resin.

That is, the product has a structural segment b represented by the formula (b). This structural segment b is introduced in the phosphorus-containing epoxy resin by reacting the phosphorus-containing phenolic compound (1) and an epoxy resin.

In formula (b), Ar and Z have the same meaning as in the formula (1) of the organophosphorus compound described above.

The epoxy equivalent (g/eq.) of the phosphorus-containing epoxy resin of the present invention is preferably 100 to 1500, more preferably 160 to 1200, still more preferably 200 to 800, and particularly preferably 250 to 700. When the epoxy equivalent is low, the introduction of the phosphorus structure is small and the flame retardancy may be deteriorated. When the epoxy equivalent is high, the molecular chain becomes longer than necessary, and adverse effects such as deterioration of solvent solubility and increase of resin viscosity may be enhanced. Further, the number of addition reaction sites with epoxy groups is increased and the number of epoxy groups is decreased. Therefore, the crosslink density of the cured product becomes low, thereby causing a serious problem in use, such as decrease of the elastic modulus at a solder reflow temperature. However, when a reactive flame retardant is target use, one epoxy group is sufficient and the upper limit of the epoxy equivalent does not have to be particularly considered.

Moreover, when the use is simply for a flame retardant, a high phosphorus content ratio is preferable because flame retardancy will be exhibited even when the amount used is small. However, when the target use is to exhibit the effect of epoxy resin, the phosphorus content ratio is preferably 0.5% by mass to 15% by mass, more preferably 1% by mass to 8% by mass, even more preferably 1.5% by mass to 6.0% by mass, and particularly preferably 2.0% by mass to 3.5% by mass, as phosphorus, in the phosphorus-containing epoxy resin. When the phosphorus content ratio is low, the flame retardancy may be deteriorated. When the phosphorus content ratio is high, there is a possibility that adverse effects such as deterioration in solvent solubility and moisture absorption resistance and increase in resin viscosity may increase to overshadow the effect of improving flame retardancy. Therefore, it is effective to manage the upper limit.

The phosphorus-containing epoxy resin of the present invention has flame retardancy and heat resistance improved over those of a phosphorus-containing epoxy resin having no structural segment b, the phosphorus content ratio in the resins being the same. It is impossible to quantify the structural segment b in the phosphorus-containing epoxy resin, and the characterization is also quite difficult. For example, after isolation of only low-molecular-weight components in the phosphorus-containing epoxy resin, the presence of the structural segment b can be confirmed by analysis such as NMR, but the isolation requires an operation such as fractionation or the like. In short, since the reaction between the epoxy group and the hydroxy group contained in the phosphorus-containing reactive agent including the phosphorus-containing phenolic compound (1), which is used as a raw material, as an essential component proceeds almost quantitatively, it is possible to analyze this phosphorus-containing reactive agent and perform calculation from the amount of the phosphorus-containing phenolic compound (1) contained therein. As supporting evidence, there is a method of measuring the remaining amount of the phosphorus-containing phenolic compound (1) in the phosphorus-containing epoxy resin. The phosphorus-containing phenolic compound (1) is essential for the introduction of the structural segment b, and under normal reaction conditions, the phosphorus-containing phenolic compound (1) may remain although in a small amount. By verifying the remaining phosphorus-containing phenolic compound (1), it can be determined whether the phosphorus-containing epoxy resin of the present invention has the structural segment b. Specifically, the determination is based on whether the structural segment is detected by high performance liquid chromatography (HPLC) measurement under measurement conditions with a lowest detection sensitivity of 0.01% by mass. The structural segment b is preferably 0.01% by mass to 60% by mass, more preferably 0.1% by mass to 50% by mass, still more preferably 1.0% by mass to 40% by mass, and particularly preferably 10% by mass to 30% by mass in the phosphorus-containing epoxy resin.

The phosphorus-containing epoxy resin of the present invention has the above structural segment b, and preferably further has a structural segment c. The entire structure including these structural segments b and c is represented by the above formula (b1), or the above formula (b1) and formula (c1). E in the formulas (b1) and (c1) is an organic group represented by -R-A¹, -R- is a linking group generated by the reaction of an epoxy group of a polyfunctional epoxy resin and a hydroxy group, A¹ is a residue of the polyfunctional epoxy resin, and contains 1 mol or more of an epoxy group or an epoxy derivative group thereof per 1 mol of A¹, where at least a part of the epoxy group and the epoxy derivative group thereof is an epoxy group, and the epoxy derivative group is generated from an epoxy group and a phenolic compound having a structure in which a phosphorus-containing group Z and a hydroxy group are bonded to Ar. Further, E in the formula (b1) and formula (c1) may be shared with other formula (b1) or formula (c1).

The hydroxy group of the phosphorus-containing reactive agent used as the raw material reacts with the epoxy group of the epoxy resin to form a linking group R to bond the two. The linking group R is determined by the type of epoxy resin. When the epoxy resin is a glycidyl ether or a glycidyl ester, -R-A¹ is represented by -CH₂-CH(OH)-CH₂-O-A¹, in the case of glycidyl amine, it is represented by -CH₂-CH(OH)-CH₂-N-A¹, and in the case of polyvinylarene polyoxide, it is represented by -CH₂-CH(OH)-A¹. Further, when an epoxy resin is alicyclic like a celloxide, it becomes what is represented by formula (E1). Since the reaction mechanism of a hydroxy group and an epoxy group of various epoxy resins is well known, it is possible to understand the linking group R from the reaction formulas described above and below.

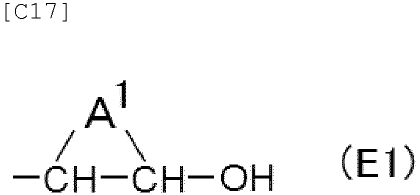

A¹ is the residue of the polyfunctional epoxy resin, one of the epoxy groups thereof being used to form the linking group R, the other epoxy group remaining unreacted or further reacting with the phosphorus-containing reactive agent used as a raw material to form an epoxy derivative. That is, since the phosphorus-containing phenolic compound in the phosphorus-containing reactive agent is a phenolic compound having a structure in which the phosphorus-containing group Z and the hydroxy group are bonded to Ar, the hydroxy group of the phosphorus compound reacts with the epoxy group of the polyfunctional epoxy resin to form the linking group R, and an epoxy derivative group of a structure in which the polyfunctional epoxy resin is bonded to Ar of the phosphorus compound through the linking group R is obtained. This phosphorus-containing reactive agent may be the phosphorus-containing phenolic compound (1) in the formula (1) or the phosphorus-containing phenolic compound (3) in the formula (3), and as a result, a compound having the structural segment b and the structural segment c at the same time can be obtained. Further, since A¹ can further have the linking group R, E including A¹ can be E in the formula (b1), can be E in the formula (c1), and can be shared. Sharing, as referred to herein, means a structure such as Ar^{b}-E-Ar^{c} under the condition where Ar in the formula (b1) is denoted by Ar^{b} and Ar in the formula (c1) is denoted by Ar^{c}, and this structure satisfies both the formula (b1) and the formula (c1). That is, the structures in the formula (b1) and the formula (c1) may be present separately, or may share E and be present in one molecule as described above. Further, since the formula (b1) and the formula (c1) also represent resins, E can have a structure in which a plurality of structural segments in the formula (b), formula (c) or both formulas is linked via another E or the linking groups R, and also can include a residue segment E' corresponding to E.

A¹ contains 1 mol or more of an epoxy group or an epoxy derivative group thereof per 1 mol of A¹, where at least a part of the epoxy group and the epoxy derivative group thereof is an epoxy group. As a result of having a plurality of epoxy groups, the polyfunctional epoxy resin can be crosslinked to have the structural segment b and the structural segment c in one molecule at the same time. However, since it is an epoxy resin, the resin has an epoxy group necessary to satisfy the abovementioned epoxy equivalent. The details of A¹ can be understood from the specific examples and reaction formulas of the phosphorus-containing epoxy resin of the present invention described hereinbelow.

The phosphorus-containing epoxy resin of the present invention is obtained by reacting the hydroxy groups of the phosphorus compound represented by the formula (1) with the epoxy groups of the epoxy resin.

A method for producing the phosphorus-containing epoxy resin of the present invention is described hereinbelow.

The method for producing the phosphorus-containing epoxy resin of the present invention is not unique to the present invention, and it is sufficient to react the reactive agent (x) which includes the phosphorus-containing phenolic compound (1) as an essential component with the polyfunctional epoxy resin (y). For example, publicly known and commonly used methods such as the method disclosed in Japanese Patent Application Publication No. H 11-279258, an advance method which is a method for reacting a phenolic compound and an epoxy resin, and the like can be used.

The reactive agent (x) is composed of one or two or more compounds having a functional group that will react with an epoxy group, and as a compound having a functional group reactive with an epoxy group, it can be divided into a phosphorus-containing reactive agent (p) composed of a phosphorus compound including phosphorus, and a compound (x1) containing no phosphorus. Here, since the phosphorus-containing reactive agent (p) is composed of a phosphorus compound, it is also referred to as a phosphorus compound (p). The reactive agent (x) includes the phosphorus-containing reactant (p) as an essential component and optionally includes the compound (x1). Further, the reactive agent (x), or the phosphorus-containing reactive agent (p) includes the phosphorus-containing phenolic compound (1) as an essential component.

The phosphorus-containing phenolic compound (1) can be used as the phosphorus-containing reactant (p) including another phosphorus-containing phenolic compound such as the phosphorus-containing phenolic compound (3) or another phosphorus compound having a functional group reactive with an epoxy group. The phosphorus-containing phenolic compound (1) is obtained by the above reaction, but is usually obtained as a reaction mixture including a by-product and unreacted substances. Such a reaction mixture, or a mixture obtained by partial purification thereof is excellent as the phosphorus-containing reactive agent (p). The reactive agent (x) can include a compound (x1) having a functional group reactive with an epoxy group, the compound (x1) being other than the phosphorus-containing reactive agent (p).

The phosphorus-containing reactive agent (p) may be the phosphorus-containing phenolic compound (1) alone, or may be a mixture thereof with a phosphorus compound having a functional group reactive with an epoxy group. The phosphorus-containing phenolic compound (1) has better heat resistance and flame retardancy as compared to the phosphorus-containing phenolic compound (3) and the phosphorus compound (2) conventionally known as flame retardants. The reason therefor is considered hereinbelow. The phosphorus-containing phenolic compound (1) and the phosphorus-containing phenolic compound (3) are bifunctional and, therefore, uniformly incorporated into the entire cured product, but it is conceivable that since phosphorus atoms are more unevenly distributed in the phosphorus-containing phenolic compound (1) than in the phosphorus-containing phenolic compound (3), char formation in the cured product advances far more preferentially, thereby improving flame retardancy. Moreover, it is also conceivable that the heat resistance of the cured product is improved because the phosphorus-containing phenolic compound (1) is bifunctional, whereas the phosphorus compound (2) is monofunctional.

The phosphorus-containing reactive agent (p) may be one obtained by isolating the phosphorus-containing phenolic compound (1), but can be used as a reaction mixture in a state where by-products shown in the above reaction formula are mixed, or as a concentrate obtained by performing purification operations such as extraction, washing, recrystallization, distillation and the like in order to reduce the amount of by-products contained in the reaction mixture. Further, it may be a mixture of the isolated or concentrated phosphorus-containing phenolic compound (1) and another phosphorus compound such as the phosphorus-containing phenolic compound (3). The phosphorus compound (4) is preferably removed because it adversely affects the curability as disclosed in PTL 7.

Since many complex steps are required to isolate the phosphorus-containing phenolic compound (1), it is industrially preferable to use this compound in a state of being mixed with the phosphorus-containing phenolic compound (3) and the phosphorus compound (2). Because the flame retardancy in this case is slightly inferior to that when the phosphorus-containing phenolic compound (1) is used alone, a usage mode in which the phosphorus content ratio in the composition is slightly increased is preferable.

In this case, the content ratio of the phosphorus-containing phenolic compound (1) is preferably 0.1% by mass to 35% by mass, more preferably 0.5% by mass to 30% by mass, and still more preferably 1.0% by mass to 25% by mass of the phosphorus-containing reactive agent (p). When the content ratio is 0.1 mass% or more with respect to the phosphorus containing reactive agent (p) which does not contain a phosphorus-containing phenolic compound (1) at all, the improvement effect of the flame retardancy is recognized. In addition, a higher upper limit results in a higher improvement effect of the flame retardancy, but when the actual reaction is taken into consideration, it is preferable to control the content ratio to about 35% by mass from the viewpoint of suppressing by-produced impurities such as the phosphorus compound (4).

In the method for producing the phosphorus-containing epoxy resin of the present invention, an epoxy resin having 2 or more, preferably 3 or more epoxy groups in a molecule may be used as the polyfunctional epoxy resin (y). Specific examples of such an epoxy resin include, but are not limited to, polyglycidyl ether compounds, polyglycidyl amine compounds, polyglycidyl ester compounds, alicyclic epoxy resins, and other modified epoxy resins. These epoxy resins may be used singly, or two or more of the epoxy resins of the same system may be used together with each other, or epoxy resins of different systems may be used in combination. Among these epoxy resins, a phenol novolak epoxy resin excels in utility and is particularly preferable from the viewpoint of cost and properties such as heat resistance, flame retardancy and the like.

Specific examples of the polyglycidyl ether compounds include, but are not limited to, bisphenol A type epoxy resin, bisphenol F type epoxy resin, tetramethyl bisphenol F type epoxy resin, biphenol type epoxy resin, hydroquinone type epoxy resin, bisphenol fluorene type epoxy resin, naphthalene diol type epoxy resin, bisphenol S type epoxy resin, diphenyl sulfide type epoxy resin, diphenyl ether type epoxy resin, resorcinol type epoxy resin, phenol novolak type epoxy resin, cresol novolak type epoxy resin, alkyl novolak type epoxy resin, styrenated phenol novolak type epoxy resin, bisphenol novolak type epoxy resin, naphthol novolak type epoxy resin, β-naphthol aralkyl type epoxy resin, naphthalenediol aralkyl type epoxy resin, α-naphthol aralkyl type epoxy resin, biphenyl aralkyl phenol type epoxy resin, trihydroxyphenylmethane type epoxy resin, tetrahydroxyphenylethane type epoxy resin, dicyclopentadiene type epoxy resin, alkylene glycol type epoxy resin, aliphatic cyclic epoxy resin and the like.

Specific examples of the polyglycidyl amine compounds include, but are not limited to, diaminodiphenylmethane type epoxy resin, metaxylene diamine type epoxy resin, 1,3-bisaminomethylcyclohexane type epoxy resin, isocyanurate type epoxy resin, aniline type epoxy resin, hydantoin type epoxy resin, aminophenol type epoxy resin, and the like.

Specific examples of the polyglycidyl ester compounds include, but are not limited to, dimer acid type epoxy resin, hexahydrophthalic acid type epoxy resin, trimellitic acid type epoxy resin, and the like.

Examples of the alicyclic epoxy resins include, but are not limited to, aliphatic cyclic epoxy resins such as CELOXIDE 2021 (manufactured by Daicel Chemical Industries, Ltd.) and the like.

Specific examples of the other modified epoxy resins include, but are not limited to, urethane-modified epoxy resins, oxazolidone ring-containing epoxy resins, epoxy-modified polybutadiene rubber derivatives, CTBN-modified epoxy resins, polyvinylarene polyoxides (for example, divinyl benzene dioxide, trivinyl naphthalene trioxide and the like), phosphorus-containing epoxy resins, and the like.

The reaction of the phosphorus-containing phenolic compound (1) with the polyfunctional epoxy resin (y) is specifically exemplified hereinbelow. When using a phenol novolak type epoxy resin represented by formula (y-1) as the epoxy resin and a phosphorus-containing phenolic compound represented by the above formula (1-1) as the phosphorus-containing phenolic compound, as an example, a phosphorus-containing epoxy resin represented by formula (7-1) is obtained. This is an example in which two phenol novolak type epoxy resins and one phosphorus-containing phenolic compound in the formula (1-1) have reacted.

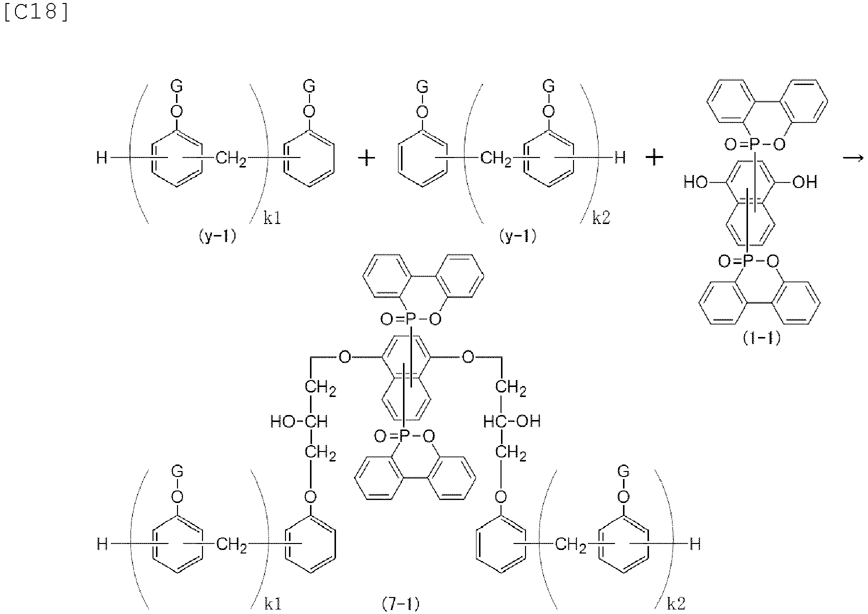

Here, G represents a glycidyl group. k1 and k2 are repetition numbers and are 1 or more.

When using a phenol novolak type epoxy resin represented by the formula (y-1) as the epoxy resin, a phosphorus-containing phenolic compound represented by the formula (1-1) as the phosphorus compound, and a phosphorus compound represented by a formula (2-2), as an example, a phosphorus-containing epoxy resin represented by formula (7-2) is obtained. This is an example in which two phenol novolak type epoxy resins, one phosphorus-containing phenolic compound represented by the formula (1-1), and one or more phosphorus compounds represented by the formula (2-2) have reacted.

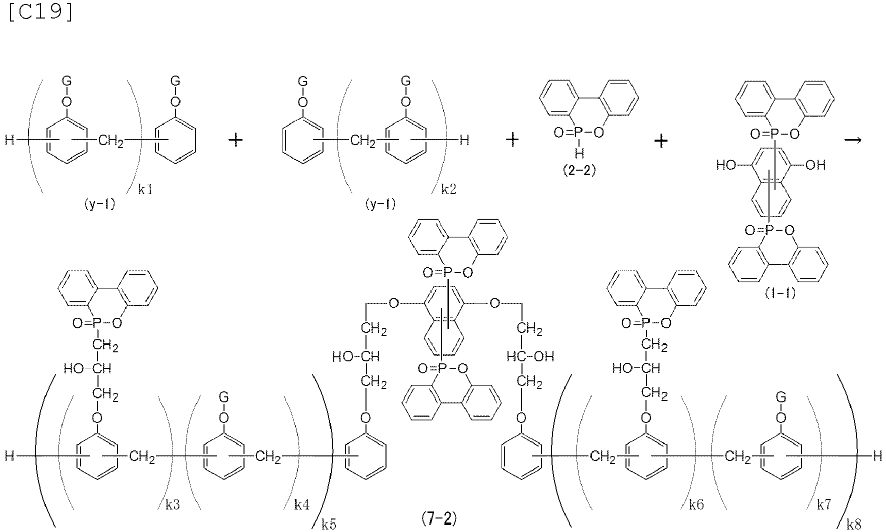

Here, G represents a glycidyl group. k1, k2, k5 and k8 are repetition numbers and are 1 or more. k3, k4, k6 and k7 are repetition numbers and are 0 or more, the sum of k3 and k4 in each k5 is k1, the sum of k6 and k7 in each k8 is k2, and at least one of k3 in k5 and k6 in k8 is 1 or more.

When using a glycidyl amine type epoxy resin represented by formula (y-2) as the epoxy resin and a phosphorus-containing phenolic compound represented by the formula (1-1) as the phosphorus compound, as an example, a phosphorus-containing epoxy resin represented by formula (8-1) is obtained.

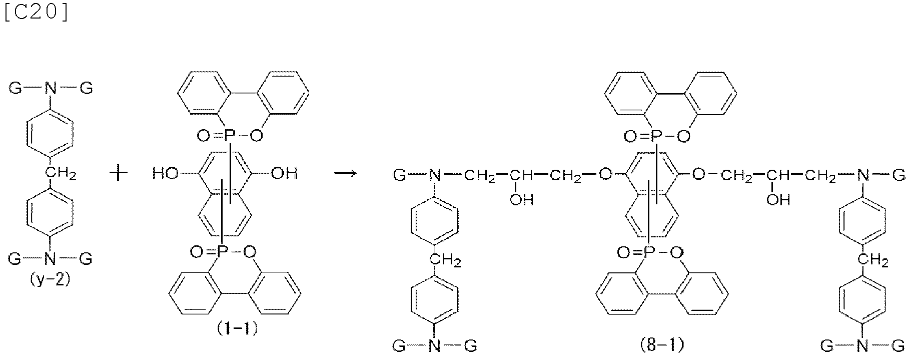

Here, G represents a glycidyl group.

When using a glycidyl amine type epoxy resin represented by formula (y-3) as the epoxy resin and a phosphorus-containing phenolic compound represented by the formula (1-1) as the phosphorus compound, as an example, a phosphorus-containing epoxy resin represented by formula (9-1) is obtained.

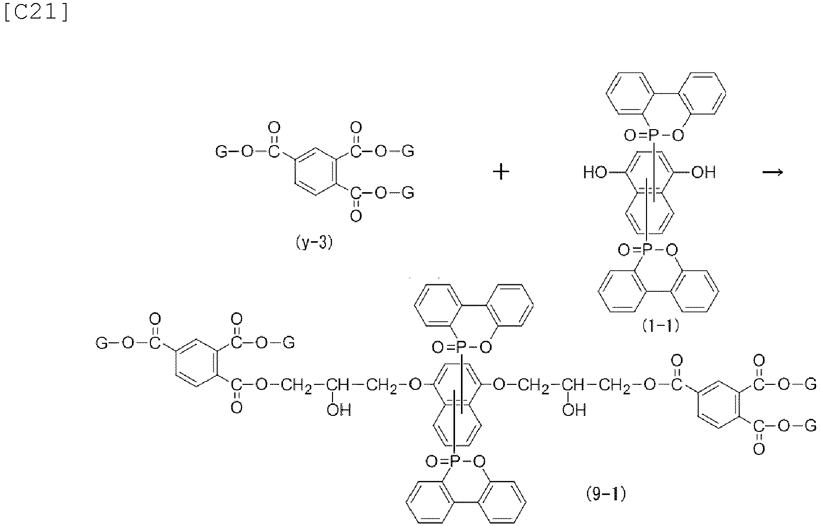

Here, G represents a glycidyl group.

When using an alicyclic epoxy resin represented by formula (y-4) as the epoxy resin and a phosphorus-containing phenolic compound represented by the formula (1-1) as the phosphorus compound, as an example, a phosphorus-containing epoxy resin represented by formula (10-1) is obtained.

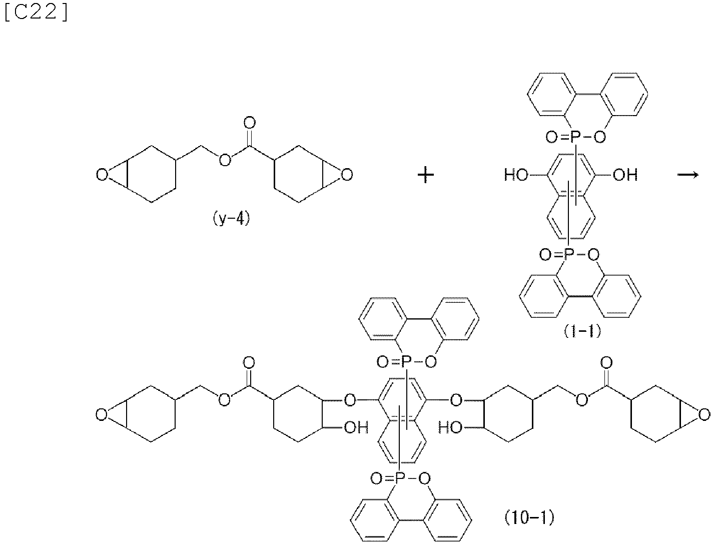

When using a polyvinylarene polyoxide represented by formula (y-5) as the epoxy resin and a phosphorus-containing phenolic compound represented by the formula (1-1) as the phosphorus-containing reactive agent compound, as an example, a phosphorus-containing epoxy resin represented by formula (11-1) is obtained.

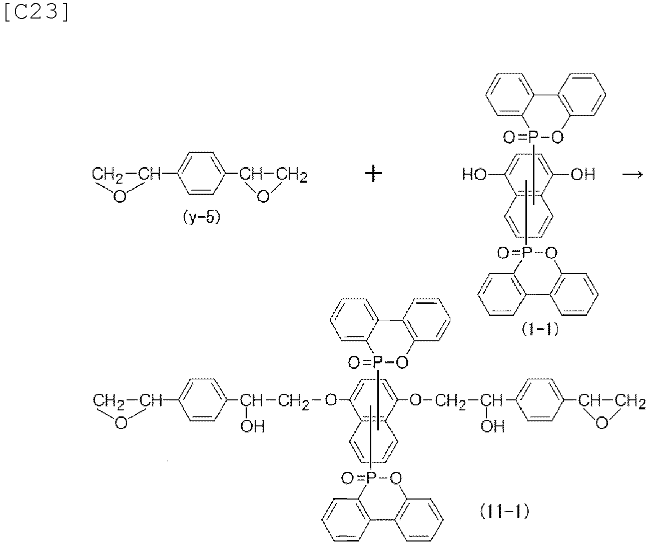

The epoxy equivalent, molecular weight, and the like can be adjusted by using, as necessary, various epoxy resin modifiers as the compound (x1) having a functional group reactive with an epoxy group, the compound (x1) being other than the phosphorus-containing reactive agent (p), in the reactive agent (x). Examples of various epoxy resin modifiers include, but are not limited to, phenolic compounds, amine compounds, carboxylic acids and the like. These epoxy resin modifiers may be used singly, or two or more kinds of epoxy resin modifiers of the same system may be used together, or epoxy resin modifiers of different systems may be used in combination. The suitable amount thereof is preferably 30 parts by mass or less, more preferably 20 parts by mass or less, and even more preferably 10 parts by mass or less with respect to 100 parts by mass of the epoxy resin.

Specific examples of the phenolic compound include, but are not limited to, monophenolic compounds such as nonylphenol, t-butylphenol, phenylphenol, naphthol and the like; bisphenols such as bisphenol A, dimethyl bisphenol A, tetramethyl bisphenol A, tetrabutyl bisphenol A, bisphenol F, dimethyl bisphenol F, tetramethyl bisphenol F, bis(4-hydroxyphenyl)sulfone, dimethyl bisphenol S, tetramethyl bisphenol S, 2,2-bis(4-hydroxyphenyl)butane, 2,2-bis(3-methyl-4-hydroxyphenyl)propane, 1,1-bis(4-hydroxyphenyl)ethane, 1,4-bis(2-(4-hydroxyphenyl)-2-propyl)benzene, 2,2-bis(4-hydroxyphenyl)hexafluoropropane, 1,1-bis(4-hydroxyphenyl)-1-phenylethane, bisphenol fluorene, biscresol fluorene, 1,1-bis(4-hydroxyphenyl)cyclohexane, tetramethyl bisphenol Z, 4,4'-(3,3,5-trimethylcyclohexylidene) bisphenol, dihydroxydiphenyl sulfide, 4,4'-thiobis(3-methyl-6-t-butylphenol), dihydroxydiphenyl ether, dihydroxybenzophenone, dihydroxydiphenyl sulfide, dihydroxystilbene and the like; biphenols such as biphenol, dimethyl biphenol, diethyl biphenol, di-t-butyl biphenol, tetramethyl biphenol and the like; dihydroxybenzenes such as hydroquinone, methylhydroquinone, dimethylhydroquinone, dibutylhydroquinone, methoxyhydroquinone, catechol, methyl catechol, dimethyl catechol, methoxy catechol, resorcinol, methyl resorcinol, hexyl resorcinol, dimethyl resorcinol, methoxy resorcinol and the like; polyhydroxynaphthalenes such as dihydroxynaphthalene, dihydroxymethyl naphthalene, trihydroxynaphthalene, tetrahydroxynaphthalene and the like;
a phenol compound such as a condensation product of a phenol and/or a naphthol and an aldehyde such as a phenol novolak resin, a cresol novolak resin, a bisphenol A novolak resin, trishydroxyphenylmethane type novolak resin, a styrenated phenol novolak resin, a naphthol novolak resin, a naphthol-phenol co-condensed novolak resin, a naphthol-cresol co-condensed novolak resin and the like; an aromatic hydrocarbon formaldehyde resin-modified phenolic resin; a condensation product of a phenol and/or naphthol and xylylene glycol and/or a xylylene dihalide, such as a phenol aralkyl resin, a naphthol aralkyl resin and the like; a reaction product of a phenol and/or a naphthol and dicyclopentadiene such as a dicyclopentadiene phenol resin; a condensation product of a phenol and/or a naphthol and isopropenyl acetophenone; a condensation product of a phenol and/or a naphthol and a biphenyl-based condensing agent, such as a biphenyl-modified phenol resin, a biphenyl-modified naphthol resin, and the like; an aminotriazine-modified phenol resin (a polyphenolic compound in which phenol nuclei are linked by melamine, benzoguanamine, and the like); polyfunctional phenol resins obtained by condensation reaction of various phenols and various aldehydes, such as crotonaldehyde, glyoxal and the like, such as a terpene phenol resin, a heavy oil-modified phenol resin and the like; polyfunctional phenol compounds in which these polyfunctional phenol resins are nucleus-substituted with a substituent such as alkyl group, alkoxy group, aryl group and the like; and the like.

As raw materials for these polyfunctional phenol compounds, phenols are exemplified by phenol, cresol, xylenol, butylphenol, octylphenol, amylphenol, nonylphenol, trimethylphenol, phenylphenol and the like. Naphthols are exemplified by 1-naphthol, 2-naphthol and the like. In addition, although not strictly naphthols, naphthalenediols such as 1,4-naphthalenediol, 1,5-naphthalenediol, 2,6-naphthalenediol, 2,7-naphthalenediol and the like are also included in naphthanols. Aldehydes are exemplified by formaldehyde, acetaldehyde, propylaldehyde, butyraldehyde, valeraldehyde, caproaldehyde, benzaldehyde, glyoxal, malonaldehyde, succinaldehyde, glutaraldehyde, adipaldehyde, pimelaldehyde, sebacaldehyde, acrolein, crotoaldehyde, alicylaldehyde, phthalaldehyde, hydroxybenzaldehyde and the like. Biphenyl-based condensing agents are exemplified by bis(methylol)biphenyl, bis(methoxymethyl)biphenyl, bis(ethoxymethyl)biphenyl, bis(chloromethyl)biphenyl and the like.

Specific examples of amine compounds include, but are not limited to, diethylenetriamine, triethylenetetramine, cyclohexanediamine, isophoronediamine, aniline, phenylenediamine, toluidine, xylidine, naphthylamine, methylnaphthaleneamine, xylylenediamine, toluenediamine, diethyltoluenediamine, diaminodiphenylmethane, dimethyldiaminodiphenylmethane, diaminodiphenylethane, diaminodiphenylpropane, diaminodiphenyl ketone, diaminodiphenyl sulfide, diaminodiphenyl sulfone, bis(aminophenyl) fluorene, diaminodiphenylether, diaminobenzanilide, diaminobiphenyl, dimethyldiaminobiphenyl, tetramethylbenzidine, biphenyl tetraamine, biphenyl aminophenyl anthracene, bisaminophenoxybenzene, bisaminophenoxyphenyl ether, bisaminophenoxybiphenyl, bisaminophenoxyphenyl sulfone, bisaminophenoxyphenylpropane, diaminonaphthalene, methylnaphthalene diamine, tetrahydronaphthalene diamine, decahydronaphthalene diamine, diaminobinaphthalene and the like.

Specific examples of the carboxylic acid include, but are not limited to, monocarboxylic acids such as acetic acid, lauric acid, benzoic acid and the like, and polyvalent carboxylic acids such as succinic acid, adipic acid, sebacic acid, dimer acid, hydrogenated dimer acid, cyclohexanedicarboxylic acid, phthalic acid, isophthalic acid, terephthalic acid, methyl phthalic acid, methyl isophthalic acid, methyl terephthalic acid, α-carboxyphenylacetic acid, biphenyldicarboxylic acid, naphthalenedicarboxylic acid, binaphthalenedicarboxylic acid, trimellitic acid, and the like.

In the method for producing the phosphorus-containing epoxy resin of the present invention, the molar ratio of the reactive agent (x) and the polyfunctional epoxy resin (y) may be in the range of 1 : 0.5 to 2.0 as represented by the equivalent ratio of the epoxy groups (phenolic hydroxy group and the like) of the reactive agent (x) which are reactive with an epoxy group and the epoxy groups of the polyfunctional epoxy resin (y).

The reaction temperature is preferably 100°C to 200°C, and more preferably 120°C to 180°C. When the rate of this reaction is slow, a catalyst can be used, as necessary, to improve productivity.

Specific examples of the catalyst that can be used include well-known and commonly used catalyst such as phosphines such as triphenylphosphine, tritolylphosphine, trixylylphosphine, tris(para-methoxyphenyl)phosphine, tris(dimethoxyphenyl)phosphine, tris(t-butoxyphenyl)phosphine and the like; quaternary phosphonium salts such as n-butyltriphenylphosphonium bromide, ethyltriphenylphosphonium bromide, ethyltriphenylphosphonium iodide, tetraphenylphosphonium bromide, and the like; imidazoles such as 2-methylimidazole, 2-ethyl-4-methylimidazole, 2-phenylimidazole, and the like; quaternary ammonium salts such as tetramethyl ammonium chloride, tetraethyl ammonium bromide, and the like; tertiary amines such as triethylamine, benzyldimethylamine and the like; and the like. These catalysts may be used singly, or two or more types of catalysts of the same system may be used together, or catalysts of different systems may be used in combination. The amount of these catalysts to be used is preferably 0.002 to 2 parts by mass, more preferably 0.003 to 1 parts by mass, and still more preferably 0.005 to 0.5 parts by mass with respect to 100 parts by mass of the reactive agent (x). A large amount used makes the reaction control difficult, and can make it impossible to obtain a phosphorus-containing epoxy resin having a stable viscosity. Furthermore, the storage stability of the epoxy resin composition of the present invention may be adversely affected.

Moreover, a non-reactive organic solvent may be used as needed. Specific examples thereof include but are not limited to hydrocarbons such as hexane, heptane, octane, decane, dimethylbutane, pentene, cyclohexane, methylcyclohexane, benzene, toluene, xylene, ethylbenzene and the like; ketones such as acetone, ethyl methyl ketone, methyl isobutyl ketone, cyclohexanone and the like; ethers such as ethyl ether, isopropyl ether, butyl ether, diisoamyl ether, methyl phenyl ether, ethyl phenyl ether, amyl phenyl ether, ethyl benzyl ether, dioxane, methyl furan, tetrahydrofuran, diethylene glycol dimethyl ether, ethylene glycol diethyl ether, ethyl methyl carbitol and the like; esters such as methyl cellosolve acetate, cellosolve acetate, butyl cellosolve acetate, methyl acetate, ethyl acetate, propyl acetate, butyl acetate, diethyl oxalate and the like; amides such as N-methyl-2-pyrrolidone, N,N-dimethylacetamide, N,N-dimethylformamide and the like; lactones such as γ-butyrolactone and the like; sulfoxides such as dimethyl sulfoxide and the like; ureas such as tetramethyl urea and the like; halogenated hydrocarbons such as dichloromethane, 1,2-dichloroethane, 1,4-dichlorobutane, chlorobenzene, o-dichlorobenzene and the like; and the like. These non-reactive organic solvents may be used singly or in combination of two or more. The amount of the solvent used is preferably 1 to 900 parts by mass, and more preferably 5 to 100 parts by mass with respect to 100 parts by mass of the epoxy resin.

As described above, the phosphorus-containing epoxy resin of the present invention may be obtained by reacting the phosphorus compound (2) and the quinone compound (q) to obtain the reaction mixture containing phosphorus-containing phenolic compound (1) of the present invention, then adding the polyfunctional epoxy resin (y) and, if necessary, the compound (x1) having a functional group reactive with an epoxy group, the compound (x1) being other than the phosphorus-containing reactive agent (p), without taking the obtained reaction mixture from the system, and conducting a reaction. It is also possible to purify the reaction mixture and concentrate one or two or more products or unreacted products such as shown in the reaction formula (30) together with the phosphorus-containing phenolic compound (1).

The reaction time may be about 1 to 10 hours, and the reaction may be carried out until the functional groups reactive with epoxy group or the hydroxy groups of the phosphorus compound are almost eliminated. Further, in order to impart properties such as viscosity reduction and the like, depending on the situation, the reaction rate may be set to 60% to 95% by the manufacturing method disclosed in Japanese Patent Application Publication No. 2012-172079. After completion of the reaction, the solvent and the like are removed as necessary to obtain the phosphorus-containing epoxy resin of the present invention.

Next, a curable resin composition obtained by blending the phosphorus-containing phenolic compound of the present invention as an essential component in a thermosetting resin will be described.

Examples of the thermosetting resin include a phenol resin, a melamine resin, a urea resin, an unsaturated polyester resin, an alkyd resin, a diallyl phthalate resin, a thermosetting polyimide resin, an epoxy resin composition including an epoxy resin and a curing agent, and the like, and the epoxy resin composition is preferred.

Since the phosphorus-containing phenolic compound of the present invention has a phosphorus-containing structure that contributes to flame retardancy, the flame retardancy of a curable resin composition including such a thermosetting resin is improved. In addition, since the phosphorus-containing phenolic compound of the present invention also has a hydroxy group that functions as an epoxy resin curing agent, excellent performance of an epoxy resin composition is achieved.

The blended composition of the curable resin composition is not particularly limited, but the organophosphorus compound of the present invention is usually 0.1 to 100 parts by mass, preferably 1 to 50 parts by mass, and more preferably 5 to 30 parts by mass with respect to 100 parts by mass of the thermosetting resin. Moreover, it is preferable that an inorganic filler and a phosphorus type flame retardant which are described hereinbelow be also included in the composition. In addition, in consideration of flame retardancy, it is preferable to determine the blending by the phosphorus content ratio rather than by managing by the blending amount of the organophosphorus compound.

As an epoxy resin to be included in the curable resin composition, an epoxy resin having 2 or more, preferably 3 or more of epoxy groups in a molecule may be used. Specifically, an epoxy resin of the same type as the polyfunctional epoxy resin (y) usable in the production of the phosphorus-containing epoxy resin can be mentioned. These epoxy resins may be used singly, or two or more epoxy resins of the same system may be used together, or epoxy resins of different systems may be used in combination. Among these epoxy resins, a phenol novolak epoxy resin excels in utility and is particularly preferable from the viewpoint of cost and properties such as heat resistance, flame retardancy and the like.

The curing agent is not particularly limited as long as the epoxy resin can be cured, and a phenol-based curing agent, an acid anhydride-based curing agent, an amine-based curing agent, a hydrazide-based curing agent, an active ester-based curing agent, a phosphorus-containing curing agent can be used. These curing agents may be used singly, or two or more curing agents of the same system may be used together, or curing agents of different systems may be used in combination. Among these, dicyandiamide and a phenol-based curing agent are preferred.

In a curable resin composition using an epoxy resin, the amount of the curing agent used is such that the amount of active hydrogen groups of the curing agent is 0.2 mol to 1.5 mol with respect to 1 mol of the epoxy groups of the epoxy resin. When the amount of the active hydrogen groups is less than 0.2 mol or more than 1.5 mol with respect to 1 mol of the epoxy groups, curing may be incomplete and good cured product properties may not be obtained. A preferred range is 0.3 to 1.5 mol, a more preferred range is 0.5 to 1.5 mol, and a further preferred range is 0.8 to 1.2 mol. For example, when a phenol-based curing agent, an amine-based curing agent or an active ester-based curing agent is used, blending is such that the number of moles of the active hydrogen groups is substantially equal to that of the epoxy groups, and when an acid anhydride-based curing agent is used, blending is such that the acid anhydride groups are present at 0.5 to 1.2 mol, and preferably 0.6 to 1.0 mol with respect to 1 mol of the epoxy groups.

The term "active hydrogen group", as used in the present description, refers to a functional group having active hydrogen reactive with an epoxy group (inclusive of a functional group having latent active hydrogen that generates active hydrogen upon hydrolysis or the like, or a functional group exhibiting an equivalent curing action), and specific examples thereof include an acid anhydride group, a carboxyl group, an amino group, a phenolic hydroxy group and the like. Carboxyl groups (-COOH) and phenolic hydroxy groups (-OH) are calculated as 1 mol, and amino groups (-NH₂) are calculated as 2 moles with respect to the active hydrogen groups. Further, when an active hydrogen group is not clear, an active hydrogen equivalent can be obtained by measurement. For example, the active hydrogen equivalent of the used curing agent can be obtained by reacting a monoepoxy resin having a known epoxy equivalent such as phenyl glycidyl ether with a curing agent having an unknown active hydrogen equivalent and measuring the amount of the monoepoxy resin consumed. In the present description, the unit of each equivalent is "g/eq.".

The phenol-based curing agent can be exemplified by polyfunctional phenolic compounds which can be used as the abovementioned various epoxy resin modifiers.

Among these phenol-based curing agents, those including many aromatic skeletons in the molecular structure are preferable, and examples thereof include a phenol novolak resin, a cresol novolak resin, a phenol resin modified with an aromatic hydrocarbon formaldehyde resin, a phenol aralkyl resin, a naphthol aralkyl resin, a naphthol novolak resin, a naphthol-phenol co-condensed novolak resin, a naphthol-cresol co-condensed novolak resin, a biphenyl-modified phenolic resin, a biphenyl-modified naphthol resin, and an aminotriazine-modified phenolic resin.

Benzoxazine compounds which are ring-opened upon heating to be phenolic compounds are also useful as curing agents. Specific examples thereof include, but are not limited to, benzoxazine compounds of bisphenol F type or bisphenol S type or the like.

Specific examples of the acid anhydride-based curing agents include, but are not limited to, tetrahydrophthalic anhydride, methyltetrahydrophthalic anhydride, hexahydrophthalic anhydride, methylhexahydrophthalic anhydride, phthalic anhydride, trimellitic anhydride, hydrogenated trimellitic anhydride, methyl nadic anhydride, succinic anhydride, maleic anhydride, and the like, 4,4'-oxydiphthalic anhydride, 4,4'-biphthalic anhydride, pyromellitic anhydride, hydrogenated pyromellitic anhydride, 1,2,3,4-cyclobutanetetracarboxylic dianhydride, 1,2,3,4-cyclopentanetetracarboxylic dianhydride, 5- (2,5-dioxotetrahydrofurfuryl)-3-methyl-3-cyclohexene-1,2-dicarboxylic anhydride, 4-(2,5-dioxotetrahydrofuran-3-yl)-1,2,3,4-tetrahydronaphthalene-1,2-dicarboxylic anhydride and the like.

Examples of amine-based curing agents include, but are not limited to, amine compounds that can be used as the abovementioned various epoxy resin modifiers. Other examples include, but are not limited to, amine compounds such as 2,4,6-tris (dimethylaminomethyl)phenol, dimer diamine, dicyandiamide and derivatives thereof, and also amine compounds, such as polyamidoamine and the like, which are condensation products of acids such as dimer acid or the like and polyamines, and the like.

Specific examples of the hydrazide-based curing agents include, but are not limited to, adipic acid dihydrazide, isophthalic acid dihydrazide, sebacic acid dihydrazide, dodecanedioic acid dihydrazide and the like.

Examples of active ester-based curing agents include, but are not limited to, reaction products of polyfunctional phenolic compounds and aromatic carboxylic acids as described in Japanese Patent No. 5152445, and examples of commercially available products include Epiclone HPC-8000-65T (DIC Corporation) and the like.

Specific examples of other curing agents include, but are not limited to, phosphine compounds such as triphenylphosphine, tris (2,6-dimethoxyphenyl)phosphine and the like, phosphonium salts such as n-butyltriphenylphosphonium bromide, ethyltriphenylphosphonium bromide, ethyltriphenylphosphonium iodide, tetraphenylphosphonium bromide and the like, imidazoles such as 2-methylimidazole, 2-phenylimidazole, 2-ethyl-4-methylimidazole, 2-undecylimidazole, 1-cyanoethyl-2-methylimidazole and the like, imidazole salts which are salts of imidazoles with trimellitic acid, isocyanuric acid, boric acid and the like, quaternary ammonium salts such as tetramethyl ammonium chloride, tetramethyl ammonium bromide, tetramethyl ammonium hydroxide, triethylmethyl ammonium chloride, tetraethyl ammonium chloride, tetraethyl ammonium bromide, tetraethyl ammonium iodide, tetrapropyl ammonium hydroxide, tetrapropyl ammonium chloride, tetrapropyl ammonium bromide, tetrabutyl ammonium chloride, tetrabutyl ammonium bromide, tetrabutyl ammonium iodide, benzyltrimethylammonium hydroxide, benzyltributylammonium chloride, phenyltrimethylammonium chloride and the like, diazabicyclo compounds, salts of diazabicyclo compounds with phenolic compounds and the like, complexes of boron trifluoride and amines or ether compounds and the like, iodonium salts, and the like.

Next, an epoxy resin composition including the phosphorus-containing epoxy resin of the present invention as an essential component and a curing agent for the epoxy resin blended therein is described.

In the curable resin composition formed by blending the above-described phosphorus-containing phenolic compound as an essential component with the thermosetting resin, a curing agent that can be used when an epoxy resin is used as the thermosetting resin can be likewise used as the curing agent for the epoxy resin.

A curing accelerator can be used, as necessary, for the curable resin composition and epoxy resin composition of the present invention. Examples of the curing accelerator include, but are not limited to, imidazole derivatives, tertiary amines, organophosphorus compounds such as phosphines, metal compounds, Lewis acids, amine complexes and the like. These curing accelerators may be used singly or in combination of two or more.

Among these curing accelerators, when the application is for build-up materials and circuit boards, 2-dimethylaminopyridine, 4-dimethylaminopyridine, and imidazoles are preferable in view of excellent heat resistance, dielectric properties, solder resistance and the like. Moreover, when the application is for semiconductor sealing materials, triphenyl phosphine and DBU are preferable in view of excellent curability, heat resistance, electrical properties, moisture-resistant reliability and the like.

The compounded amount of the curing accelerator may be appropriately selected according to the purpose of use, but 0.01 to 15 parts by mass can be used as needed with respect to 100 parts by mass of the epoxy resin component in the epoxy resin composition. The amount is preferably 0.01 to 10 parts by mass, more preferably 0.05 to 8 parts by mass, and still more preferably 0.1 to 5 parts by mass. By using a curing accelerator, the curing temperature can be lowered and the curing time can be shortened.

In the curable resin composition and the epoxy resin composition of the present invention, various non-halogen flame retardants including substantially no halogen can be also used in combination, within a range in which reliability is not reduced, for the purpose of improving the flame retardancy of the cured product to be obtained. Examples of the non-halogen flame retardants that can be used include organophosphorus compounds (phosphorus-based flame retardants) other than that of the present invention, nitrogen-based flame retardants, silicone-based flame retardants, inorganic flame retardants, organic metal salt flame retardants, and the like. These non-halogen flame retardants are not limited at all in use, and may be used singly, or a plurality of flame retardants of the same system may be used, or flame retardants of different systems may be used in combination.

Examples of the organophosphorus compounds other than that of the present invention include, but are not limited to, general-purpose organophosphorus compounds such as phosphoric acid ester compounds, condensed phosphoric acid esters, phosphonic acid compounds, phosphinic acid compounds, phosphine oxide compounds, phosphorane compounds and the like, nitrogen-containing organophosphorus compounds, organophosphorus compound such as metal salts of phosphonic acid and also organic phosphorus compounds having an active hydrogen group directly bonded to a phosphorus element, organophosphorus compounds (for example, DOPO, diphenylphosphine oxide and the like) or phosphorus-containing phenolic compounds (for example, DOPO-HQ, 10-(2,7-dihydroxynaphthyl)-10H-9-oxa-10-phosphaphenanthrene-10-oxide (hereinafter abbreviated as DOPO-NQ), diphenylphosphinyl hydroquinone, diphenylphosphenyl-1,4-dioxynaphthalene, 1,4-cyclooctyrenephosphinyl-1,4-phenyldiol, 1,5-cyclooctyrenephosphinyl-1,4-phenyldiol, and the like), and derivatives obtained by reacting these organophosphorus compounds with compounds such as epoxy resin, phenol resin and the like.

When the phosphorus-based flame retardant is a phosphorus-containing epoxy resin that serves as an epoxy resin and also a curing agent, or a phosphorus-containing curing agent, the phosphorus-containing phenolic compound (1) of the present invention, a bivalent phosphorus-containing phenolic compound (3) having a phosphorus-containing group represented by the same formula (a1) and/or formula (a2), and a phosphorus compound (2) used as a raw material are preferred as the reactive organophosphorus compound used therein.

Examples of the phosphorus-containing epoxy resins that can be used in combination include, but are not limited to, Epotohto FX-305, FX-289B, TX-1320A, TX-1328 (all above are manufactured by Nippon Steel & Sumikin Chemical Co., Ltd.) and the like.

The epoxy equivalent of the phosphorus-containing epoxy resin that can be used is preferably 200 to 800, more preferably 300 to 780, and still more preferably 400 to 760. The phosphorus content ratio is preferably 0.5% by mass to 6% by mass, more preferably 2% by mass to 5.5% by mass, and still more preferably 3% by mass to 5% by mass.

In addition to the abovementioned organophosphorus compounds, phosphorus compounds suitable as the phosphorus-containing curing agents can be obtained by reacting a phosphorus compound having a phosphorus-containing group represented by the formula (a1) and/or formula (a2), with an aldehyde and a phenolic compound by a production method such as shown in Japanese Translation of International Patent Application No. 2008-501063 or Japanese Patent No. 4548547. In this case, the phosphorus compound having a phosphorus-containing group represented by the formula (a1) and/or formula (a2) is incorporated into the molecule by condensation addition via an aldehyde to the aromatic ring of the phenolic compound. Further, a phosphorus-containing active ester compound can be obtained from the phosphorus-containing phenolic compound having a phosphorus-containing group represented by the formula (a1) and/or formula (a2) by further reacting an aromatic carboxylic acid by a production method such as shown in JP-A-2013-185002. In addition, a phosphorus-containing benzoxazine compound having a phosphorus-containing group represented by the formula (a1) and/or formula (a2) can be obtained by the production method such as shown in WO 2008/010429.

The compounded amount of the phosphorus-based flame retardant to be used in combination is appropriately selected according to the type of the phosphorus-based flame retardant, phosphorus content ratio thereof, components of the curable resin composition, and the degree of desired flame retardancy. In the case of an organophosphorus compounds with a reactive phosphorus-based flame retardant, that is, a raw material phosphorus compound, by-produced phosphorus compounds (3), (4), a phosphorus-containing epoxy resin or a phosphorus-containing curing agent, the phosphorus content ratio is preferably 0.2% by mass to 6% by mass or less, more preferably 0.4% by mass to 4% by mass or less, even more preferably 0.5% by mass to 3.5% by mass or less, and still more preferably 0.6% by mass to 3.3% by mass or less, with respect to the solid fraction (nonvolatile fraction) in the curable resin composition obtained by blending all of the epoxy resin, curing agent, flame retardant, other fillers and additives and the like. When the phosphorus content ratio is low, it may be difficult to ensure flame retardancy, and where the phosphorus content ratio is too high, the heat resistance may be adversely affected. Further, not only the phosphorus content ratio of the phosphorus-based flame retardant which can be used in combination but also the phosphorus content ratio of the organophosphorus compound (1) of the present invention is included in the phosphorus content ratio in the curable resin composition referred to herein.

The compounded amount of the phosphorus-based flame retardant used in combination in the case of an additive system is preferably in the range of 0.1 to 2 parts by mass when red phosphorus is used, and is preferably in the range of 0.1 to 10 parts by mass, and particularly preferably in the range of 0.5 to 6 parts by mass when an organophosphorus compound is used, in 100 parts by mass of the solid fraction (nonvolatile fraction) in the curable resin composition.

Further, in the curable resin composition of the present invention, for example, hydrotalcite, magnesium hydroxide, a boron compound, zirconium oxide, calcium carbonate, zinc molybdate and the like may be used in combination as an auxiliary flame retardant.

In the curable resin composition and the epoxy resin composition of the present invention, an organic solvent or a reactive diluent can be used for viscosity adjustment.

Examples of the organic solvent include, but are not limited to, amides such as N,N-dimethylformamide, N,N-dimethylacetamide, and the like, ethers such as ethylene glycol monomethyl ether, dimethoxydiethylene glycol, ethylene glycol diethyl ether, diethylene glycol diethyl ether, triethylene glycol dimethyl ether and the like, ketones such as acetone, ethyl methyl ketone, methyl isobutyl ketone, cyclohexanone and the like, alcohols such as methanol, ethanol, 1-methoxy-2-propanol, 2-ethyl-1-hexanol, benzyl alcohol, ethylene glycol, propylene glycol, butyl diglycol, pine oil and the like, acetic acid esters such as butyl acetate, methoxybutyl acetate, methyl cellosolve acetate, cellosolve acetate, ethyl diglycol acetate, propylene glycol monomethyl ether acetate, carbitol acetate, benzyl alcohol acetate and the like, benzoic acid esters such as methyl benzoate, ethyl benzoate and the like, cellosolves such as methyl cellosolve, cellosolve, butyl cellosolve and the like, carbitols such as methyl carbitol, carbitol, butyl carbitol and the like, aromatic hydrocarbons such as benzene, toluene, xylene and the like, dimethyl sulfoxide, acetonitrile, N-methylpyrrolidone and the like.

Examples of the reactive diluents include, but are not limited to, monofunctional glycidyl ethers such as allyl glycidyl ether, butyl glycidyl ether, 2-ethylhexyl glycidyl ether, phenyl glycidyl ether, tolyl glycidyl ether and the like, difunctional glycidyl ethers such as resorcinol diglycidyl ether, neopentyl glycol diglycidyl ether, 1,4-butanediol diglycidyl ether, 1,6-hexanediol diglycidyl ether, cyclohexane dimethanol diglycidyl ether, propylene glycol diglycidyl ether and the like, polyfunctional glycidyl ethers such as glycerol polyglycidyl ether, trimethylolpropane polyglycidyl ether, trimethylolethane polyglycidyl ether, pentaerythritol polyglycidyl ether and the like, glycidyl esters such as neodecanoic acid glycidyl ester and the like, and glycidyl amines such as phenyl diglycidyl amine, tolyl diglycidyl amine and the like.

These organic solvents or reactive diluents are preferably used singly or as a mixture of a plurality of types thereof, at 90% by mass or less as a nonvolatile fraction, and the suitable type and amount to be used are appropriately selected depending on the application. For example, for printed wiring board applications, polar solvents having a boiling point of 160°C or less such as ethyl methyl ketone, acetone, 1-methoxy-2-propanol and the like are preferable, and the amount thereof to be used is preferably 40% by mass to 80% by mass in the nonvolatile fraction. For adhesive film applications, it is preferable to use, for example, ketones, acetic acid esters, carbitols, aromatic hydrocarbons, dimethylformamide, dimethylacetamide, N-methylpyrrolidone, and the like, and the amount thereof to be used is preferably 30% by mass to 60% by mass in the nonvolatile fraction.

A filler, a thermoplastic resin, a silane coupling agent, an antioxidant, a mold release agent, a defoaming agent, an emulsifying agent, a thixotropic agent, a leveling agent, a pigment and other additives can be blended, if necessary, in the curable resin composition and the epoxy resin composition of the present invention.

Examples of the filler include inorganic fillers such as fused silica, crystalline silica, alumina, silicon nitride, boron nitride, aluminum hydroxide, calcium hydroxide, magnesium hydroxide, boehmite, talc, mica, clay, calcium carbonate, magnesium carbonate, barium carbonate, zinc oxide, titanium oxide, magnesium oxide, magnesium silicate, calcium silicate, zirconium silicate, barium sulfate, carbon and the like, fibrous fillers such as carbon fibers, glass fibers, alumina fibers, silica alumina fibers, silicon carbide fibers, polyester fibers, cellulose fibers, aramid fibers, ceramic fibers, and the like, organic rubber components such as styrene-butadiene copolymer rubber, butadiene rubber, butyl rubber, butadiene-acrylonitrile copolymer rubber and the like, fine particulate rubber and the like. Among these, those which are not decomposed or dissolved by oxidizing compounds such as permanganate aqueous solution or the like used for surface roughening treatment of a cured product are preferable, and fused silica and crystalline silica are particularly preferable because fine particles are easily obtained. In addition, it is preferable to use fused silica when the blending amount of the filler is particularly increased. Although fused silica can be used either in a crushed or spherical shape, it is more preferable to use mainly spherical particles in order to suppress the increase in melt viscosity of the molding material while increasing the blending amount of fused silica. In order to further increase the blending amount of spherical silica, it is preferable to adjust, as appropriate, the particle size distribution of spherical silica. The filler may be treated with a silane coupling agent or with an organic acid such as stearic acid. Generally, the reason for using a filler is to improve the impact resistance of the cured product, and to realize low linear expansion of the cured product. When a metal hydroxide such as aluminum hydroxide, boehmite or magnesium hydroxide is used, the filler acts as an auxiliary flame retardant and has an effect of improving the flame retardancy. When the application is for a conductive paste or the like, a conductive filler such as silver powder and copper powder can be used.

The blending amount of the filler is preferably large in consideration of the low linear expansion of the cured product and the flame retardancy. The amount is preferably 1% by mass to 90% by mass, more preferably 5% by mass to 80% by mass, and still more preferably 10% by mass to 60% by mass with respect to the solid fraction (nonvolatile fraction) in the epoxy resin composition. When the blending amount is too large, the adhesion required for laminate applications may be lowered, the cured product may be brittle, and sufficient mechanical properties may not be obtained. Further, when the blending amount is small, there is a possibility that the effect of blending the filler, such as improvement of the impact resistance of the cured product, may not be obtained.

The average particle diameter of the inorganic filler is preferably 0.05 to 1.5 um, and more preferably 0.1 to 1 um. When the average particle diameter of the inorganic filler is in these ranges, satisfactory flowability of the epoxy resin composition can be maintained. The average particle diameter can be measured by a particle size distribution measuring apparatus.

Blending a thermoplastic resin is particularly effective when the epoxy resin composition is to be formed into a sheet or film. Examples of the thermoplastic resin include, but are not limited to, phenoxy resins, polyurethane resins, polyester resins, polyolefin resins (polyethylene resins, polypropylene resins and the like), polystyrene resins, acrylonitrile-butadiene-styrene copolymer (ABS resin), acrylonitrile-styrene copolymer (AS resin), vinyl chloride resins, polyvinyl acetate resins, polymethyl methacrylate resins, polycarbonate resins, polyacetal resins, cyclic polyolefin resins, polyamide resins, thermoplastic polyimide resins, polyamideimide resins, polytetrafluoroethylene resins, polyether imide resins, polyphenylene ether resins, modified polyphenylene ether resins, polyether sulfone resins, polysulfone resins, polyether ether ketone resins, polyphenylene sulfide resins, polyvinyl formal resins and the like. A phenoxy resin is preferable in terms of compatibility with the epoxy resin, and a polyphenylene ether resin or a modified polyphenylene ether resin is preferable in terms of low dielectric characteristics.

Examples of other additives include organic pigments such as quinacridone pigments, azo pigments, phthalocyanine pigments and the like, inorganic pigments such as titanium oxide, metal foil pigments, rust preventive pigments and the like, UV absorbers based on hindered amines, benzotriazoles, benzophenones and the like, antioxidants based on hindered phenols, phosphorus, sulfur, hydrazide and the like, coupling agents based on silane, titanium and the like, mold release agents such as stearic acid, palmitic acid, zinc stearate, calcium stearate and the like, leveling agents, rheology control agents, pigment dispersants, repelling inhibitor, and antifoaming agent. The blending amount of these other additives is preferably in the range of 0.01% by mass to 20% by mass with respect to the solid fraction (nonvolatile fraction) in the epoxy resin composition.

The curable resin composition and the epoxy resin composition of the present invention can be cured by the same method as the known epoxy resin compositions to obtain the cured product of the present invention. The method for obtaining a cured product can be the same as that for obtaining the known curable resin compositions, and methods such as and casting, injection, potting, dipping, drip coating, transfer molding, compression molding, and laminate formation by laminating in the form of a resin sheet, a resin-clad copper foil, a prepreg and the like and curing by heating and pressure can be advantageously used. The curing temperature at that time is usually in the range of 100°C to 300°C, and the curing time is usually on the order of 10 minutes to 5 hours.

The curable resin composition and the epoxy resin composition of the present invention can be obtained by uniformly mixing the components. The epoxy resin composition obtained by blending an epoxy resin, a curing agent, and, if necessary, various additives, can be easily made into a cured product by the same method as conventionally known methods. Examples of the cured product include molded and cured products such as laminates, cast products, molded products, adhesive layers, insulating layers, films and the like.

Examples of applications to which the curable resin composition or the epoxy resin composition of the present invention can be used include materials for circuit boards, sealing materials, casting materials, conductive pastes, adhesives and the like. Materials for circuit boards include prepregs, resin sheets, resin-clad metal foils, resin compositions for printed wiring boards and flexible wiring boards, insulating materials for circuit boards such as interlayer insulation materials for buildup boards, adhesive films for buildup, resist inks and the like. Examples of sealing materials include material for tape-shaped semiconductor chips, potting type liquid sealing, underfill, semiconductor interlayer insulating films and the like.

Among these various applications, in applications for materials for printed wiring boards, insulating materials for circuit boards and adhesive films for buildup, the compositions of the present invention can be used as insulating materials for so-called electronic component embedded substrates, in which passive components such as capacitors and active components such as IC chips are embedded in a substrate,

Among them, because of properties thereof such as high flame retardancy, high heat resistance, low dielectric characteristics and solvent solubility, the compositions are preferably used for semiconductor sealing materials and materials for circuit boards (laminated boards) such as printed wiring board materials, resin compositions for flexible wiring boards, interlayer insulating materials for buildup boards and the like.

When making an epoxy resin composition into a plate shape, such as a laminate, a fibrous material is preferable as a filler to be used due to dimensional stability and flexural strength, and glass cloth, glass mat, and glass roving cloth are more preferred.

A prepreg to be used in a printed wiring board or the like can be prepared by impregnating the curable resin composition and the epoxy resin composition of the present invention into a fibrous reinforcing base material. Examples of the fibrous reinforcing base material that can be used include, but are not limited to, woven or non-woven fabric of inorganic fibers such as glass or organic fibers such as polyester resin, polyamine resin, polyacrylic resin, polyimide resin, aromatic polyamide resin and the like.

The curable resin composition and the epoxy resin composition of the present invention were prepared and cured by curing to evaluate the cured product. As a result, the flame retardancy was better than that of the cured product obtained from a curable resin composition including the conventional organophosphorus compound. Therefore, since the phosphorus content ratio can be suppressed to a low level, the heat resistance and the water absorption are improved in a laminate having a necessary and sufficient phosphorus content ratio, thereby demonstrating usefulness for the laminate to be used under more severe conditions.

### EXAMPLES

The present invention will be specifically described hereinbelow by way of Examples and Comparative Examples, but the present invention is not limited to these as long as the gist of the invention is not exceeded. Parts represent parts by mass and % represents % by mass, unless specifically stated otherwise.

The analysis methods and measurement methods are shown below.

### (1) Phosphorus content ratio:

Sulfuric acid, hydrochloric acid and perchloric acid were added to the sample and wet-ashed by heating to convert all phosphorus elements into orthophosphoric acid. A metavanadic acid salt and a molybdic acid salt were reacted in a sulfuric acid acidic solution, the absorbance at 420 nm of the resulting phosphovanadomolybdic acid complex was measured, and the phosphorus content ratio determined by the calibration curve prepared in advance was expressed in % by mass. The phosphorus content ratio of the curable resin composition and the epoxy resin composition (laminate) was represented as the amount relative to the resin component in the laminate. Here, the resin component in the laminate refers to a component corresponding to an organic component (an epoxy resin, a curing agent, an organophosphorus compound, and the like), excluding the solvent, among the components blended in the resin composition.

### (2) Epoxy equivalent:

The measurement was performed in accordance with the JIS K 7236 standard. The unit is g/eq.

### (3) Softening point:

The softening point was measured in accordance with the ring and ball method of the JIS K 7234. Specifically, an automatic softening point apparatus (ASP-MG4 manufactured by Meitec Corporation) was used.

### (4) Glass transition temperature (Tg):

The glass transition temperature was represented by the temperature of DSC·Tgm (the middle temperature of the variation curve with respect to the tangent to a glass state and a rubber state) when measured under a temperature rising condition of 20°C/min with a differential scanning calorimeter (EXSTA16000 DSC6200, manufactured by Hitachi High-Tech Science Corporation) according to the IPC-TM-650 2.4.25.c.

### (5) Copper foil peel strength and interlayer adhesive strength:

The measurement was performed under a 25°C atmosphere according to JIS C 6481, 5.7. The interlayer adhesive strength was measured between the seventh and eighth layers.

### (6) Relative dielectric constant and dielectric loss tangent:

The evaluation was performed by using a material analyzer (manufactured by AGILENT Technologies) according to IPC-TM-650 2.5.5.9 and determining the dielectric constant and dielectric loss tangent at a frequency of 1 GHz by a capacitance method.

### (7) Flame retardancy:

The evaluation was performed by a vertical method according to the UL94 standard. The evaluation was represented by V-0, V-1, and V-2. When the testpiece was in the form of a film, the representation was VTM-0, VTM-1, or VTM-2. However, a completely burned testpiece was represented by x.

### (8) GPC (gel permeation chromatography) measurement:

Columns (TSKgel G4000H_{XL}, TSKgel G3000H_{XL}, TSKgel G2000H_{XL}, manufactured by Tosoh Corporation) were provided in series at a main body (HLC-8220GPC, manufactured by Tosoh Corporation) and a column temperature was set to 40°C. In addition, tetrahydrofuran (THF) was used as an eluent, a flow rate was set to 1 mL/min, and a differential refractive index detector was used. A total of 0.1 g of a sample was dissolved in 10 mL of THF and filtered with a microfilter, and 50 µL of the resulting measurement sample was used. GPC-8020 model II version 6.00 manufactured by Tosoh Corp was used for data processing.

### (9) FT-IR:

The transmittance and absorbance at a wave number of 400 to 4000 cm⁻¹ were measured by a total reflection measurement method (ATR method) with a Fourier transform infrared spectrophotometer (Spectrum One FT-IR Spectrometer 1760X, manufactured by Perkin Elmer Precisely).

### (10) NMR:

¹H liquid measurement was performed at room temperature with THF-d8 as a solvent by using a Fourier transform nuclear magnetic resonance apparatus (JNM-ECA400 manufactured by JEOL Ltd.).

### (11) HPLC:

A column (Ascentis C18, 4.6 mm φ × 250 mm L, manufactured by Sigma-Aldrich Co. LLC) was used at a main body (Agilent-HP1100, manufactured by Agilent Technologies), and the column temperature was set to 40°C. A 10 mM ammonium acetate aqueous solution/acetonitrile/THF = 55/22.5/22.5 (volume ratio) was used as an eluent and the flow rate was set to 1 mL/min. A UV detector (detection wavelength: 280 nm) was used. A total of 0.4 g of the sample was dissolved in 10 mL of a 10 mM aqueous ammonium acetate solution, and 5 µL was injected for measurement.

The abbreviations used in Examples and Comparative Examples are presented hereinbelow.
DOPO: 9,10-dihydro-9-oxa-10-phosphaphenanthrene-10-oxide (active hydrogen equivalent: 216, phosphorus content ratio 14.3%)
DPPO: diphenyl phosphine oxide (active hydrogen equivalent 202, phosphorus content ratio 15.3%)
DOPO-NQ: 10-(2,7-dihydroxynaphthyl)-10H-9-oxa-10-phosphaphenanthrene-10-oxide (manufactured by Sanko Chemical Co., Ltd., product name: HCA-NQ, hydroxy equivalent: 187, phosphorus content ratio 8.2%)
PX-200: aromatic condensed phosphoric acid ester (manufactured by Daihachi Chemical Industry Co., Ltd., product name: PX-200, phosphorus content ratio 9%)

### [Epoxy resins]

PN-E: phenol novolak type epoxy resin (manufactured by Nippon Steel & Sumikin Chemical Co., Ltd., product name: Epotohto YDPN-638, epoxy equivalent 176)
DCPD-E: dicyclopentadiene/phenol co-condensed epoxy resin (manufactured by Kukdo Chemical Co., Ltd., product name: KDCP-130, epoxy equivalent 254)
BPA-E: bisphenol A type solid epoxy resin (manufactured by Nippon Steel & Sumikin Chemical Co., Ltd., product name: Epotohto YD-903, epoxy equivalent 812)
OCN-E: ortho-cresol novolak type epoxy resin (manufactured by Nippon Steel & Sumikin Chemical Co., Ltd., product name: Epotohto YDCN-700-7, epoxy equivalent 202)
YDPN-638: phenol novolak type epoxy resin (manufactured by Nippon Steel & Sumikin Chemical Co., Ltd., Epotohto YDPN-638, epoxy equivalent 176)
YDF-170: bisphenol F type liquid epoxy resin (manufactured by Nippon Steel & Sumikin Chemical Co., Ltd., Epotohto YDF-170, epoxy equivalent 167)
ESN-485: naphthol aralkyl type epoxy resin (manufactured by Nippon Steel & Sumikin Chemical Co., Ltd., Epotohto EN-485, epoxy equivalent 296)
YDG-414: tetrafunctional epoxy resin (manufactured by Nippon Steel & Sumikin Chemical Co., Ltd., Epotohto YDG-414, epoxy equivalent: 187)

### [Curing agents]

PN: phenol novolak resin (manufactured by Showa Denko K.K., product name: Shonol BRG-557, softening point 80°C, phenolic hydroxy group equivalent 105)
DICY: dicyandiamide (manufactured by Nippon Carbide Industries Co., Ltd., product name: DIHARD, active hydrogen equivalent 21)
DCPD-P: dicyclopentadiene/phenol co-condensation resin (manufactured by Gun-ei Chemical Industry Co., Ltd., GDP 9140, phenolic hydroxy equivalent 196)
GK-5855P: aromatic modified novolak resin (manufactured by Nippon Steel & Sumikin Chemical Co., Ltd., GK-5855P, phenolic hydroxy equivalent 230)
MTHPA: 3 or 4-methyl-1,2,3,6-tetrahydrophthalic anhydride (manufactured by Hitachi Chemical Co., Ltd., HN-2200, acid anhydride equivalent 166)

### [Curing accelerator]

2E4MZ: 2-ethyl-4-methylimidazole (manufactured by Shikoku Kasei Kogyo Corporation, product name: Curezol 2E4MZ)

### [Catalysts]

TPP: triphenylphosphine (reagent)
TDMPP: tris(2,6-dimethoxyphenyl)phosphine (reagent)

### [Others]

YP-50S: bisphenol A type phenoxy resin (manufactured by Nippon Steel & Sumikin Chemical Co., Ltd., product name: Phenotohto YP-50S, weight average molecular weight = 40,000)
BMB: alumina monohydrate (manufactured by Kawai Lime Industry Co., Ltd., product name: BMB, average particle diameter 1.5 um)
CMC12: crystalline silica (manufactured by Tatsumori Co., Ltd., Crystallite CMC-12, average particle diameter 5 µm)
BPA: Bisphenol A

### Example 1

A total of 200 parts of propylene glycol monomethyl ether acetate (PMA), 108 parts of DOPO, and 4.2 parts of water (water/DOPO molar ratio = 0.47) were charged under room temperature in a reactor equipped with a stirrer, a thermometer, a nitrogen gas introducing device, a cooling pipe and a water separator, and completely dissolved by raising the temperature to 70°C under a nitrogen atmosphere. Thereto, 78.9 parts of NQ (NQ/DOPO molar ratio = 0.999) was charged over 30 minutes. After completion of the charging, the temperature was raised to 145°C at which reflux was started, and the reaction was continued for 5 h while maintaining the reflux temperature.

The product obtained was cooled to room temperature and filtered off by suction filtration. A total of 2500 parts of benzyl acetate was added to the filter cake, and heating was performed for complete dissolution. The solution was thereafter cooled to room temperature and allowed to stand for 1 day. The formed precipitate was separated by suction filtration. The filtrate was poured into 39% water-containing methanol, and the formed precipitate was separated by suction filtration to obtain a phosphorus-containing phenolic compound (PC1) (purity of 99% or more) as a filter cake. Fig. 1 shows a GPC chart of the PC1, Fig. 2 shows an FT-IR chart, and Fig. 3 shows an NMR chart.

According to Figs. 1 to 3, the obtained PC1 is represented by the formula (1'-1).

### Example 2 (not according to the invention)

A total of 108 parts of DOPO, 53 parts of BQ (BQ/DOPO molar ratio = 0.98), 1.8 parts of water (water/DOPO molar ratio = 0.20), and 200 parts of PMA were charged under room temperature in the same reactor as in Example 1, the temperature was raised to 145°C at which reflux was started, and the reaction was continued for 3 h while maintaining the reflux state.

The product obtained was cooled to room temperature and filtered off by suction filtration. A total of 2500 parts of benzyl acetate was added to the filter cake, and heating was performed for complete dissolution. The solution was thereafter cooled to room temperature and allowed to stand for 1 day. The formed precipitate was separated by suction filtration. The filtrate was poured into 39% water-containing methanol, and the formed precipitate was separated by suction filtration to obtain a phosphorus-containing phenolic compound (PC2) as a filter cake. PC2 is represented by the formula (1'-2) .

### Example 3

A total of 101 parts of DOPO, 78 parts of NQ (NQ/DOPO molar ratio = 0.99), 2.7 parts of water (water/DPPO molar ratio = 0.30), and 200 parts of PMA were charged under room temperature in the same reactor as in Example 1, the temperature was raised to 145°C at which reflux was started, and the reaction was continued for 3 hours while maintaining the reflux state.

The product obtained was cooled to room temperature and filtered off by suction filtration. A total of 2500 parts of benzyl acetate was added to the filter cake, and heating was performed for complete dissolution. The solution was thereafter cooled to room temperature and allowed to stand for 1 day. The formed precipitate was separated by suction filtration. The filtrate was poured into 39% water-containing methanol, and the formed precipitate was separated by suction filtration to obtain a phosphorus-containing phenolic compound (PC3) as a filter cake. PC3 is represented by the formula (1'-3) .

### Example 4

A total of 25 parts of the organophosphorus compound 1 obtained in Example 1 as a flame retardant, 100 parts of PN-E as an epoxy resin, 6.0 parts of DICY as a curing agent, and 0.1 parts of 2E4MZ as a curing accelerator were blended and then dissolved in a mixed solvent prepared with ethyl methyl ketone (MEK), propylene glycol monomethyl ether (PGM), and N,N-dimethylformamide (DMF) to obtain an epoxy resin varnish having a nonvolatile fraction of 50%.

The obtained resin varnish was impregnated into glass cloth (WEA 2116, manufactured by Nitto Boseki Co., Ltd., thickness 0.1 mm). The impregnated glass cloth was dried in a hot air circulating oven at 150°C for 10 minutes to obtain a prepreg. A total of 8 pieces of the obtained prepreg and a copper foil (3EC-III, manufactured by Mitsui Mining & Smelting Co., Ltd., thickness 35 µm) placed on top and bottom thereof were stacked and vacuum pressed under a vacuum degree of 0.5 kPa, a press pressure of 2 MPa, and a temperature conditions of 130°C × 15 min + 170°C × 70 min to obtain a laminate having a thickness of 1 mm. The copper foil portions of the obtained laminate were removed by immersion in an etching solution, followed by washing, drying and then cutting to a size of 127 mm × 12.7 mm to obtain a testpiece for flame retardancy measurement. The results of the copper foil peel strength, interlayer adhesive strength, glass transition temperature (Tg) and flame retardancy of the laminate are shown in Table 1.

### Examples 5 to 6 and Comparative Examples 1 to 2

Resin varnishes were obtained using the blending ratios (parts) described in Table 1 and the same device and the same conditions as in Example 4, and then laminates and testpieces for flame retardancy measurement were obtained. The same tests as in Example 4 were conducted, and the results are shown in Table 1. PC1 to PC3 are phosphorus-containing phenolic compounds represented by the formula (1).

**[Table 1]**

| | Example 4 | Example 5* | Example 6 | Comparative Example 1 | Comparative Example 2 |
|---|---|---|---|---|---|
| PC1 | 25 | | | | |
| PC2 | | 23 | | | |
| PC3 | | | 24 | | |
| DOPO-NQ | | | | 32 | |
| PX-200 | | | | | 31 |
| PN-E | 100 | 100 | 100 | 100 | 100 |
| DICY | 6.0 | 6.0 | 6.0 | 6.0 | 6.0 |
| 2E4MZ | 0.1 | 0.1 | 0.1 | 0.1 | 0.1 |
| Tg (°C) | 178 | 171 | 181 | 153 | 183 |
| Copper foil peel strength (kN/m) | 1.3 | 1.3 | 1.3 | 1.5 | 1.3 |
| Interlayer adhesive strength (kN/m) | 1.0 | 1.0 | 1.0 | 1.2 | 0.9 |
| Flame retardancy | V-0 | V-0 | V-0 | V-0 | V-2 |

| | | | | | |
|---|---|---|---|---|---|
| * not according to the invention | | | | | |

### Examples 7 to 9 and Comparative Examples 3 to 5

Resin varnishes were obtained using the blending ratios (parts) described in Table 2 and the same device and the same conditions as in Example 4, and then laminates and testpieces for flame retardancy measurement were obtained. The same tests as in Example 4 were conducted, and the results are shown in Table 2. Further, "(A)/(B)" in the table represents the equivalent ratio (molar ratio) of the functional groups of the epoxy resin (A) and the curing agent (B). "*" represents unmeasured.

**[Table 2]**

| | Example 7 | Comparative Example 3 | Example 8 | Comparative Example 4 | Example 9 | Comparative Example 5 |
|---|---|---|---|---|---|---|
| PC1 | 44.6 | | 32 | | 31.7 | |
| PX-200 | | 60.5 | | 40.5 | | 40 |
| PN-E | 100 | 100 | | | | |
| DCPD-E | | | 100 | 100 | | |
| BPA-E | | | | | 30 | 30 |
| OCN-E | | | | | 70 | 70 |
| PN | | | 29.9 | 41.3 | 28.9 | 34.6 |
| DCPD-P | 81.6 | 111.4 | | | | |
| 2E4MZ | 0.1 | 0.1 | 0.1 | 0.1 | 0.1 | 0.1 |
| (A) / (B) | 1/1 | 1/1 | 1/1 | 1/1 | 1/1 | 1/1 |
| Tg (°C) | 153 | 159 | 155 | 165 | 153 | 149 |
| Copper foil peel strength (kN/m) | 1.5 | 1.4 | 1.5 | 1.3 | 2.1 | 1.7 |
| Interlayer adhesive strength (kN/m) | 1.3 | 1.1 | 1.3 | 1.0 | 1.8 | 1.4 |
| Relative dielectric constant | 4.3 | 4.3 | 4.4 | 4.4 | * | * |
| Dielectric loss tangent | 0.014 | 0.014 | 0.015 | 0.015 | * | * |
| Flame retardancy | V-0 | V-2 | V-0 | V-2 | V-0 | V-2 |

### Example 10

A total of 48 parts of PC1 obtained in Example 1 as a flame retardant, 97 parts of PN-E as an epoxy resin, 5 parts of DICY as a curing agent, 0.2 parts of 2E4MZ as a curing accelerator, and 100 parts of YP-50S and 50 parts of BMB as other components were blended and then dissolved in a mixed solvent prepared with MEK, PGM, and DMF to obtain an epoxy resin varnish having a nonvolatile fraction of 50%.

The obtained resin varnish was applied onto a separator film (polyimide film) using a roll coater, and dried in an oven at 130°C for 10 minutes to obtain a resin film having a thickness of 60 um. The resin film was peeled off from the separator film, and the resin film was further cured in an oven at 200°C for 120 minutes to obtain a cured film. The cured film was cut into a size of 200 mm × 50 mm to obtain a testpiece for flame retardancy measurement. The Tg and the flame retardancy results of the cured film are shown in Table 3.

### Example 11 and Comparative Examples 6 to 7

Resin varnishes were obtained using the blending ratios (parts) described in Table 3 and the same device and the same conditions as in Example 10, and then cured films and testpieces for flame retardancy measurement were obtained. The same tests as in Example 10 were conducted, and the results are shown in Table 3.

**[Table 3]**

| | Example 10 | Example 11 | Comparative Example 6 | Comparative Example 7 |
|---|---|---|---|---|
| PC1 | 52 | 21 | | |
| DOPO-NQ | | 46 | 80 | |
| PX-200 | | | | 52 |
| PN-E | 114 | 138 | 157 | 83 |
| YP-50S | 100 | 100 | 100 | 100 |
| DICY | 5.0 | 5.0 | 5.0 | 5.0 |
| 2E4MZ | 0.2 | 0.2 | 0.4 | 0.2 |
| BMB | 40 | 40 | 40 | 40 |
| Tg (°C) | 150 | 143 | 135 | 140 |
| Flame retardancy | VTM-0 | VTM-0 | VTM-1 | VTM-2 |

Examples 10 to 11 (Comparative Examples 6 to 7) are examples in which a cured film was formed. Even in this case, the flame retardancy and heat resistance were improved. Further, the blending amount of the epoxy resin (PN-E) was set by taking the same blending amount relative to the curing agent (DICY) and adding the epoxy resin in an amount corresponding to the equivalent number of moles with respect to the functional groups of the flame retardant agent.

### Synthesis Example 1

A total of 200 parts of PMA, 108 parts of DOPO and 4.2 parts of water (water/DOPO molar ratio = 0.23) were charged in a reactor equipped with a stirrer, a thermometer, a nitrogen gas introducing device, and a cooling pipe, and completely dissolved by raising the temperature to 70°C under a nitrogen atmosphere. Thereto, 78.9 parts of NQ (NQ/DOPO molar ratio = 0.999) was charged over 30 minutes. After completion of the charging, the temperature was raised to 145°C at which reflux was started, and the reaction was continued for 2 hours while maintaining the reflux temperature. After completion of the reaction, the reaction product was cooled to 25°C and suction filtered to obtain a reaction product as a filter cake. A total of 150 parts of the reaction product and 750 parts of PMA were charged, heated and mixed, cooled to 25°C, and suction filtered to obtain a reaction product as a filter cake. This operation was repeated twice to obtain a phosphorus compound (p0) .

The HPLC chart of the obtained phosphorus compound is shown in Fig. 6. In Fig. 6, the component corresponding to the phosphorus-containing phenolic compound (1) in (p0) is a peak group (a), the remaining raw material phosphorus compound (2): DOPO is a peak (c), the by-produced phosphorus-containing phenolic compound (3): DOPO-NQ is a peak (b), and the by-produced phosphorus compound (4) is a peak (d). The phosphorus-containing phenolic compound (1) is represented by the formula (1'-1), DOPO-NQ is represented by the formula (2-3), and the phosphorus compound (4) is represented by the formula (2-4).

### Synthesis Example 2

A total of 15 parts of the phosphorus compound (p0) obtained in Synthesis Example 1 and 200 parts of benzyl acetate were charged and completely dissolved by raising the temperature to 200°C under a nitrogen atmosphere. The solution was cooled to room temperature and allowed to stand for 1 day. The formed precipitate was separated by suction filtration. The filtrate was poured into 39% water-containing methanol, the precipitate formed was separated by suction filtration, and a phosphorus-containing phenolic compound (P1) was isolated as a filter cake. P1 corresponds to the phosphorus-containing phenolic compound (1).

### Synthesis Example 3

A total of 15 parts of the precipitate (1) obtained in Synthesis Example 2 and 200 parts of benzyl acetate were charged and completely dissolved by raising the temperature to 200°C under a nitrogen atmosphere. The solution was cooled to room temperature, allowed to stand for 1 day, and recrystallized to isolate a phosphorus-containing phenolic compound (P3). P3 corresponds to the DOPO-NQ.

### Synthesis Example 4

The phosphorus compound (p0) obtained in Synthesis Example 1 was fractionated by HPLC to isolate the by-produced phosphorus compound (P4). (P4) corresponds to the phosphorus compound (4).

### Example 21

A total of 805 parts of YDPN-638, 100 parts of YDF-170, 95 parts of (p1) and 0.1 parts of TPP were charged in the same device as in Synthesis Example 1, the temperature was raised to 150°C under a nitrogen atmosphere, and the reaction was continued for 3 hours while maintaining the reaction temperature of 150°C to 155°C to obtain a phosphorus-containing epoxy resin (Resin 1). The epoxy equivalent and phosphorus content ratio of the obtained phosphorus-containing epoxy resin were measured. The measurement results are shown in Table 4.

### Example 22

A total of 835 parts of YDPN-638, 95 parts of (p1), 70 parts of DOPO, and 0.1 parts of TPP were charged in the same device as in Synthesis Example 21, the temperature was raised to 150°C under a nitrogen atmosphere, and the reaction was continued for 3 hours while maintaining the reaction temperature of 150°C to 155°C to obtain a phosphorus-containing epoxy resin (Resin 2).

### Example 23

A total of 835 parts of ESN-485, 95 parts of (p1), 70 parts of DOPO, and 0.1 parts of TPP were charged in the same device as in Synthesis Example 21, the temperature was raised to 150°C under a nitrogen atmosphere, and the reaction was continued for 3 hours while maintaining the reaction temperature of 150°C to 155°C to obtain a phosphorus-containing epoxy resin (Resin 3).

### Example 24

A total of 835 parts of YDG-414, 95 parts of (p1), 70 parts of DOPO, and 0.1 parts of TPP were charged in the same device as in Synthesis Example 21, the temperature was raised to 150°C under a nitrogen atmosphere, and the reaction was continued for 3 hours while maintaining the reaction temperature of 150°C to 155°C to obtain a phosphorus-containing epoxy resin (Resin 4).

### Example 25

A total of 762 parts of YDF-170, 238 parts of (p1), and 0.3 parts of TPP were charged in the same device as in Synthesis Example 21, the temperature was raised to 150°C under a nitrogen atmosphere, and the reaction was continued for 3 hours while maintaining the reaction temperature of 150°C to 155°C to obtain a phosphorus-containing epoxy resin (Resin 5).

### Example 26

A total of 714 parts of YDF-170, 286 parts of (p1), and 0.5 parts of TPP were charged in the same device as in Synthesis Example 21, the temperature was raised to 150°C under a nitrogen atmosphere, and the reaction was continued for 3 hours while maintaining the reaction temperature of 150°C to 155°C to obtain a phosphorus-containing epoxy resin (Resin 6).

### Example 27

A total of 639 parts of YDF-170, 3 parts of (p1), 358 parts of DOPO-NQ and 0.5 parts of TDMPP were charged in the same device as in Synthesis Example 21, the temperature was raised to 150°C under a nitrogen atmosphere, and the reaction was continued for 3 hours while maintaining the reaction temperature of 150°C to 155°C to obtain a phosphorus-containing epoxy resin (Resin 7).

### Example 28

A total of 690 parts of YDPN-638, 10 parts of (p1), 200 parts of DOPO, 100 parts of BPA, and 0.4 parts of TPP were charged in the same device as in Synthesis Example 21, the temperature was raised to 150°C under a nitrogen atmosphere, and the reaction was continued for 3 hours while maintaining the reaction temperature of 150°C to 155°C to obtain a phosphorus-containing epoxy resin (Resin 8).

### Example 29

A total of 690 parts of YDPN-638, 100 parts of YDF-170, 0.5 parts of (p1), 209.5 parts of DOPO, and 0.4 parts of TPP were charged in the same device as in Synthesis Example 21, the temperature was raised to 150°C under a nitrogen atmosphere, and the reaction was continued for 3 hours while maintaining the reaction temperature of 150°C to 155°C to obtain a phosphorus-containing epoxy resin (Resin 9).

### Example 30

A total of 238 parts of YDPN-638, 190 parts of YDF-170, 310 parts of (p1), 262 parts of DOPO, and 0.5 parts of TPP were charged in the same device as in Synthesis Example 21, the temperature was raised to 150°C under a nitrogen atmosphere, and the reaction was continued for 3 hours while maintaining the reaction temperature of 150°C to 155°C to obtain a phosphorus-containing epoxy resin (Resin 10).

### Example 31

A total of 175 parts of DOPO, 90 parts of NQ (NQ/DOPO molar ratio = 0.70), 4.7 parts of water (water/DOPO molar ratio = 0.33), and 409 parts of PMA were charged in the same device as in Synthesis Example 1, the temperature was raised to 145°C at which reflux was started under a nitrogen atmosphere, and the reaction was continued for 2 hours while maintaining the reflux state. As a result of collecting the contents and measuring by HPLC, the amount of (p1) was 35 parts.

Next, 515 parts of YDPN-638 and 220 parts of YDF-170 were charged into the contents, PMA was removed by distillation under reduced pressure, 0.5 parts of TDMPP was charged, and the reaction was continued for 3 hours while maintaining the reaction temperature of 160°C to 165°C to obtain a phosphorus-containing epoxy resin (Resin 11).

The GPC measurement chart is shown in Fig. 4. The signal strength is shown on the ordinate. The FT-IR measurement chart is shown in Fig. 5. The ordinate shows the transmittance.

### Example 32

A total of 210 parts of DOPO, 38 parts of NQ (NQ/DOPO molar ratio = 0.25), 2.0 parts of water (water/DOPO molar ratio = 0.11), and 490 parts of xylene were charged in the same device as in Synthesis Example 1, the temperature was raised to 142°C at which reflux was started under a nitrogen atmosphere, and the reaction was continued for 2 hours while maintaining the reflux state. As a result of collecting the contents and measuring by HPLC, the amount of (p1) was 5 parts.

Next, 752 parts of YDPN-638 was charged into the contents, xylene was removed by distillation under reduced pressure, 0.5 parts of TPP was charged, and the reaction was continued for 3 hours while maintaining the reaction temperature of 155°C to 165°C to obtain a phosphorus-containing epoxy resin (Resin 12).

### Example 33

A total of 62 parts of DOPO, 38 parts of NQ (NQ/DOPO molar ratio = 0.84), 2.0 parts of water (water/DOPO molar ratio = 0.39), and 490 parts of toluene were charged in the same device as in Synthesis Example 1, the temperature was raised to 109°C at which reflux was started under a nitrogen atmosphere, and the reaction was continued for 3 hours while maintaining the reflux state. Then, 148 parts of DOPO was added followed by uniform stirring. As a result of collecting the contents and measuring by HPLC, the amount of (p1) was 17 parts.

Next, 752 parts of YDPN-638 was charged into the contents, toluene was removed by distillation under reduced pressure, 0.5 parts of TPP was charged, and the reaction was continued for 3 hours while maintaining the reaction temperature of 155°C to 165°C to obtain a phosphorus-containing epoxy resin (Resin 13).

### Comparative Example 11

A total of 780 parts of YDPN-638, 100 parts of YDF-170, 120 parts of DOPO-NQ, and 0.1 parts of TPP were charged in the same device as in Synthesis Example 21, the temperature was raised to 150°C under a nitrogen atmosphere, and the reaction was continued for 3 hours while maintaining a reaction temperature of 150°C to 155°C to obtain a phosphorus-containing epoxy resin (Resin H1).

### Comparative Example 12

A total of 830 parts of YDPN-638, 100 parts of YDF-170, 70 parts of DOPO, and 0.1 parts of TPP were charged in the same device as in Synthesis Example 21, the temperature was raised to 150°C under a nitrogen atmosphere, and the reaction was continued for 3 hours while maintaining a reaction temperature of 150°C to 155°C to obtain a phosphorus-containing epoxy resin (Resin H2).

### Comparative Example 13

A total of 780 parts of YDPN-638, 100 parts of YDF-170, 120 parts of (p4), and 0.1 parts of TPP were charged in the same device as in Synthesis Example 21, the temperature was raised to 150°C under a nitrogen atmosphere, and the reaction was continued for 3 hours while maintaining a reaction temperature of 150°C to 155°C to obtain a phosphorus-containing epoxy resin (Resin H3).

### Comparative Example 14

A total of 860 parts of YDPN-638, 140 parts of DOPO, and 0.1 parts of TPP were charged in the same device as in Synthesis Example 21, the temperature was raised to 150°C under a nitrogen atmosphere, and the reaction was continued for 3 hours while maintaining a reaction temperature of 150°C to 155°C to obtain a phosphorus-containing epoxy resin (Resin H4).

### Comparative Example 15

A total of 639 parts of YDF-170, 361 parts of DOPO-NQ, and 0.3 parts of TPP were charged in the same device as in Synthesis Example 21, the temperature was raised to 150°C under a nitrogen atmosphere, and the reaction was continued for 3 hours while maintaining a reaction temperature of 150°C to 155°C to obtain a phosphorus-containing epoxy resin (Resin H5).

### Comparative Example 16

A total of 690 parts of YDPN-638, 210 parts of DOPO, 100 parts of BPA, and 0.5 parts of TDMPP were charged in the same device as in Synthesis Example 21, the temperature was raised to 150°C under a nitrogen atmosphere, and the reaction was continued for 3 hours while maintaining a reaction temperature of 150°C to 155°C to obtain a phosphorus-containing epoxy resin (Resin H6).

### Comparative Example 17

A total of 690 parts of YDPN-638, 100 parts of YDF-170, 210 parts of DOPO, and 0.4 parts of TPP were charged in the same device as in Synthesis Example 21, the temperature was raised to 150°C under a nitrogen atmosphere, and the reaction was continued for 3 hours while maintaining a reaction temperature of 150°C to 155°C to obtain a phosphorus-containing epoxy resin (Resin H7).

### Comparative Example 18

A total of 471 parts of YDPN-638, 529 parts of DOPO, and 0.5 parts of TPP were charged in the same device as in Synthesis Example 21, the temperature was raised to 150°C under a nitrogen atmosphere, and the reaction was continued for 3 hours while maintaining a reaction temperature of 150°C to 155°C to obtain a phosphorus-containing epoxy resin (Resin H8).

### Comparative Example 19

A total of 210 parts of DOPO, 38 parts of NQ (NQ/DOPO molar ratio = 0.25), 2.0 parts of water (water/DOPO molar ratio = 0.11), and 490 parts of toluene were charged in the same device as in Synthesis Example 1, the temperature was raised to 80°C under a nitrogen atmosphere, and the reaction was continued for 4 hours while maintaining 80°C. As a result of collecting the contents and measuring by HPLC, (p1) could not be detected.

Next, 752 parts of YDPN-638 was charged into the contents, toluene was removed by distillation under reduced pressure, 0.5 parts of TPP was charged, and the reaction was continued for 3 hours while maintaining the reaction temperature of 155°C to 160°C to obtain a phosphorus-containing epoxy resin (Resin H9).

The same tests as in Example 21 were conducted on the Resins 2 to 13 and the Resins H1 to H9 obtained in Examples 21 to 33 and Comparative Examples 11 to 19.

Table 4 shows the measurement results of the epoxy equivalents and the phosphorus content ratios of the Resins 1 to 13 and H1 to H9 obtained in the Examples and Comparative Examples. The b1 content ratio in the table is the content ratio (%) of the structural segment represented by formula (1'-1b) in the phosphorus-containing epoxy resin, and this content ratio was determined by calculation from the charged amount of the phosphorus-containing phenolic compound (1), the measurement results of HPLC, and the residual amount of phosphorus-containing phenolic compound (1).

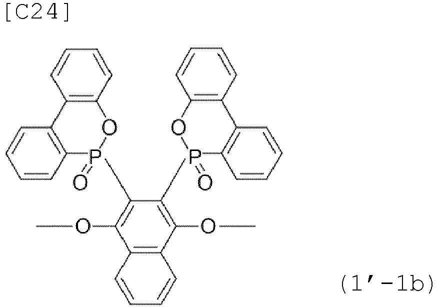

**[Table 4]**

| Resin | Epoxy equivalent (g/eq.) | Phosphorus content ratio (%) | b1 content ratio (%) |
|---|---|---|---|
| 1 | 208 | 1.0 | 9.0 |
| 2 | 245 | 2.0 | 9.0 |
| 3 | 460 | 2.0 | 9.0 |
| 4 | 261 | 2.0 | 9.0 |
| 5 | 267 | 2.5 | 23 |
| 9 | 305 | 3.0 | 27 |
| 6 | 530 | 3.0 | 0.28 |
| 7 | 480 | 3.0 | 0.9 |
| 8 | 285 | 3.0 | 0.05 |
| 10 | 4450 | 7.0 | 29 |
| 11 | 346 | 2.5 | 3.5 |
| 12 | 325 | 3.0 | 0.5 |
| 13 | 324 | 3.0 | 1.7 |
| H1 | 230 | 1.0 | 0 |
| H2 | 202 | 1.0 | 0 |
| H3 | 214 | 1.0 | 0 |
| H4 | 237 | 2.0 | 0 |
| H5 | 530 | 3.0 | 0 |
| H6 | 480 | 3.0 | 0 |
| H7 | 285 | 3.0 | 0 |
| H8 | 4450 | 7.6 | 0 |
| H9 | 327 | 3.0 | 0 |

### Example 34 (not according to the invention)

A total of 210 parts of DOPO, 94 parts of BQ (BQ/DOPO molar ratio = 0.90), 3.4 parts of water (water/DOPO molar ratio = 0.19), and 490 parts of PMA were charged in the same device as in Synthesis Example 1, the temperature was raised to 145°C at which reflux was started under a nitrogen atmosphere, and the reaction was continued for 2 hours while maintaining the reflux state. As a result of collecting the contents and measuring by HPLC, the amount of the phosphorus-containing phenolic compound (1) represented by the formula (1-2) was 51 parts.

Next, 70 parts of YDPN-638 and 626 parts of YDF-170 were charged into the contents, PMA was removed by distillation under reduced pressure, 0.5 parts of TDMPP was charged, and the reaction was continued for 3 hours while maintaining the reaction temperature of 160°C to 165°C to obtain a phosphorus-containing epoxy resin (Resin 14).

### Comparative Example 20

A total of 210 parts of DOPO, 94 parts of BQ (BQ/DOPO molar ratio = 0.90), and 490 parts of PMA (no water was used) were charged in the same device as in Synthesis Example 1, the temperature was raised to 109°C at which reflux was started under a nitrogen atmosphere, and the reaction was continued for 3 hours while maintaining the reflux state. As a result of collecting the contents and measuring by HPLC, the phosphorus compound represented by the formula (1-2) could not be detected.

Next, 70 parts of YDPN-638 and 626 parts of YDF-170 were charged into the contents, toluene was removed by distillation under reduced pressure, 0.5 parts of TDMPP was charged, and the reaction was continued for 3 hours while maintaining the reaction temperature of 160°C to 165°C to obtain a phosphorus-containing epoxy resin (Resin H10).

The results of measurement of the epoxy equivalent and the phosphorus content ratio of the Resins 14 and H10 obtained in Example 34 and Comparative Example 20 are shown in Table 5. The b2 content ratio in the table is the content ratio of the structural segment represented by formula (1-2b) in the phosphorus-containing epoxy resin.

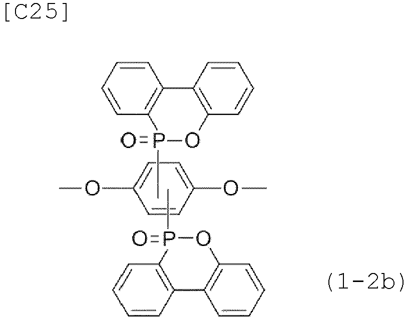

**[Table 5]**

| Resin | Epoxy equivalent (g/eq.) | Phosphorus content ratio (%) | b2 content ratio (%) |
|---|---|---|---|
| 14 | 420 | 3.0 | 5.3 |
| H10 | 433 | 3.0 | 0 |

### Example 35

A total of 196 parts of DPPO, 77 parts of NQ (NQ/DPPO molar ratio = 0.50), 4.0 parts of water (water/DPPO molar ratio = 0.23), and 450 parts of PMA were charged in the same device as in Synthesis Example 1, the temperature was raised to 145°C at which reflux was started under a nitrogen atmosphere, and the reaction was continued for 2 hours while maintaining the reflux state. As a result of collecting the contents and measuring by HPLC, the amount of the phosphorus-containing phenolic compound (1) represented by the formula (1-3) was 23 parts.

Next, 509 parts of YDPN-638 and 218 parts of YDF-170 were charged into the contents, PMA was removed by distillation under reduced pressure, 0.5 parts of TDMPP was charged, and the reaction was continued for 3 hours while maintaining the reaction temperature of 160°C to 165°C to obtain a phosphorus-containing epoxy resin (Resin 15).

### Example 36

A total of 196 parts of DPPO, 77 parts of NQ, 8.0 parts of water (water/DPPO molar ratio = 0.46), and 450 parts of toluene were charged in the same device as in Synthesis Example 1, the temperature was raised to 108°C at which reflux was started under a nitrogen atmosphere, and the reaction was continued for 3 hours while maintaining the reflux state. As a result of collecting the contents and measuring by HPLC, the amount of the phosphorus-containing phenolic compound (1) represented by the formula (1-3) was 17 parts.

Next, 509 parts of YDPN-638 and 218 parts of YDF-170 were charged into the contents, toluene was removed by distillation under reduced pressure, 0.5 parts of TDMPP was charged, and the reaction was continued for 3 hours while maintaining the reaction temperature of 160°C to 165°C to obtain a phosphorus-containing epoxy resin (Resin 16).

### Comparative Example 21

A total of 196 parts of DPPO, 23 parts of NQ (NQ/DPPO molar ratio = 0.15), 0.7 parts of water (water/DPPO molar ratio = 0.04), and 450 parts of toluene were charged in the same device as in Synthesis Example 1, the temperature was raised to 109°C at which reflux was started under a nitrogen atmosphere, and the reaction was continued for 3 hours while maintaining the reflux state. As a result of collecting the contents and measuring by HPLC, the phosphorus compound represented by the formula (1-3) could not be detected.

Next, 546 parts of YDPN-638 and 234 parts of YDF-170 were charged into the contents, toluene was removed by distillation under reduced pressure, 0.5 parts of TDMPP was charged, and the reaction was continued for 3 hours while maintaining the reaction temperature of 160°C to 165°C to obtain a phosphorus-containing epoxy resin (Resin H11).

The results of measurement of the epoxy equivalent and the phosphorus content ratio of the Resins 15, 16 and H11 obtained in Examples 35 to 36 and Comparative Example 21 are shown in Table 6. The b3 content ratio in the table is the content ratio of the structural segment represented by formula (1-3b) in the phosphorus-containing epoxy resin.

**[Table 6]**

| Resin | Epoxy equivalent (g/eq.) | Phosphorus content ratio (%) | b3 content ratio (%) |
|---|---|---|---|
| 15 | 360 | 3.0 | 2.1 |
| 16 | 360 | 3.0 | 1.6 |
| H11 | 300 | 3.0 | 0 |

Examples 31 to 36 and Comparative Examples 19 to 21 are examples in which, after synthesizing the phosphorus compound, the phosphorus compound is continuously reacted with the epoxy resin, without taking the phosphorus compound out of the reaction system, to obtain a phosphorus-containing epoxy resin. Table 7 shows the results of HPLC measurement of the phosphorus compound before charging the epoxy resin. In the table, the compound (1) indicates the phosphorus-containing phenolic compound (1) represented by the formula (1'-1), and the compound (3) indicates DOPO-NQ (3) represented by the formula (2-3). The phosphorus compound (2) indicates the starting material DOPO, and the phosphorus compound (4) indicates a by-produced phosphorus compound represented by the formula (2-4).

**[Table 7]**

| | Compound (1) | Compound (3) | Phosphorus compound (2) | Phosphorus compound (4) |
|---|---|---|---|---|
| Example 31 | 35 | 178 | 43 | 5.5 |
| Example 32 | 5 | 86 | 156 | 0 |
| Example 33 | 17 | 73 | 153 | 2.5 |
| Example 34 | 23 | 156 | 87 | 3.5 |
| Example 35 | 17 | 160 | 91 | 3.0 |
| Example 36 | 51 | 234 | 8 | 9 |
| Comparative Example 19 | 0 | 89 | 158 | 0 |
| Comparative Example 20 | 0 | 52 | 166 | 0 |
| Comparative Example 21 | 0 | 282 | 22 | 0 |

### Example 37

A total of 100 parts of the Resin 1 as a phosphorus-containing epoxy resin, 5.0 parts of DICY as a curing agent, and 0.1 parts of 2E4MZ as a curing accelerator were blended and then dissolved in a mixed solvent prepared with MEK, PGM, and DMF to obtain an epoxy resin composition varnish having a nonvolatile fraction of 50%.

The obtained epoxy resin composition varnish was impregnated into glass cloth (WEA 2116, thickness 0.1 mm). The impregnated glass cloth was dried in a hot air circulating oven at 150°C for 10 minutes to obtain a prepreg. A total of 8 pieces of the obtained prepreg and a copper foil (3EC-III, thickness 35 µm) placed on top and bottom thereof were stacked and vacuum pressed under 2 MPa and a temperature conditions of 130°C × 15 min + 170°C × 70 min to obtain a laminate having a thickness of 1 mm. The copper foil portions of the obtained laminate were removed by immersion in an etching solution, followed by washing, drying and then cutting to a size of 127 mm × 12.7 mm to obtain a testpiece for flame retardancy measurement. The results of the phosphorus content ratio of the epoxy resin composition, copper foil peel strength in the laminate, interlayer adhesive strength, glass transition temperature (Tg) and flame retardancy of the laminate are shown in Table 8.

### Comparative Examples 22 to 24

Epoxy resin composition varnishes were obtained in the same manner as in Example 37 by using the blends shown in Table 8, except that the Resins H1 to H3 obtained in Comparative Examples 11 to 13 were used as the resin, and then laminates and testpieces for flame retardancy measurement were obtained. The same test as in Example 37 was conducted, and the results are shown in Table 8. In the table, (parts) of DICY and 2E4MZ are blending amounts which are relative to 100 parts of the resin.

**[Table 8]**

| | Example 37 | Comparative Example 22 | Comparative Example 23 | Comparative Example 24 |
|---|---|---|---|---|
| Resin | 1 | H1 | H2 | H3 |
| DICY (parts) | 5.0 | 4.6 | 5.2 | 4.9 |
| 2E4MZ (parts) | 0.1 | 0.1 | 0.1 | 0.1 |
| Phosphorus content ratio (%) | 1.0 | 1.0 | 1.0 | 1.0 |
| Copper foil peel strength (kN/m) | 1.4 | 1.6 | 1.3 | 1.3 |
| Interlayer adhesive strength (kN/m) | 1.5 | 1.2 | 1.4 | 1.0 |
| Tg (°C) | 177 | 171 | 180 | 172 |
| Flame retardancy | V-1 | X | X | X |

### Examples 38 to 40 and Comparative Example 25

Epoxy resin composition varnishes were obtained in the same manner as in Example 37 by using the blends shown in Table 9, except that the Resins 2 to 4 obtained in Examples 22 to 24 and the Resin H4 obtained in Comparative Example 14 were used as the resin, and then laminates and testpieces for flame retardancy measurement were obtained. The same test as in Example 37 was conducted, and the results are shown in Table 9. In the table, (parts) of DICY and 2E4MZ have the same meaning as in Table 8.

**[Table 9]**

| | Example 38 | Example 39 | Example 40 | Comparative Example 25 |
|---|---|---|---|---|
| Resin | 2 | 3 | 4 | H4 |
| DICY (parts) | 4.3 | 2.3 | 4.0 | 4.4 |
| 2E4MZ (parts) | 0.1 | 0.1 | 0.1 | 0.1 |
| Phosphorus content ratio (%) | 1.9 | 1.9 | 1.9 | 1.9 |
| Copper foil peel strength (kN/m) | 1.2 | 1.3 | 1.4 | 1.0 |
| Interlayer adhesive strength (kN/m) | 1.2 | 1.3 | 1.2 | 0.8 |
| Tg (°C) | 165 | 174 | 184 | 163 |
| Flame retardancy | V-0 | V-0 | V-0 | V-1 |

Examples 37 to 40 (Comparative Examples 22 to 25) are examples in which the phosphorus-containing phenolic compound (1) was used alone. Example 37 (Comparative Examples 22 to 24) is for comparison with the case in which the phosphorus content ratio of the phosphorus-containing epoxy resin is 1.0%, and Examples 38 to 40 (Comparative Example 25) are for comparison with the case in which the phosphorus content ratio of the phosphorus-containing epoxy resin is 2.0%. In either case, the flame retardancy of the laminate using the phosphorus-containing epoxy resin of the present invention was improved.

### Examples 41 to 43 and Comparative Example 26

Epoxy resin composition varnishes were obtained in the same manner as in Example 37 by using the blends shown in Table 10, except that the Resins 5 to 7 obtained in Examples 25 to 27 and the Resin H5 obtained in Comparative Example 15 were used as the resin, and then laminates and testpieces for flame retardancy measurement were obtained. The same test as in Example 37 was conducted, and the results are shown in Table 10. In the table, (parts) of DICY and 2E4MZ are blending amounts which are relative to 100 parts of the resin.

**[Table 10]**

| | Example 41 | Example 42 | Example 43 | Comparative Example 26 |
|---|---|---|---|---|
| Resin | 5 | 6 | 7 | H5 |
| DICY (parts) | 3.9 | 3.4 | 2.0 | 2.0 |
| 2E4MZ (parts) | 0.3 | 0.3 | 0.3 | 0.3 |
| Phosphorus content ratio (%) | 2.4 | 2.9 | 2.9 | 2.9 |
| Copper foil peel strength (kN/m) | 1.6 | 1.7 | 1.7 | 1.7 |
| Interlayer adhesive strength (kN/m) | 2.1 | 2.2 | 2.1 | 2.2 |
| Tg (°C) | 145 | 139 | 131 | 128 |
| Flame retardancy | V-0 | V-0 | V-0 | V-0 |

Examples 41 to 43 (Comparative Example 26) relate to a system using a linear phosphorus-containing epoxy resin obtained by using the phosphorus-containing phenolic compound (1) or DOPO-NQ as a phosphorus compound and reacting with a bifunctional epoxy resin, and DICY as a curing agent. In Comparative Example 26 in which DOPO-NQ was used alone, the flame retardancy was satisfactory, but the heat resistance was insufficient. In Example 42, the phosphorus-containing phenolic compound (1) was used alone, and the heat resistance was improved. In Example 43, the phosphorus-containing phenolic compound (1) was used in combination with 3% of DOPO-NQ, but the heat resistance of the laminate was improved. In Example 41, the phosphorus-containing phenolic compound (1) was used alone and a phosphorus-containing epoxy resin having a phosphorus content reduced from 3% to 2.5% was used, but the flame retardancy and heat resistance were satisfactory.

### Examples 44 to 45 and Comparative Example 27

Epoxy resin composition varnishes were obtained in the same manner as in Example 37 by using the blends shown in Table 11, except that the Resins 6 and 7 obtained in Examples 26 and 27 and the Resin H5 obtained in Comparative Example 15 were used as the resin, and then laminates and testpieces for flame retardancy measurement were obtained. The same test as in Example 37 was conducted, and the results are shown in Table 11. In the table, (parts) of YDPN-638, PN and 2E4MZ are blending amounts which are relative to 40 parts of the resin.

**[Table 11]**

| | Example 44 | Example 45 | Comparative Example 27 |
|---|---|---|---|
| Resin | 6 | 7 | H5 |
| YDPN-638 (parts) | 60 | 60 | 60 |
| PN (parts) | 49.6 | 43.7 | 43.7 |
| 2E4MZ (parts) | 0.1 | 0.1 | 0.1 |
| Phosphorus content ratio (%) | 0.8 | 0.8 | 0.8 |
| Copper foil peel strength (kN/m) | 1.4 | 1.2 | 1.2 |
| Interlayer adhesive strength (kN/m) | 1.4 | 1.2 | 1.2 |
| Tg (°C) | 161 | 145 | 141 |
| Flame retardancy | V-0 | V-0 | V-1 |

Examples 44 and 45 (Comparative Example 27) relate to a system using a linear phosphorus-containing epoxy resin obtained by using the phosphorus-containing phenolic compound (1) or DOPO-NQ as a phosphorus compound and reacting with a bifunctional epoxy resin, and also using, in addition to the phosphorus-containing epoxy resin, a phenol novolak epoxy resin and PN as a curing agent. In this example, the blending amount of the phosphorus-containing epoxy resin is small and the phosphorus content ratio in the epoxy resin composition is low. In Comparative Example 27 in which DOPO-NQ was used alone, the heat resistance was insufficient. In Example 45, the phosphorus-containing phenolic compound (1) was used in combination with 3% of DOPO-NQ, but the flame retardancy of the laminate was satisfactory and the heat resistance was also improved. Further, Example 44 is an example in which the phosphorus-containing phenolic compound (1), rather than DOPO-NQ, was used alone, but the flame retardancy and heat resistance were satisfactory.

From the results of Table 10 and Table 11, it is understood that the phosphorus-containing phenolic compound (1) has a larger effect of improving the flame retardancy and heat resistance of a phosphorus-containing epoxy resin as compared with DOPO-NQ.

### Examples 46 to 47 and Comparative Examples 28 to 29

Epoxy resin composition varnishes were obtained in the same manner as in Example 37 by using the blends shown in Table 12, except that the Resins 8 and 9 obtained in Examples 28 and 29 and the Resins H6 and H7 obtained in Comparative Examples 16 and 17 were used as the resin, and then laminates and testpieces for flame retardancy measurement were obtained. The same test as in Example 37 was conducted, and the results are shown in Table 12. In the table, (parts) of PN and 2E4MZ are blending amounts which are relative to 100 parts of the resin.

**[Table 12]**

| | Example 46 | Comparative Example 28 | Example 47 | Comparative Example 29 |
|---|---|---|---|---|
| Resin | 8 | H6 | 9 | H7 |
| PN (parts) | 21.9 | 21.9 | 36.8 | 36.8 |
| 2E4MZ (parts) | 0.1 | 0.1 | 0.1 | 0.1 |
| Phosphorus content ratio (%) | 2.3 | 2.3 | 2.2 | 2.2 |
| Copper foil peel strength (kN/m) | 1.5 | 1.5 | 1.2 | 1.2 |
| Interlayer adhesive strength (kN/m) | 1.3 | 1.3 | 1.0 | 0.8 |
| Tg (°C) | 156 | 151 | 153 | 149 |
| Flame retardancy | V-0 | V-1 | V-0 | V-1 |

Examples 46 and 47 (Comparative Examples 28 and 29) relate to a system using a phosphorus-containing epoxy resin obtained by using the phosphorus-containing phenolic compound (1) or DOPO as a phosphorus compound and reacting with a phenol novolak type epoxy resin, and PN as a curing agent. In the Examples, a small amount of the phosphorus-containing phenolic compound (1) was used in combination with DOPO. Although a small amount of the phosphorus-containing phenolic compound (1) was used in combination, the flame retardancy and heat resistance of the laminate using the obtained phosphorus-containing epoxy resin were improved.

### Examples 48 to 51 and Comparative Examples 30 and 31

Epoxy resin composition varnishes were obtained in the same manner as in Example 37 by using the blends shown in Table 13, except that the Resins 11 to 14 obtained in Examples 31 to 34 and the Resins H9 and H10 obtained in Comparative Examples 19 and 20 were used as the resin, and then laminates and testpieces for flame retardancy measurement were obtained. The same test as in Example 37 was conducted, and the results are shown in Table 13. In the table, (parts) of KDCP130, PN and 2E4MZ are blending amounts which are relative to 100 parts of the resin.

**[Table 13]**

| | Example 48 | Example 49 | Example 50 | Comparative Example 30 | Example 51 | Comparative Example 31 |
|---|---|---|---|---|---|---|
| Resin | 11 | 12 | 13 | H9 | 14 | H10 |
| KDCP130 (parts) | 50 | 50 | 50 | 50 | 50 | 50 |
| PN (parts) | 51 | 53 | 53 | 53 | 46 | 45 |
| 2E4MZ (parts) | 0.1 | 0.1 | 0.1 | 0.1 | 0.1 | 0.1 |
| Phosphorus content ratio (%) | 1.2 | 1.5 | 1.5 | 1.5 | 1.5 | 1.5 |
| Copper foil peel strength (kN/m) | 1.5 | 1.2 | 1.3 | 1.1 | 1.3 | 1.1 |
| Interlayer adhesive strength (kN/m) | 1.3 | 1.1 | 1.2 | 0.9 | 1.2 | 0.9 |
| Tg (°C) | 165 | 153 | 161 | 146 | 161 | 146 |
| Flame retardancy | V-0 | V-0 | V-0 | V-1 | V-0 | V-1 |
| Relative dielectric constant | 4.4 | 4.4 | 4.4 | 4.4 | 4.3 | 4.3 |
| Dielectric loss tangent | 0.015 | 0.015 | 0.015 | 0.015 | 0.015 | 0.015 |

### Examples 52 to 54 and Comparative Examples 32 to 34

Epoxy resin composition varnishes were obtained in the same manner as in Example 37 by using the blends shown in Table 14, except that the Resins 15 and 16 obtained in Examples 35 and 36 and the Resin H11 obtained in Comparative Example 21 were used as the resin, and then laminates and testpieces for flame retardancy measurement were obtained. The same test as in Example 37 was conducted, and the results are shown in Table 14. In the table, (parts) of DCPD-P, GK5855P and 2E4MZ are blending amounts which are relative to 100 parts of the resin.

**[Table 14]**

| | Example 52 | Example 53 | Comparative Example 32 | Example 54 | Comparative Example 33 | Comparative Example 34 |
|---|---|---|---|---|---|---|
| Resin | 15 | 16 | H11 | 15 | H11 | H11 |
| DCPD-P (parts) | 54.5 | 54.5 | 65.4 | 0 | 0 | 0 |
| GK58555P (parts) | 0 | 0 | 0 | 63.9 | 76.7 | 63.9 |
| 2E4MZ (parts) | 0.1 | 0.1 | 0.1 | 0.1 | 0.1 | 0.1 |
| Phosphorus content ratio (%) | 1.9 | 1.9 | 1.8 | 1.8 | 1.7 | 1.8 |
| Copper foil peel strength (kN/m) | 1.6 | 1.6 | 1.4 | 1.6 | 1.4 | 1.3 |
| Interlayer adhesive strength (kN/m) | 1.4 | 1.4 | 1.2 | 1.4 | 1.2 | 1.3 |
| Tg (°C) | 153 | 153 | 146 | 152 | 134 | 130 |
| Flame retardancy | V-0 | V-0 | V-1 | V-0 | V-1 | V-1 |
| Relative dielectric constant | 4.3 | 4.3 | 4.2 | 4.2 | 4.1 | 4.2 |
| Dielectric loss tangent | 0.014 | 0.014 | 0.013 | 0.012 | 0.012 | 0.012 |

Examples 52 to 54 (Comparative Examples 32 to 34) are examples in which a phenol-based curing agent other than PN was used. There was no difference in dielectric properties, and the flame retardancy, heat resistance and adhesion of the laminate were improved.

### Example 55

A total of 100 parts of the Resin 13 as a phosphorus-containing epoxy resin, 3.2 parts of DICY as a curing agent, 0.2 parts of 2E4MZ as a curing accelerator, and 95 parts of YP-50S and 39 parts of BMB as other components were blended and dissolved in a mixed solvent prepared with MEK, PGM, and DMF to obtain an epoxy resin varnish having a nonvolatile fraction of 50%.

The obtained epoxy resin composition varnish was applied onto a separator film (polyimide film) by using a roll coater, and dried in an oven at 130°C for 10 minutes to obtain a resin film having a thickness of 60 um. The resin film was peeled off from the separator film, and the resin film was further cured in an oven at 200°C for 120 minutes to obtain a cured film. The cured film was cut into a size of 200 mm × 50 mm to obtain a testpiece for flame retardancy measurement. The results of Tg and flame retardancy of the cured film are shown in Table 15.

### Example 56 and Comparative Examples 35 and 36

Epoxy resin composition varnishes were obtained in the same manner as in Example 55 by using the blends shown in Table 15, except that the Resin 10 obtained in Example 30 and the Resins H8 and H9 obtained in Comparative Examples 18 and 19 were used as the resin, and then cured films and testpieces for flame retardancy measurement were obtained. The same test as in Example 55 was conducted, and the results are shown in Table 15. In the table, (parts) of YDPN-638, YP-50S, DICY, 2E4MZ, BMB and PX-200 are blending amounts which are relative to 100 parts of the resin.

### Comparative Example 37

An epoxy resin composition varnish was obtained in the same manner as in Example 55 by using the blends shown in Table 15 except that the phosphorus-containing epoxy resin was not used and 81 parts of PX-200 was used as a flame retardant, and then a cured film and a testpiece for flame retardancy measurement were obtained. The same test as in Example 55 was conducted and the results are shown in Table 15.

**[Table 15]**

| | Example 55 | Comparative Example 35 | Example 56 | Comparative Example 36 | Comparative Example 37 |
|---|---|---|---|---|---|
| Resin | 13 | H9 | 10 | H8 | - |
| YDPN-638 (parts) | 0 | 0 | 119 | 119 | 125 |
| YP-50S (parts) | 95 | 95 | 149 | 149 | 149 |
| DICY (parts) | 3.2 | 3.2 | 7.4 | 7.4 | 7.4 |
| 2E4MZ (parts) | 0.2 | 0.2 | 0.3 | 0.3 | 0.3 |
| BMB (parts) | 39 | 39 | 60 | 60 | 60 |
| PX-200 (parts) | 0 | 0 | 0 | 0 | 81 |
| Phosphorus content ratio (%) | 1.5 | 1.5 | 1.9 | 2.0 | 2.0 |
| Tg (°C) | 145 | 133 | 143 | 131 | 140 |
| Flame retardancy | VTM-0 | VTM-1 | VTM-0 | VTM-1 | VTM-2 |

Examples 55 and 56 (Comparative Examples 35 to 37) are examples in which cured films were obtained. Even in this case, the flame retardancy and heat resistance were improved.

### Example 57

A total of 100 parts of the Resin 10 as a phosphorus-containing epoxy resin, 100 parts of YDF-170, 106 parts of MTHPA as a curing agent, 0.5 parts of 2E4MZ as a curing accelerator, and 160 parts of CMC12 as another component were blended and stirred and homogenized while heating to 80°C to obtain an epoxy resin composition. The obtained epoxy resin composition was defoamed, cast in a mold, and cured under temperature conditions of 150°C × 120 min to obtain a cured product having a thickness of 2 mm. After removal from the mold, the cured product was further post-cured in an oven at 200°C for 120 minutes. The resulting cured product was cut into a size of 127 mm × 12.7 mm to obtain a testpiece for flame retardancy measurement. The results of Tg and flame retardancy of the cured product are shown in Table 16.

### Comparative Examples 38 and 39

Epoxy resin compositions were obtained in the same manner as in Example 57 by using the blends shown in Table 16 except that the Resin H8 obtained in Comparative Example 18 was used as the resin, and then cured products and testpieces for flame retardancy measurement were obtained. The same test as in Example 57 was conducted and the results are shown in Table 16. In the table, (parts) of YDF-170, MTHPA, 2E4MZ, CMC12 and PX-200 are blending amounts which are relative to 100 parts of the resin.

**[Table 16]**

| | Example 57 | Comparative Example 38 | Comparative Example 39 |
|---|---|---|---|
| Resin | 10 | H8 | H8 |
| YDF-170 (parts) | 100 | 100 | 200 |
| MTHPA (parts) | 106 | 104 | 208 |
| 2E4MZ (parts) | 0.5 | 0.5 | 1.0 |
| CMC12 (parts) | 160 | 160 | 320 |
| PX-200 (parts) | 0 | 0 | 80 |
| Phosphorus content ratio (%) | 2.3 | 2.5 | 2.5 |
| Tg (°C) | 138 | 128 | 125 |
| Flame retardancy | V-0 | V-1 | V-2 |

Example 57 (Comparative Examples 38 and 39) are examples in which cured products (cast products) were obtained. Even in this case, the flame retardancy and heat resistance were improved.

### [Industrial Applicability]

The organophosphorus compound, phosphorus-containing epoxy resin and phosphorus-containing epoxy resin composition of the present invention can be used as a circuit board material, a sealing material, a casting material, a conductive paste, an adhesive, and the like, and are particularly useful as semiconductor encapsulation materials and materials for circuit boards (laminated boards) such as printed wiring board materials, resin compositions for flexible wiring boards, interlayer insulation materials for buildup boards, and the like, which require properties such as high flame retardancy, high heat resistance, low dielectric properties, solvent solubility, and the like.

## Claims

1. A phosphorus-containing phenolic compound represented by formula (1): 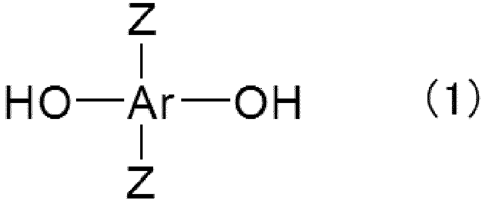 wherein Ar represents a naphthalene ring which may include an alkyl group having 1 to 8 carbon atoms, an alkoxy group having 1 to 8 carbon atoms, a cycloalkyl group having 5 to 8 carbon atoms, an aryl group having 6 to 10 carbon atoms, an aralkyl group having 7 to 11 carbon atoms, an aryloxy group having 6 to 10 carbon atoms, or an aralkyloxy group having 7 to 11 carbon atoms as a substituent; and Z is a phosphorus-containing group represented by formula (a1) and/or formula (a2): 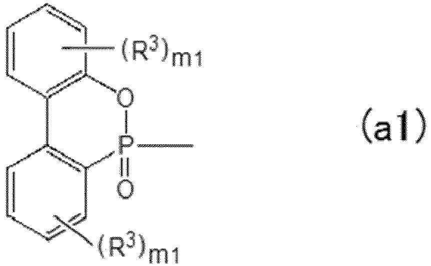 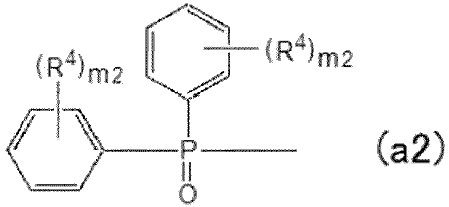 wherein R³ are each independently a hydrocarbon group having 1 to 11 carbon atoms; m1 are each independently an integer of 0 to 4 each; R⁴ are each independently a hydrocarbon group having 1 to 11 carbon atoms; and m2 are each independently an integer of 0 to 5.

2. A curable resin composition, comprising the phosphorus-containing phenolic compound according to claim 1 and a thermosetting resin.

3. The curable resin composition according to claim 2, wherein the thermosetting resin comprises an epoxy resin and a curing agent.

4. A cured product obtained by curing the curable resin composition according to claim 2.

5. A method for producing the phosphorus-containing phenolic compound according to claim 1, comprising:
a step 1 of reacting 0.5 mol or more and less than 1.0 mol of a quinone compound with 1 mol of a phosphorus compound represented by formula (2a) and/or formula (2b) at 100°C to 200°C in an organic solvent in the presence of 0.05 to 0.5 mol of water;
a step 2 of dissolving the reaction product obtained in the step 1 in a good solvent and removing insoluble impurities; and
a step 3 of mixing the solution obtained in the step 2 with a poor solvent to obtain a product by precipitation separation: 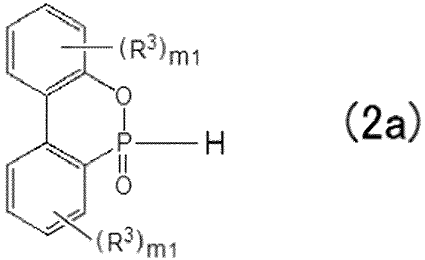 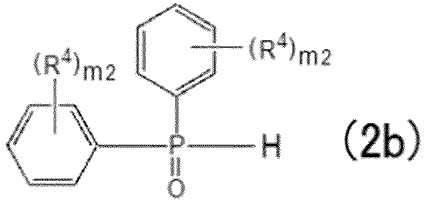
wherein R³ and m1 have the same meaning as R³ and m1 in the formula (a1), and R⁴ and m2 have the same meaning as R⁴ and m2 in the formula (a2),
wherein the good solvent is one or a mixture of two or more solvents selected from the group consisting of ethylene glycol, propylene glycol, diethylene glycol, cyclohexanone, benzyl alcohol, an acetic acid ester, and a benzoic acid ester, and
the poor solvent is one or a mixture of two or more solvents selected from the group consisting of methanol, ethanol, butanol and acetone; and
wherein the quinone compound is at least one selected from the group consisting of naphthoquinone, methyl-naphthoquinone, cyclohexyl-naphthoquinone, and methoxy-naphthoquinone.

6. A phosphorus-containing epoxy resin that is obtained by reacting the phosphorus-containing phenolic compound according to claim 1 and a polyfunctional epoxy resin, and has a structure produced by a reaction of a hydroxy group of the phosphorus-containing phenolic compound and an epoxy group of the epoxy resin.

7. The phosphorus-containing epoxy resin according to claim 6, which has a structural segment represented by formula (b) or a structural segment represented by the following formula (b) and a structural segment represented by formula (c): 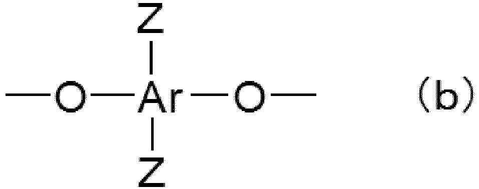 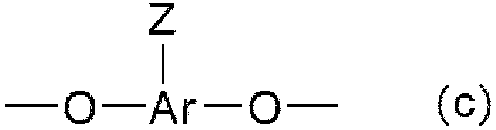 in the formulas (b) and (c), Ar represents a naphthalene ring which may include an alkyl group having 1 to 8 carbon atoms, an alkoxy group having 1 to 8 carbon atoms, a cycloalkyl group having 5 to 8 carbon atoms, an aryl group having 6 to 10 carbon atoms, an aralkyl group having 7 to 11 carbon atoms, an aryloxy group having 6 to 10 carbon atoms, or an aralkyloxy group having 7 to 11 carbon atoms as a substituent; and Z is a phosphorus-containing group represented by formula (a1) and/or formula (a2) as defined in claim 1.

8. The phosphorus-containing epoxy resin according to claim 7, which has a structure represented by formula (b1), or has a structure represented by the following formula (b1) and a structure represented by formula (c1) : 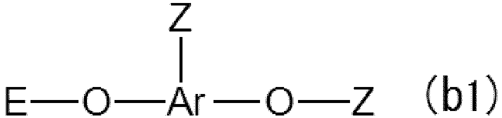 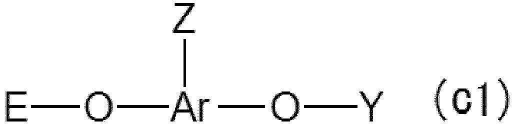 wherein Ar and Z have the same meaning as Ar and Z, respectively, in the formula (b); E is an organic group represented by -R-A¹, -R- is a linking group generated by the reaction of an epoxy group of a polyfunctional epoxy resin and a hydroxy group, A¹ is a residue of the polyfunctional epoxy resin, and contains 1 mol or more of an epoxy group or an epoxy derivative group thereof per 1 mol of A¹, where at least a part of the epoxy group and the epoxy derivative group thereof is an epoxy group, and the epoxy derivative group is generated from an epoxy group and a phenolic compound having a structure in which a phosphorus-containing group Z and a hydroxy group are bonded to Ar; E in the formula (b1) and formula (c1) may be shared with other formula (b1) or formula (c1); and Y is a hydrogen atom or E.

9. A method for producing the phosphorus-containing epoxy resin according to claim 7, wherein a reactive agent (x) comprising a compound that includes the phosphorus-containing phenolic compound (1) according to claim 1 as an essential component and has a functional group reactive with an epoxy group is reacted with a polyfunctional epoxy resin (y).

10. The method for producing the phosphorus-containing epoxy resin according to claim 9, wherein the reactive agent (x) includes a phosphorus-containing reactive agent (p) having a functional group reactive with an epoxy group, the phosphorus-containing reactive agent (p) includes a phosphorus-containing phenolic compound (1) and a phosphorus-containing phenolic compound (3) represented by formula (3), and a content ratio of the phosphorus-containing phenolic compound (1) is 0.1% by mass to 35% by mass of the phosphorus-containing reactive agent (p): 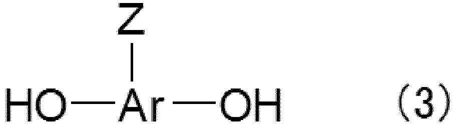 wherein Ar and Z have the same meaning as Ar and Z, respectively, in the formula (b).

11. The method for producing the phosphorus-containing epoxy resin according to claim 9, wherein the phosphorus-containing reactive agent (p) is obtained by charging a quinone compound (q) in an amount of 0.10 mol or more and less than 1.0 mol with respect to 1 mol of the phosphorus compound (2) represented by the formula (2a) and/or formula (2b) as defined in claim 5, and conducting a reaction at 100°C to 200°C in an organic solvent having a water amount of 0.05 to 0.5 mol with respect to 1 mol of the phosphorus compound (2) .

12. The method for producing the phosphorus-containing epoxy resin according to claim 9 or 10, wherein the reactive agent (x) includes a compound (x1) that is other than the phosphorus compound (p) and has a functional group reactive with an epoxy group.

13. An epoxy resin composition including the phosphorus-containing epoxy resin according to claim 7 and a curing agent for the epoxy resin.

14. A circuit board material obtained by using the epoxy resin composition according to claim 13.

15. A cured product obtained by curing the epoxy resin composition according to claim 13.

## Patentansprüche

1. Phosphorhaltige Phenolverbindung, dargestellt durch die Formel (1): 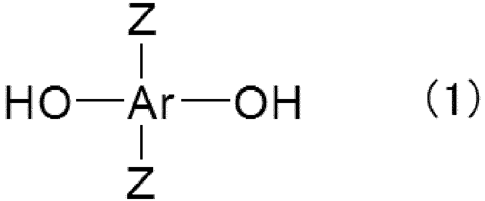 worin gilt: Ar steht für einen Naphthalinring, der eine Alkylgruppe mit 1 bis 8 Kohlenstoffatomen, eine Alkoxygruppe mit 1 bis 8 Kohlenstoffatomen, eine Cycloalkylgruppe mit 5 bis 8 Kohlenstoffatomen, eine Arylgruppe mit 6 bis 10 Kohlenstoffatomen, eine Aralkylgruppe mit 7 bis 11 Kohlenstoffatomen, eine Aryloxygruppe mit 6 bis 10 Kohlenstoffatomen oder eine Aralkyloxygruppe mit 7 bis 11 Kohlenstoffatomen als Substituent enthalten kann; und Z ist eine phosphorhaltige Gruppe der Formel (a1) und/oder der Formel (a2): 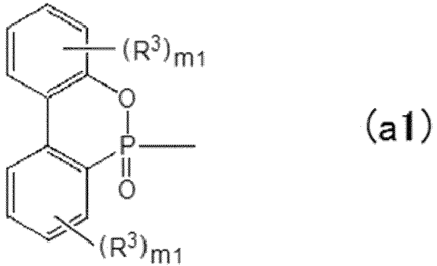 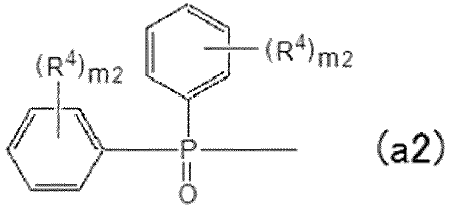 worin gilt: R³ stehen jeweils unabhängig für eine Kohlenwasserstoffgruppe mit 1 bis 11 Kohlenstoffatomen; m1 stehen jeweils unabhängig für eine ganze Zahl von 0 bis 4; R⁴ stehen jeweils unabhängig für eine Kohlenwasserstoffgruppe mit 1 bis 11 Kohlenstoffatomen; und m2 stehen jeweils unabhängig für eine ganze Zahl von 0 bis 5.

2. Härtbare Harzzusammensetzung, umfassend die phosphorhaltige Phenolverbindung nach Anspruch 1 und ein wärmehärtendes Harz.

3. Härtbare Harzzusammensetzung nach Anspruch 2, wobei das wärmehärtbare Harz ein Epoxidharz und ein Härtungsmittel umfasst.

4. Gehärtetes Produkt, das durch Härten der härtbaren Harzzusammensetzung nach Anspruch 2 erhalten wird.

5. Verfahren zur Herstellung der phosphorhaltigen Phenolverbindung nach Anspruch 1, umfassend:
einen Schritt 1 des Umsetzens von 0,5 mol oder mehr und weniger als 1,0 mol einer Chinonverbindung mit 1 mol einer Phosphorverbindung der Formel (2a) und/oder der Formel (2b) bei 100°C bis 200°C in einem organischen Lösungsmittel in Gegenwart von 0,05 bis 0,5 mol Wasser;
einen Schritt 2, in dem das in Schritt 1 erhaltene Reaktionsprodukt in einem guten Lösungsmittel gelöst und unlösliche Verunreinigungen entfernt werden; und
einen Schritt 3, in dem die in Schritt 2 erhaltene Lösung mit einem schlechten Lösungsmittel gemischt wird, um ein Produkt durch Fällungstrennung zu erhalten: 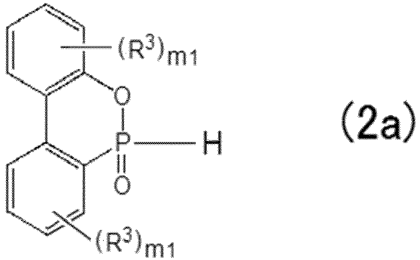 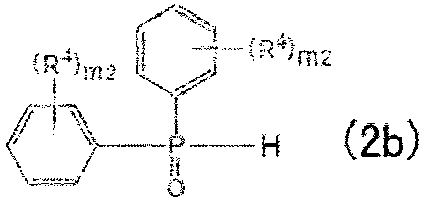
worin R³ und m1 die gleiche Bedeutung haben wie R³ und m1 in der Formel (a1), und R⁴ und m2 die gleiche Bedeutung haben wie R⁴ und m2 in der Formel (a2),
wobei das gute Lösungsmittel ein oder ein Gemisch aus zwei oder mehr Lösungsmitteln ist, die aus der Gruppe bestehend aus Ethylenglykol, Propylenglykol, Diethylenglykol, Cyclohexanon, Benzylalkohol, einem Essigsäureester und einem Benzoesäureester ausgewählt sind, und
das schlechte Lösungsmittel ein oder ein Gemisch aus zwei oder mehr Lösungsmitteln ist, die aus der Gruppe bestehend aus Methanol, Ethanol, Butanol und Aceton ausgewählt sind; und
wobei die Chinonverbindung mindestens eine ist, die aus der Gruppe ausgewählt ist, die aus Naphthochinon, Methylnaphthochinon, Cyclohexylnaphthochinon und Methoxynaphthochinon besteht.

6. Phosphorhaltiges Epoxidharz, das durch Umsetzen der phosphorhaltigen Phenolverbindung nach Anspruch 1 und eines polyfunktionellen Epoxidharzes erhalten wird und eine Struktur aufweist, die durch eine Reaktion einer Hydroxygruppe der phosphorhaltigen Phenolverbindung und einer Epoxygruppe des Epoxidharzes erzeugt wird.

7. Phosphorhaltiges Epoxidharz nach Anspruch 6, das ein durch die Formel (b) dargestelltes Struktursegment oder ein durch die folgende Formel (b) dargestelltes Struktursegment und ein durch die Formel (c) dargestelltes Struktursegment aufweist: 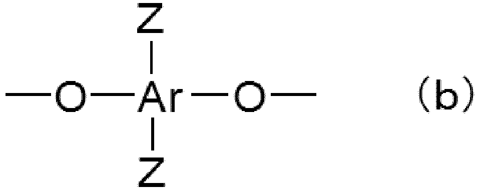 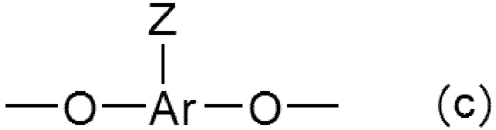 in den Formeln (b) und (c) steht Ar für einen Naphthalinring, der eine Alkylgruppe mit 1 bis 8 Kohlenstoffatomen, eine Alkoxygruppe mit 1 bis 8 Kohlenstoffatomen, eine Cycloalkylgruppe mit 5 bis 8 Kohlenstoffatomen, eine Arylgruppe mit 6 bis 10 Kohlenstoffatomen, eine Aralkylgruppe mit 7 bis 11 Kohlenstoffatomen, eine Aryloxygruppe mit 6 bis 10 Kohlenstoffatomen oder eine Aralkyloxygruppe mit 7 bis 11 Kohlenstoffatomen als Substituent enthalten kann; und Z ist eine phosphorhaltige Gruppe, die durch die Formel (a1) und/oder die Formel (a2), wie in Anspruch 1 definiert, dargestellt wird.

8. Phosphorhaltiges Epoxidharz nach Anspruch 7, das eine durch die Formel (b1) dargestellte Struktur oder eine durch die folgende Formel (b1) dargestellte Struktur und eine durch die Formel (c1) dargestellte Struktur aufweist: 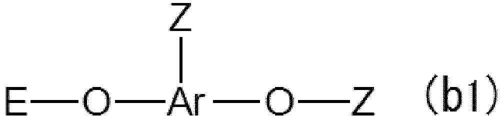 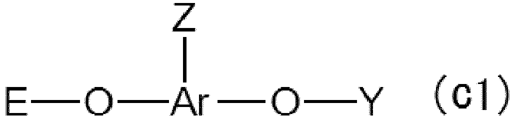 worin Ar und Z die gleiche Bedeutung wie Ar bzw. Z in der Formel (b) haben; E eine organische Gruppe ist, die durch -R-A¹ dargestellt wird, -R- eine verbindende Gruppe ist, die durch die Reaktion einer Epoxygruppe eines polyfunktionellen Epoxyharzes und einer Hydroxygruppe erzeugt wird, A¹ ein Rest des polyfunktionellen Epoxyharzes ist und 1 Mol oder mehr einer Epoxygruppe oder einer Epoxyderivatgruppe davon pro 1 Mol A¹ enthält, wobei mindestens ein Teil der Epoxygruppe und deren Epoxyderivatgruppe eine Epoxygruppe ist, und die Epoxyderivatgruppe aus einer Epoxygruppe und einer phenolischen Verbindung mit einer Struktur, in der eine phosphorhaltige Gruppe Z und eine Hydroxygruppe an Ar gebunden sind, erzeugt wird; E in der Formel (b1) und der Formel (c1) mit einer anderen Formel (b1) oder Formel (c1) geteilt sein kann; und Y ein Wasserstoffatom oder E ist.

9. Verfahren zur Herstellung des phosphorhaltigen Epoxidharzes nach Anspruch 7, wobei ein reaktives Mittel (x), das eine Verbindung umfasst, die die phosphorhaltige Phenolverbindung (1) nach Anspruch 1 als wesentlichen Bestandteil enthält und das eine funktionelle Gruppe aufweist, die mit einer Epoxidgruppe reaktiv ist, mit einem polyfunktionellen Epoxidharz (y) umgesetzt wird.

10. Verfahren zur Herstellung des phosphorhaltigen Epoxidharzes nach Anspruch 9, wobei das reaktive Mittel (x) ein phosphorhaltiges reaktives Mittel (p) mit einer funktionellen Gruppe, die mit einer Epoxygruppe reaktiv ist, umfasst, das phosphorhaltige reaktive Mittel (p) eine phosphorhaltige phenolische Verbindung (1) und eine phosphorhaltige phenolische Verbindung (3), dargestellt durch die Formel (3), umfasst, und ein Gehaltsverhältnis der phosphorhaltigen phenolischen Verbindung (1) 0.1 Masseprozent bis 35 Masseprozent des phosphorhaltigen Reaktivmittels (p) beträgt: 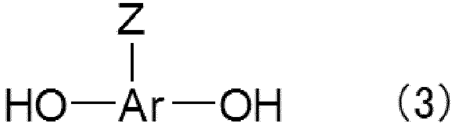 worin Ar und Z die gleiche Bedeutung wie Ar bzw. Z in der Formel (b) haben.

11. Verfahren zur Herstellung des phosphorhaltigen Epoxidharzes nach Anspruch 9, wobei das phosphorhaltige reaktive Mittel (p) erhalten wird durch Zugeben einer Chinonverbindung (q) in einer Menge von 0,10 mol oder mehr und weniger als 1.0 mol, bezogen auf 1 mol der Phosphorverbindung (2), dargestellt durch die Formel (2a) und/oder Formel (2b), wie in Anspruch 5 definiert, und Durchführung einer Reaktion bei 100°C bis 200°C in einem organischen Lösungsmittel mit einer Wassermenge von 0,05 bis 0,5 mol, bezogen auf 1 mol der Phosphorverbindung (2).

12. Verfahren zur Herstellung des phosphorhaltigen Epoxidharzes nach Anspruch 9 oder 10, wobei das reaktive Mittel (x) eine Verbindung (x1) umfasst, die von der Phosphorverbindung (p) verschieden ist und eine funktionelle Gruppe aufweist, die mit einer Epoxidgruppe reaktiv ist.

13. Epoxidharzzusammensetzung, die das phosphorhaltige Epoxidharz nach Anspruch 7 und ein Härtungsmittel für das Epoxidharz enthält.

14. Leiterplattenmaterial, erhalten durch Verwendung der Epoxidharzzusammensetzung nach Anspruch 13.

15. Gehärtetes Produkt, erhalten durch Härten der Epoxidharzzusammensetzung nach Anspruch 13.

## Revendications

1. Composé phénolique contenant du phosphore représenté par la formule (1) : 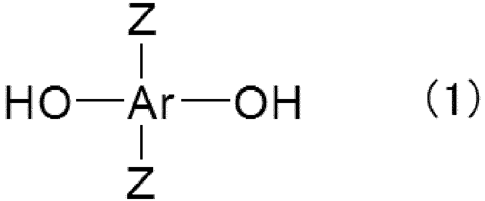 dans laquelle Ar représente un anneau de naphtalène qui peut inclure un groupe alkyle ayant 1 à 8 atomes de carbone, un groupe alcoxy ayant 1 à 8 atomes de carbone, un groupe cycloalkyle ayant 5 à 8 atomes de carbone, un groupe aryle ayant 6 à 10 atomes de carbone, un groupe aralkyle ayant 7 à 11 atomes de carbone, un groupe aryloxy ayant 6 à 10 atomes de carbone, ou un groupe aralkyloxy ayant 7 à 11 atomes de carbone en tant que substituant ; et Z est un groupe contenant du phosphore représenté par la formule (a1) et/ou la formule (a2) : 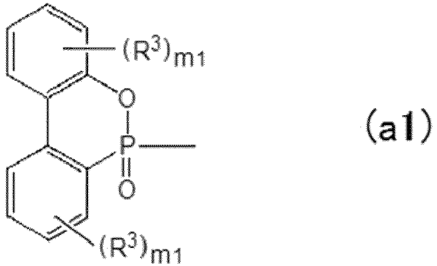 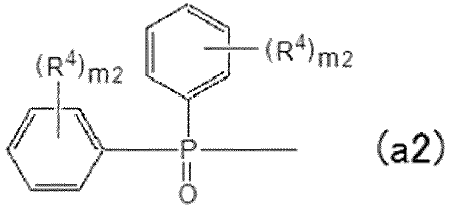 dans laquelle R³ sont chacun indépendamment un groupe d'hydrocarbures ayant 1 à 11 atomes de carbone ; m1 sont chacun indépendamment un nombre entier de 0 à 4 chacun ; R⁴ sont chacun indépendamment un groupe d'hydrocarbures ayant 1 à 11 atomes de carbone ; et m2 sont chacun indépendamment un nombre entier de 0 à 5.

2. Composition de résine durcissable, comprenant le composé phénolique contenant du phosphore selon la revendication 1 et une résine thermodurcissable.

3. Composition de résine durcissable selon la revendication 2, dans laquelle la résine thermodurcissable comprend une résine époxy et un agent de durcissement.

4. Produit durci obtenu par durcissement de la composition de résine durcissable selon la revendication 2.

5. Procédé de production du composé phénolique contenant du phosphore selon la revendication 1, comprenant :
une étape 1 consistant à faire réagir 0,5 mol ou plus et moins de 1,0 mol d'un composé de quinone avec 1 mol d'un composé de phosphore représenté par la formule (2a) et/ou la formule (2b) à 100°C à 200°C dans un solvant organique en présence de 0,05 à 0,5 mol d'eau ;
une étape 2 consistant à dissoudre le produit de réaction obtenu à l'étape 1 dans un bon solvant et à éliminer les impuretés insolubles ; et
une étape 3 consistant à mélanger la solution obtenue à l'étape 2 avec un solvant mauvais pour obtenir un produit par séparation par précipitation : 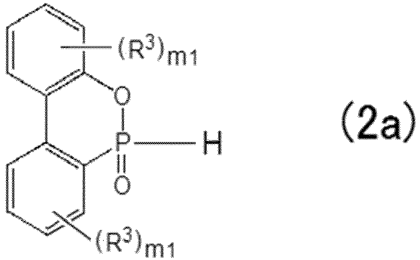 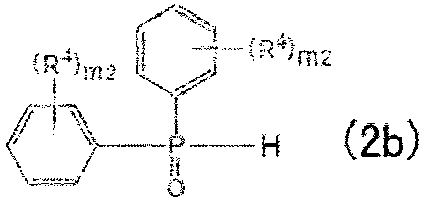
dans lesquelles R³ et m1 ont la même signification que R³ et m1 dans la formule (a1), et R⁴ et m2 ont la même signification que R⁴ et m2 dans la formule (a2),
dans lequel le bon solvant est un ou un mélange de deux solvants ou plus choisis dans le groupe constitué par l'éthylène glycol, le propylène glycol, le diéthylène glycol, la cyclohexanone, l'alcool benzylique, un ester d'acide acétique et un ester d'acide benzoïque, et
le solvant mauvais est un ou un mélange de deux solvants ou plus choisis dans le groupe constitué par le méthanol, l'éthanol, le butanol et l'acétone ; et
dans lequel le composé de quinone est au moins un composé choisi dans le groupe constitué par la naphtoquinone, la méthyl-naphtoquinone, la cyclohexyl-naphtoquinone et la méthoxy-naphtoquinone.

6. Résine époxy contenant du phosphore obtenue par réaction du composé phénolique contenant du phosphore selon la revendication 1 et d'une résine époxy polyfonctionnelle, et dont la structure est produite par réaction d'un groupe hydroxy du composé phénolique contenant du phosphore et d'un groupe époxy de la résine époxy.

7. Résine époxy contenant du phosphore selon la revendication 6, qui possède un segment structural représenté par la formule (b) ou un segment structural représenté par la formule suivante (b) et un segment structural représenté par la formule (c) : 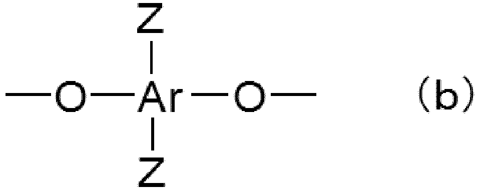 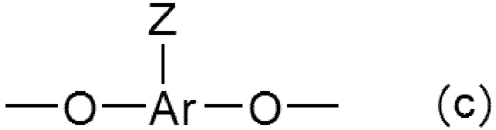 dans les formules (b) et (c), Ar représente un cycle naphtalène qui peut inclure un groupe alkyle ayant 1 à 8 atomes de carbone, un groupe alcoxy ayant 1 à 8 atomes de carbone, un groupe cycloalkyle ayant 5 à 8 atomes de carbone, un groupe aryle ayant 6 à 10 atomes de carbone, un groupe aralkyle ayant 7 à 11 atomes de carbone, un groupe aryloxy ayant 6 à 10 atomes de carbone, ou un groupe aralkyloxy ayant 7 à 11 atomes de carbone en tant que substituant ; et Z est un groupe contenant du phosphore représenté par la formule (a1) et/ou la formule (a2) telles que définies dans la revendication 1.

8. Résine époxy contenant du phosphore selon la revendication 7, qui a une structure représentée par la formule (b1), ou qui a une structure représentée par la formule suivante (b1) et une structure représentée par la formule (c1) : 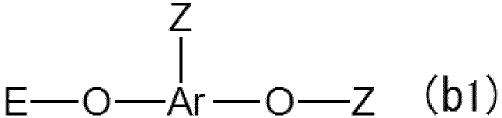 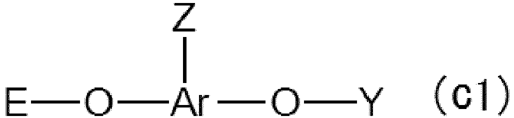 dans lesquelles Ar et Z ont la même signification que Ar et Z, respectivement, dans la formule (b) ; E est un groupe organique représenté par -R-A¹, -R- est un groupe de liaison généré par la réaction d'un groupe époxy d'une résine époxy polyfonctionnelle et d'un groupe hydroxy, A¹ est un résidu de la résine époxy polyfonctionnelle, et contient 1 mole ou plus d'un groupe époxy ou d'un groupe dérivé époxy pour 1 mole de A¹, où au moins une partie du groupe époxy et de son groupe dérivé époxy est un groupe époxy, et le groupe dérivé époxy est généré à partir d'un groupe époxy et d'un composé phénolique ayant une structure dans laquelle un groupe contenant du phosphore Z et un groupe hydroxy sont liés à Ar ; E dans la formule (b1) et la formule (c1) peut être partagé avec d'autres formules (b1) ou formules (c1) ; et Y est un atome d'hydrogène ou E.

9. Procédé de production de la résine époxy contenant du phosphore selon la revendication 7, dans lequel un agent réactif (x) comprenant un composé qui inclut le composé phénolique contenant du phosphore (1) selon la revendication 1 en tant que composant essentiel et possède un groupe fonctionnel réactif avec un groupe époxy est mis en réaction avec une résine époxy polyfonctionnelle (y).

10. Procédé de production de la résine époxy contenant du phosphore selon la revendication 9, dans lequel l'agent réactif (x) comprend un agent réactif contenant du phosphore (p) ayant un groupe fonctionnel réactif avec un groupe époxy, l'agent réactif contenant du phosphore (p) comprend un composé phénolique contenant du phosphore (1) et un composé phénolique contenant du phosphore (3) représenté par la formule (3), et un rapport de teneur du composé phénolique contenant du phosphore (1) est de 0.1 % en masse à 35 % en masse de l'agent réactif contenant du phosphore (p) : 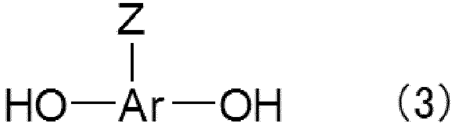 dans laquelle Ar et Z ont la même signification que Ar et Z, respectivement, dans la formule (b).

11. Procédé de fabrication de la résine époxy contenant du phosphore selon la revendication 9, dans lequel l'agent réactif contenant du phosphore (p) est obtenu en chargeant un composé de quinone (q) en une quantité égale ou supérieure à 0,10 mol et inférieure à 1.0 mol par rapport à 1 mol du composé contenant du phosphore (2) représenté par la formule (2a) et/ou la formule (2b) telles que définies dans la revendication 5, et en conduisant une réaction à 100°C à 200°C dans un solvant organique ayant une quantité d'eau de 0,05 à 0,5 mol par rapport à 1 mol du composé contenant du phosphore (2).

12. Procédé de production de la résine époxy contenant du phosphore selon la revendication 9 ou 10, dans lequel l'agent réactif (x) comprend un composé (x1) qui est autre que le composé contenant du phosphore (p) et possède un groupe fonctionnel réactif avec un groupe époxy.

13. Composition de résine époxy comprenant la résine époxy contenant du phosphore selon la revendication 7 et un agent de durcissement de la résine époxy.

14. Matériau de circuit imprimé obtenu en utilisant la composition de résine époxy selon la revendication 13.

15. Produit durci obtenu par durcissement de la composition de résine époxy selon la revendication 13.
